(19) Europäisches Patentamt
European Patent Office
Office européen des brevets

(11) EP 1 193 556 A1

(12) EUROPEAN PATENT APPLICATION

(43) Date of publication:
03.04.2002 Bulletin 2002/14

(51) Int Cl.[7]: **G03F 7/004**, G03F 7/039

(21) Application number: **01120747.9**

(22) Date of filing: **06.09.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **06.09.2000 JP 2000270158**
**25.09.2000 JP 2000290563**

(71) Applicant: **Fuji Photo Film Co., Ltd.**
**Kanagawa-ken (JP)**

(72) Inventor: **Uenishi, Kazuya**
**Yoshida-cho, Haibara-gun, Shizuoka (JP)**

(74) Representative: **HOFFMANN - EITLE**
**Patent- und Rechtsanwälte**
**Arabellastrasse 4**
**81925 München (DE)**

(54) **Positive resist composition**

(57) A positive electron composition comprises: (a) a compound capable of generating an acid upon irradiation with a radiation; (b) a compound having a cationically polymerizable function; and (c) a solvent mixture containing at least one solvent selected from Group (A) below, and at least one solvent selected from Group (B) and Group (C):

Group A: a propylene glycol monoalkyl ether carboxylate;
Group B: a propylene glycol monoalkyl ether; an alkyl lactate, an acetic ester, a chain ketone and an alkyl alkoxypropionate; and
Group C: a γ-butyrolactone, an ethylene carbonate and a propylene carbonate.

EP 1 193 556 A1

## Description

### FIELD OF THE INVENTION

The present invention relates to a positive resist composition, more specifically, the present invention relates to a positive electron beam or X-ray resist composition ensuring an excellent pattern profile of the pattern obtained upon exposure with electron beam or X-ray and also exhibiting high sensitivity, high resolution and excellent process delay stability (PCD, PED). The term "PCD (post coating delay) stability" means the coating stability when a resist composition is coated on a substrate and left standing inside or outside an irradiation apparatus, and the "PED (post exposure delay) stability" means the coating stability when the coating is left standing inside or outside an irradiation apparatus after the irradiation until a heating operation is performed.

### BACKGROUND OF THE INVENTION

The integration degree of integrated circuits is more and more elevated and in the production of a semiconductor substrate such as ultra-LSI, an ultrafine pattern consisting of lines having a width of half micron or less must be processed. To meet this requirement, the wavelength used in the exposure apparatus for use in the photolithography increasingly becomes shorter and at the present time, studies are being made on the use of far ultraviolet ray or excimer laser ray (e.g., XeCl, KrF, ArF). Furthermore, studies on the formation of a finer pattern using an electron beam or an X-ray is also being proceeding.

Particularly, the electron beam and X-ray have established the position as a pattern-forming technique in the next generation or generation after next generation and a positive or negative resist composition therefor capable of achieving a rectangular profile form with high sensitivity and high resolution is being demanded to develop.

The resist such as i-line resist, KrF excimer laser resist and ArF excimer laser resist has its absorption in the exposure wavelength and therefore, when compared between the exposure surface and the bottom part, the exposure intensity is smaller in the bottom part. Because of this, in the case of a positive resist, a so-called tapered pattern profile generally results.

When an electron beam resist is used, however, since the incident electron has electric charge and interacts with atomic nucleus or electron of a substance constituting the resist, scattering necessarily takes place on the penetration of an electron beam into the resist (the scattering of electron is described in Thompson, Willson and Bowden, Introduction to Microlithography, ACS Symposium Series 219, pp. 47-63). Therefore, in the exposed part, the area of exposure is larger in the bottom part than on the resist film surface and in the case of a positive resist, a so-called reverse-tapered pattern profile disadvantageously results. Even if the exposure is performed by reducing the beam size so as to resolve a fine pattern, the area of exposure is broadened due to this scattering and the resolution disadvantageously deteriorates.

Furthermore, the positive electron beam or X-ray resist is prone to the effect of a basic contaminant in air or effect (drying of coating) by the exposure inside or outside an irradiation apparatus and the resist surface is readily rendered sparingly soluble. This causes a problem of T-Top profile (a top with T-shaped surface) in the case of a line pattern and a problem of capped surface (formation of a hood on the contact hole surface) in the case of a contact hole pattern. Moreover, the stability (PCD, PED) in aging within an irradiation apparatus is bad and the pattern dimension changes. In addition, the inhibition of development defects, good coatability (in-plane uniformity) and good solvent solubility (prevention of precipitation in aging during storage) are being demanded.

### SUMMARY OF THE INVENTION

The object of the present invention is to improve the performance in the fine processing of a semiconductor device using an electron beam or X-ray and to solve the problems in conventional techniques. More specifically, the object of the present invention is to provide a positive chemical amplification-type resist composition for electron beam or X-ray, which is satisfied in the properties regarding sensitivity and resolution for electron beam or X-ray used, rectangular resist profile, PCD stability, PED stability, development defect, coatability and solvent solubility.

As a result of extensive investigations by taking account of these properties, the present inventors have found that the object of the present invention can be attained by the use of a specific composition. The present invention has been accomplished based on this finding. More specifically the present invention has the following constructions.

(1) A positive resist composition to be irradiated with one of an electron beam and X ray comprising:

(a) a compound capable of generating an acid upon irradiation with a radiation;
(b) a compound having a cationically polymerizable function; and

(c) one of solvent mixtures (DI) and (DII):

(DI) a solvent mixture containing at least one solvent selected from Group (A) below and at least one solvent selected from Group (B) below; and
(DII) a solvent mixture containing at least one solvent selected from Group (A) below and at least one solvent selected from Group (C) below:

Group A: a propylene glycol monoalkyl ether carboxylate;
Group B: a propylene glycol monoalkyl ether, an alkyl lactate, an acetic ester, a chain ketone and an alkyl alkoxypropionate;
Group C: a γ-butyrolactone, an ethylene carbonate and a propylene carbonate.

(2) A positive resist composition to be irradiated with one of an electron beam and X ray comprising:

(a) a compound capable of generating an acid upon irradiation with a radiation;
(b) a compound having a cationically polymerizable function; and
(c) a solvent mixture containing: at least one solvent selected from Group (A) below; at least one solvent selected from Group (B) below; and at least one solvent selected from Group (C) below:

Group A: a propylene glycol monoalkyl ether carboxylate;
Group B: a propylene glycol monoalkyl ether, an alkyl lactate, an acetic ester, a chain ketone and an alkyl alkoxypropionate;
Group C: a γ-butyrolactone, an ethylene carbonate and a propylene carbonate.

(3) The positive resist composition as described in (1) or (2), which further comprises (d) an organic basic compound.

(4) The positive resist composition as described in (1) or (2), which further comprises (e) a surfactant containing at least one of a fluorine atom and a silicon atom.

(5) The positive resist composition as described in (1) or (2), wherein the compound (b) is at least one compound selected from the group consisting of vinyl compounds, cycloalkane compounds, cyclic ether compounds, lactone compounds and aldehyde compounds.

(6) The positive resist composition as described in (1) or (2), wherein the compound (b) is a compound represented by formula (A):

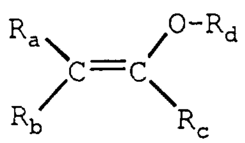

(A)

wherein $R_a$, $R_b$ and $R_c$, which are the same or different, each represents a hydrogen atom, an alkyl or aryl group which may have a substituent, two of $R_a$, $R_b$ and $R_c$ may combine to form a saturated or olefinic unsaturated ring, and $R_d$ represents an alkyl group or a substituted alkyl group.

(7) The positive resist composition as described in (1) or (2), wherein the compound (a) contains at least one selected from the compounds represented by formulae (I) to (III):

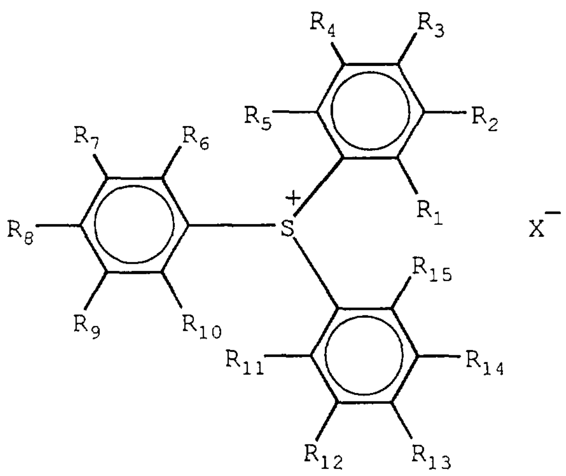

(I)

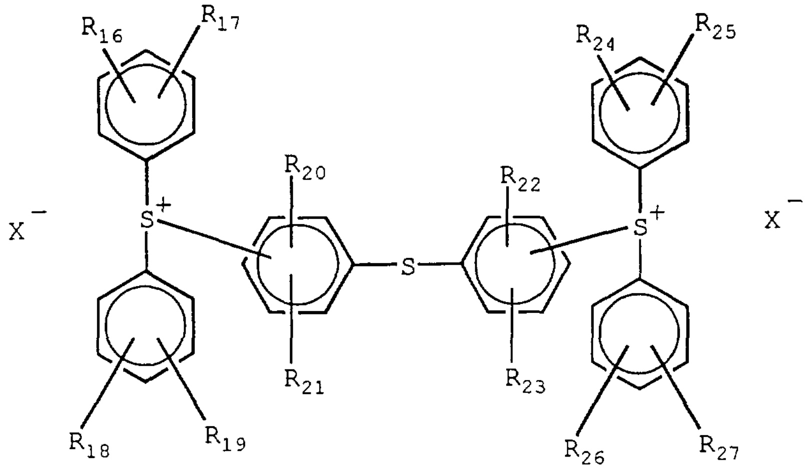

(II)

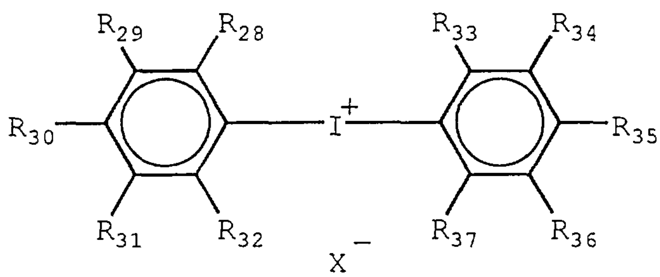

(III)

wherein $R_1$ to $R_{37}$, which are the same or different, each represents a hydrogen atom, a linear, branched or cyclic alkyl group, a linear, branched or cyclic alkoxy group, a hydroxyl group, a halogen atom or an $-S-R_{38}$ group; $R_{38}$ represents a linear, branched or cyclic alkyl or aryl group; two or more of respective groups $R_1$ to $R_{15}$, $R_{16}$ to $R_{27}$ and $R_{28}$ to $R_{37}$ may combine to form a ring containing one or more member selected from the group consisting of a single bond, a carbon, oxygen, sulfur and nitrogen atom; and

$X^-$ represents an anion of a benzenesulfonic acid, a naphthalenesulfonic acid or anthracenesulfonic acid that contains at least one member selected from the group consisting of:

at least one fluorine atom;
a linear, branched or cyclic alkyl group substituted by at least one fluorine atom;
a linear, branched or cyclic alkoxy group substituted by at least one fluorine atom;
an acyl group substituted by at least one fluorine atom;
an acyloxy group substituted by at least one fluorine atom;

a sulfonyl group substituted by at least one fluorine atom;
a sulfonyloxy group substituted by at least one fluorine atom;
a sulfonylamino group substituted by at least one fluorine atom;
an aryl group substituted by at least one fluorine atom;
an aralkyl group substituted by at least one fluorine atom; and
an alkoxycarbonyl group substituted by at least one fluorine atom.

(8) The positive resist composition as described in (1) or (2), which comprises at least one of:

(f) a resin having a group capable of decomposing by an acid, which increases in the solubility in an alkali developer under the action of an acid; and
(g) a low molecular dissolution-inhibiting compound having a molecular weight of 3,000 or less, which has a group capable of decomposing by an acid and increases in the solubility in an alkali developer under the action of an acid.

(9). A method for forming a pattern comprises: applying the positive resist composition described in the item (1) or (2) on a substrate to form a resist film; irradiating the resist film with one of an electron beam and X ray; and developing the resist film.

## DETAILED DESCRIPTION OF THE INVENTION

The positive resist composition of the present invention is described below.

[I] Cationically polymerizable compound (component (b))

The cationic polymerization as used in the present invention means an addition polymerization where the growing chain is a positive ion such as carbonium ion and oxonium ion. In the present invention, a monomer capable of undergoing such cationic polymerization is called a compound having a cationically polymerizable function. Describing by taking a vinyl compound as an example, the cationic polymerizability of a vinyl monomer can be discussed using a Q-e value employed in the radial polymerization. It is known that when the e value becomes less than about -0.3, the compound exhibits cationic polymerizability.

The cationically polymerizable compound for use in the present invention may be any compound insofar as it is a compound having a cationically polymerizable function. Preferred examples thereof include vinyl compounds, cycloalkane compounds, cyclic ether compounds, lactone compounds and aldehyde compounds.

Examples of the vinyl compound which can be used include vinyl ethers which are described later, styrenes such as α-methylstyrene, m-methoxystyrene, p-methoxystyrene, o-chlorostyrene, m-chlorostyrene, p-chlorostyrene, o-nitrostyrene, m-nitrostyrene, p-bromostyrene, 3,4-dichlorostyrene, 2,5-dichlorostyrene and p-dimethyl-aminostyrene, vinylfurans such as 2-isopropenylfuran, 2-vinylbenzofuran and 2-vinyldibenzofuran, vinylthiophenes such as 2-isopropenylthiophene and 2-vinylphenoxathine, N-vinylcarbazoles, vinylnaphthalene, vinylanthracene and acenaphthylene.

Examples of the cycloalkane compound which can be used include phenylcyclopropane, spiro[2,4]heptane, spiro[2,5]-octane, spiro[3,4]octane, 4-methylspiro[2,5]octane and spiro[2,7]decane.

Examples of the cyclic ether compound which can be used include dioxanes such as 4-phenyl-1,3-dioxane, oxethanes such as 3,3-bischloromethyloxethane, and compounds such as trioxane and 1,3-dioxepane. Other examples of the compound which can be used include glycidyl ethers such as ally glycidyl ether and phenyl glycidyl ether, glycidyl esters such as glycidyl acrylate and glycidyl methacrylate, bisphenol A epoxy resin commercially available under a trade name of Epicote, tetrabromobisphenol A epoxy resin, bisphenol F epoxy resin, phenol novolak epoxy resin and cresol novolak epoxy resin.

Examples of the lactone compound which can be used include propiolactone, butyrolactone, valerolactone, caprolactone, β-methyl-β-propiolactone, α,α-dimethyl-β-propiolactone and α-methyl-β-propiolactone.

Examples of the aldehyde compound which can be used include aliphatic saturated aldehyde compounds such as valeroaldehyde, hexanol, heptanol, octanal, nonanal, decanal, cyclohexane carbaldehyde and phenyl acetaldehyde, aliphatic unsaturated aldehyde compound such as methacrolein, croton aldehyde, 2-methyl-2-butenal, 2-butynal and safranal, aromatic aldehyde compounds such as benzaldehyde, tolualdehyde and cinnamaldehyde, halogen-substituted aldehyde compounds such as tribromoacetaldehyde, 2,2,3-trichlorobutylaldehyde and chlorobenzaldehyde, hydroxy or alkoxy-substituted aldehyde compounds such as glyceryl aldehyde, aldol, salicyl aldehyde, m-hydroxybenzaldehyde, 2,4-dihydroxybenzaldehyde, 4-hydroxy-3-methoxybenzaldehyde and piperonal, amino- or nitro-substituted aldehyde compounds such as aminobenzaldehyde and nitrobenzaldehyde, dialdehyde compounds such

as succinaldehyde, glutaraldehyde, phthalaldehyde and terephthalaldehyde, ketoaldehyde compounds such as phenyl glyoxal and benzoyl acetaldehyde, and derivatives thereof.

The cationically polymerizable compound is preferably a vinyl compound, more preferably a vinyl ether compound, still more preferably a compound represented by formula [A], because the effect of the present invention can be more successfully brought out.

In formula (A), in the case where $R_a$ and $R_b$ and $R_c$ each is an aryl group, the aryl group generally has from 4 to 20 carbon atoms and may be substituted by an alkyl group, an aryl group, an alkoxy group, an aryloxy group, an acyl group, an acyloxy group, an alkylmercapto group, an aminoacyl group, a carboalkoxy group, a nitro group, a sulfonyl group, a cyano group or a halogen atom. Examples of the aryl group having from 4 to 20 carbon toms include a phenyl group, a tolyl group, a xylyl group, a biphenyl group, a naphthyl group, an anthryl group and a phenanthryl group.

In the case where $R_a$ and $R_b$ and $R_c$ each is an alkyl group, the alkyl group means a saturated or unsaturated, linear, branched or alicyclic alkyl group having from 1 to 20 carbon atoms and may be substituted by a halogen atom, a cyano group, an ester group, an oxy group, an alkoxy group, an aryloxy group or an aryl group. Examples of the saturated or unsaturated, linear, branched or alicyclic alkyl group having from 1 to 20 carbon atoms include a methyl group, an ethyl group, a propyl group, an isopropyl group, a butyl group, an isobutyl group, a tert-butyl group, a pentyl group, an isopentyl group, a neopentyl group, a hexyl group, an isohexyl group, an octyl group, an isooctyl group, a nonyl group, a decyl group, an undecyl group, a dodecyl group, a tridecyl group, a tetradecyl group, a vinyl group, a propenyl group, a butenyl group, a 2-butenyl group, a 3-butenyl group, an isobutenyl group, a pentenyl group, a 2-pentenyl group, a hexenyl group, a heptenyl group, an octenyl group, a cyclopropyl group, a cyclobutyl group, a cyclopentyl group, a cyclohexyl group, a cycloheptyl group, a cyclooctyl group, a cyclopentenyl group and a cyclohexenyl group.

The saturated or olefinic unsaturated ring formed by the combining of any two of $R_a$, $R_b$ and $R_c$ is specifically a cycloalkane or cycloalkene ring usually having a number of ring members of 3 to 8, preferably 5 or 6.

In the present invention, the compound represented by formula (A) is preferably an enol ether group where one of $R_a$, $R_b$ and $R_c$ is a methyl group or an ethyl group and the remaining is a hydrogen atom, more preferably a compound represented by the following formula (A-1) where $R_a$, $R_b$ and $R_c$ all are a hydrogen atom:

$$CH_2=CH-O-R \qquad \text{(A-1)}$$

wherein R is an alkyl group or a substituted alkyl group.

The alkyl group here is a linear, branched or cyclic alkyl group having from 1 to 30 carbon atoms.

The substituted alkyl group is a linear, branched or cyclic substituted alkyl group having from 1 to 30 carbon atoms.

Examples of the linear, branched or cyclic alkyl group having from 1 to 30 carbon atoms include an ethyl group, a linear, branched or cyclic propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group.

Preferred Examples of the substituent of the alkyl group include a hydroxy group, an alkyl group, an alkoxy group, an amino group, a nitro group, a halogen atom, a cyano group, an acyl group, an acyloxy group, a sulfonyl group, a sulfonyloxy group, a sulfonylamino group, an aryl group, an aralkyl group, an imido group, a hydroxymethyl group, $-O-R_{201}$, $-C(=O)-R_{202}$, $-O-C(=O)-R_{203}$, $-C(=O)-O-R_{204}$, $-S-R_{205}$, $-C(=S)-R_{206}$, $-O-C(=S)-R_{207}$ and $-C(=S)-O-R_{208}$ (wherein $R_{201}$ to $R_{208}$ each independently represents a linear, branched or cyclic alkyl group, an alkoxy group, an amino group, a nitro group, a halogen atom, a cyano group, an acyl group, a sulfonyl group, a sulfonyloxy group, a sulfonylamino group, an imido group, $-(CH_2CH_2O)_n-R_{209}$ (wherein n represents an integer of 1 to 20 and $R_{209}$ represents a hydrogen atom or an alkyl group) or an aryl or aralkyl group which may have a substituent (examples of the substituent here include a linear, branched or cyclic alkyl group, an alkoxy group, an amino group, a nitro group, a halogen atom, a cyano group, an acyl group, an aryl group and an aralkyl group)).

Preferred embodiments of the compound represented by formula (A) are set forth below, however, the present invention is not limited thereto.

A-1 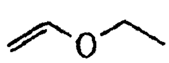

A − 2 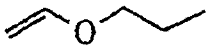

A − 3 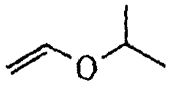

A − 4 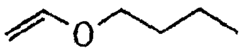

A − 5 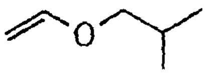

A − 6 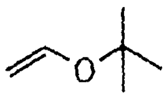

A − 7 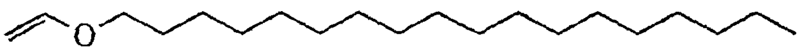

A − 8 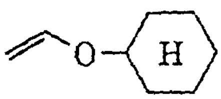

A − 9 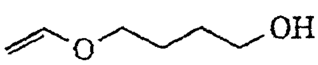

A −10 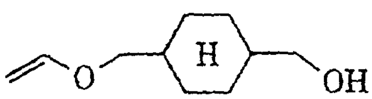

A −11 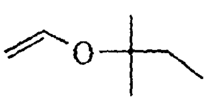

A −12 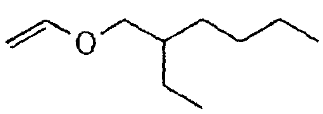

A −13 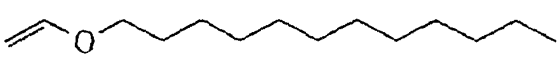

A－14 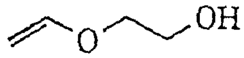

A－15 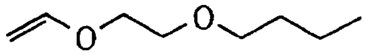

A－16 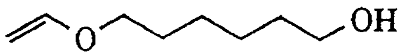

A－17 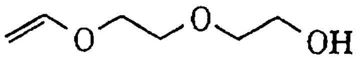

A－18 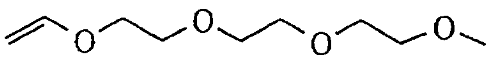

A－19 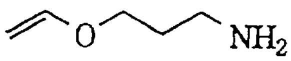

A－20 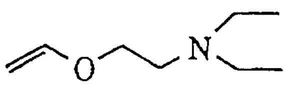

A－21 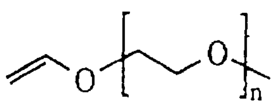 n=4~20

A－22 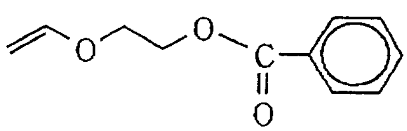

A－23 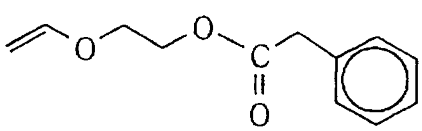

A－24

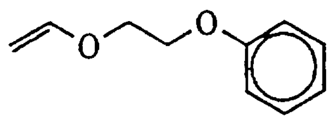

A－25

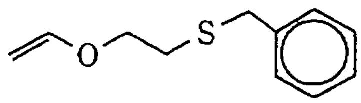

A－26

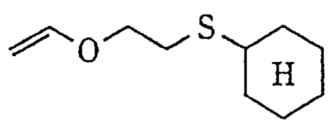

A－27

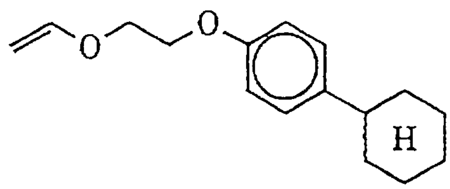

A－28

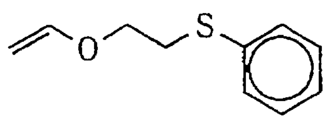

A－29

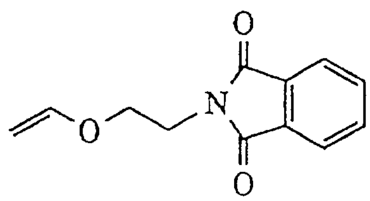

A－30

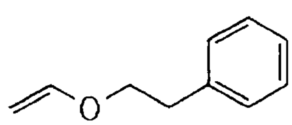

The compound represented by formula (A) can be synthesized by the method described, for example, in Stephen C. Lapin, Polymers Paint Colour Journal, 179 (4237), 321 (1988), that is, using a reaction of an alcohol or phenol with acetylene or a reaction of an alcohol or phenol with a halogenated alkyl vinyl ether. The compound may also be synthesized by the reaction of a carboxylic acid compound with a halogenated alkyl vinyl ether.

The amount of the cationically polymerizable compound (preferably the compound represented by formula (A)) added in the resist composition of the present invention is preferably from 0.5 to 50 wt%, more preferably from 3 to 30 wt%, based on the total amount (solid content) of the composition.

[II] Compound capable of generating an acid upon irradiation with a radiation (component (a))

The component (a) may be any compound insofar as it is a compound capable of generating an acid upon irradiation with a radiation, but is preferably a compound represented by the formula (I), (II) or (III) above.

[II-1] Compound represented by formula (I), (II) or (III)

In formulae (I) to (III), examples of the linear or branched alkyl group of $R_1$ to $R_{38}$ includes those having from 1 to 4 carbon atoms, which may have a substituent, such as methyl group, ethyl group, propyl group, n-butyl group, sec-butyl group and tert-butyl group. Examples of the cyclic alkyl group include those having from 3 to 8 carbon atoms, which may have a substituent, such as cyclopropyl group, cyclopentyl group and cyclohexyl group.
Examples of the linear or branched alkoxy group of $R_1$ to $R_{37}$ include those having from 1 to 4 carbon atoms, such as methoxy group, ethoxy group, hydroxyethoxy group, propoxy group, n-butoxy group, isobutoxy group, sec-butoxy group and tert-butoxy group.
Examples of the cyclic alkoxy group include a cyclopentyloxy group and a cyclohexyloxy group.
Examples of the halogen atom of $R_1$ to $R_{37}$ include a fluorine atom, a chlorine atom, a bromine atom and iodine atom.
Examples of the aryl group of $R_{38}$ include those having from 6 to 14 carbon atoms, which may have a substituent, such as phenyl group, tolyl group, methoxyphenyl group and naphthyl group.
Preferred examples of these substituents include an alkoxy group having from 1 to 4 carbon atoms, a halogen atom (e.g., fluorine, chlorine, bromine), an aryl group having from 6 to 10 carbon atoms, an alkenyl group having from 2 to 6 carbon atoms, a cyano group, a hydroxy group, a carboxy group, an alkoxycarbonyl group and a nitro group.
Examples of the ring formed by the combining of two or more of respective groups $R_1$ to $R_{15}$, $R_{16}$ to $R_{27}$, and $R_{28}$ to $R_{37}$ and having one or more member selected from the group consisting of a single bond, carbon, oxygen, sulfur and nitrogen include furan ring, dihydrofuran ring, pyran ring, trihydropyran ring, thiophene ring and pyrrole ring.
In formulae (I) to (III), $X^-$ is an anion of a benzenesulfonic acid, a naphthalenesulfonic acid or an anthracenesulfonic acid having at least one member selected from the group consisting of:

at least one fluorine atom,
a linear, branched or cyclic alkyl group substituted by at least one fluorine atom,
a linear, branched or cyclic alkoxy group substituted by at least one fluorine atom,
an acyl group substituted by at least one fluorine atom,
an acyloxy group substituted by at least one fluorine atom,
a sulfonyl group substituted by at least one fluorine atom,
a sulfonyloxy group substituted by at least one fluorine atom,
a sulfonylamino group substituted by at least one fluorine atom,
an aryl group substituted by at least one fluorine atom,
an aralkyl group substituted by at least one fluorine atom, and
an alkoxycarbonyl group substituted by at least one fluorine atom.

The above-described linear, branched or cyclic alkyl group is preferably a linear, branched or cyclic alkyl group having from 1 to 12 carbon atoms, which is substituted by from 1 to 25 fluorine atom(s). Specific examples thereof include a trifluoromethyl group, a pentafluoroethyl group, a 2,2,2-trifluoroethyl group, a heptafluoropropyl group, a heptafluoroisopropyl group, a perfluorobutyl group, a perfluorooctyl group, a perfluorododecyl group and a perfluorocyclohexyl group. In particular, a perfluoroalkyl group having from 1 to 4 carbon atoms all substituted by a fluorine atom is preferred.
The linear, branched or cyclic alkoxy group is preferably a linear, branched or cyclic alkoxy group having from 1 to 12 carbon atoms, which is substituted by from 1 to 25 fluorine atom(s). Specific examples thereof include a trifluoromethoxy group, a pentafluoroethoxy group, a heptafluoroisopropyloxy group, a perfluorobutoxy group, a perfluorooctyloxy group, a perfluorododecyloxy group and a perfluorocyclohexyloxy group. In particular, a perfluoroalkoxy group having from 1 to 4 carbon atoms all substituted by a fluorine atom is preferred.
The acyl group is preferably an acyl group having from 2 to 12 carbon atoms, which is substituted by from 1 to 23 fluorine atom(s). Specific examples thereof include a trifluoroacetyl group, a fluoroacetyl group, a pentafluoropropionyl group and a pentafluorobenzoyl group.

The acyloxy group is preferably an acyloxy group having from 2 to 12 carbon atoms, which is substituted by from 1 to 23 fluorine atom(s). Specific examples thereof include a trifluoroacetoxy group, a fluoroacetoxy group, a pentafluoropropionyloxy group and a pentafluorobenzoyloxy group.

The sulfonyl group is preferably a sulfonyl group having from 1 to 12 carbon atoms, which is substituted by from 1 to 25 fluorine atom(s). Specific examples thereof include a trifluoromethanesulfonyl group, a pentafluoroethanesulfonyl group, a perfluorobutanesulfonyl group, a perfluorooctanesulfonyl group, a pentafluorobenzenesulfonyl group and a 4-trifluoromethylbenzenesulfonyl group.

The sulfonyloxy group is preferably a sulfonyloxy group having from 1 to 12 carbon atoms, which is substituted by from 1 to 25 fluorine atom(s). Specific examples thereof include a trifluoromethanesulfonyloxy group, a perfluorobutanesulfonyloxy group and a 4-trifluoromethylbenzenesulfonyloxy group.

The sulfonylamino group is preferably a sulfonylamino group having from 1 to 12 carbon atoms, which is substituted by from 1 to 25 fluorine atoms. Specific examples thereof include a trifluoromethanesulfonylamino group, a perfluorobutanesulfonylamino group, a perfluorooctanesulfonylamino group and a pentafluorobenzenesulfonylamino group.

The aryl group is preferably an aryl group having from 6 to 14 carbon atoms, which is substituted by from 1 to 9 fluorine atom(s). Specific examples thereof include a pentafluorophenyl group, a 4-trifluoromethylphenyl group, a heptafluoronaphthyl group, a nonafluoroanthranyl group, a 4-fluorophenyl group and a 2,4-difluorophenyl group.

The aralkyl group is preferably an aralkyl group having from 7 to 10 carbon atoms, which is substituted by from 1 to 15 fluorine atom(s). Specific examples thereof include a pentafluorophenylmethyl group, a pentafluorophenylethyl group, a perfluorobenzyl group and a perfluorophenethyl group.

The alkoxycarbonyl group is preferably an alkoxycarbonyl group having from 2 to 13 carbon atoms, which is substituted by from 1 to 25 fluorine atom(s). Specific examples thereof include a trifluoromethoxycarbonyl group, a pentafluoroethoxycarbonyl group, a pentafluorophenoxycarbonyl group, a perfluorobutoxycarbonyl group and a perfluorooctyloxycarbonyl group.

$X^-$ is most preferably a fluorine-substituted benzenesulfonate anion, particularly preferably a pentafluorobenzenesulfonate anion.

The benzenesulfonic acid, naphthalenesulfonic acid or anthracenesulfonic acid having a fluorine-containing substituent may further be substituted by a linear, branched or cyclic alkoxy group, an acyl group, an acyloxy group, a sulfonyl group, a sulfonyloxy group, a sulfonylamino group, an aryl group, an aralkyl group, an alkoxycarbonyl group (the number of carbon atoms is in the same range as described above), a halogen (excluding fluorine), a hydroxyl group, a nitro group or the like.

Specific examples of the compound represented by formula (I) are set forth below.

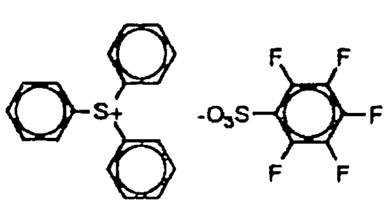

(I-1)

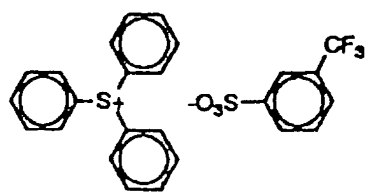

(I-2)

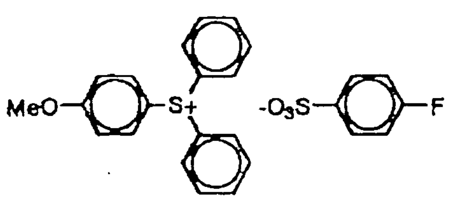

(I-3)

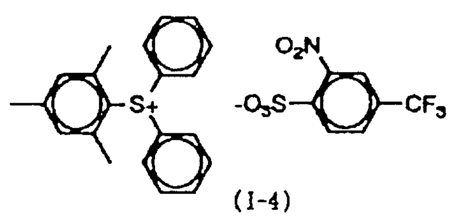

(I-4)

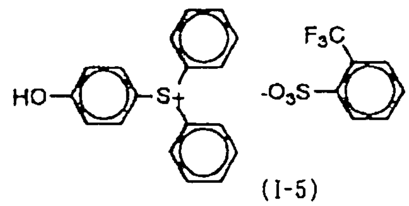

(I-5)

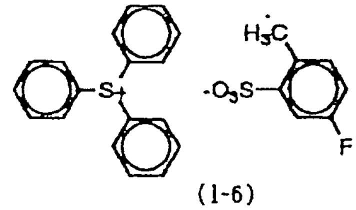

(I-6)

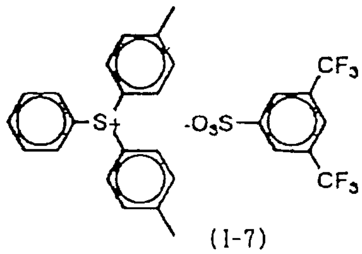

(I-7)

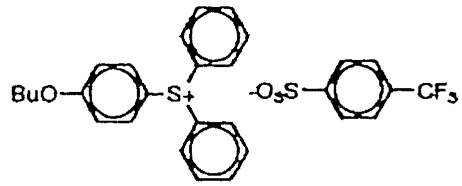

(I-8)

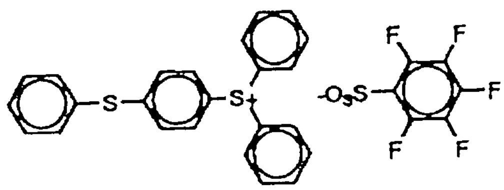

(I-9)

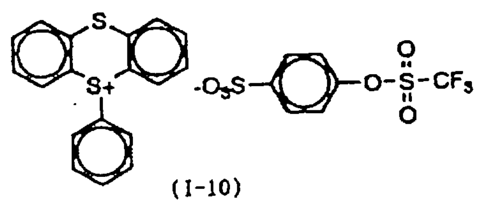

(I-10)

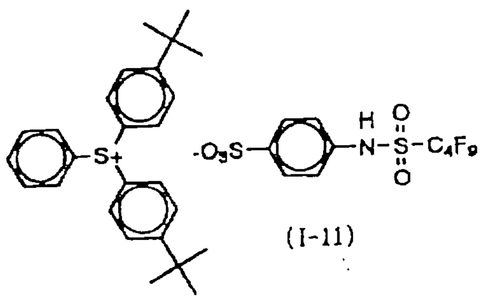

(I-11)

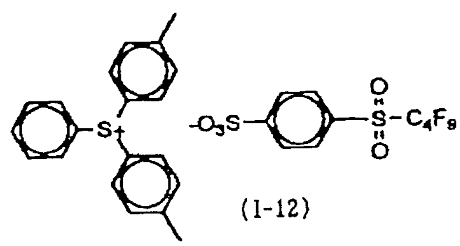

(I-12)

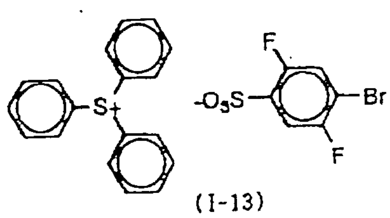

(I-13)

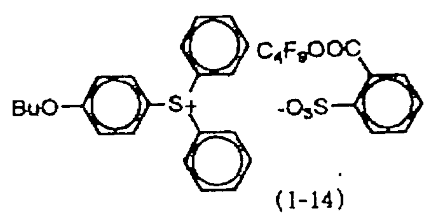

(I-14)

Specific examples of the compound represented by formula (II) are set forth below.

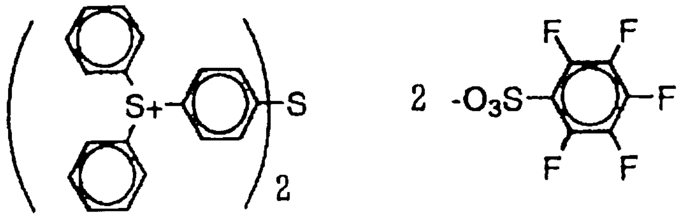

(II-1)

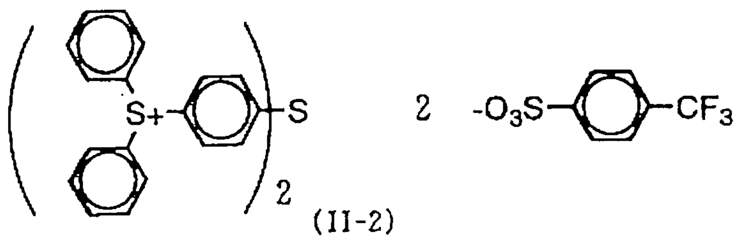

(II-2)

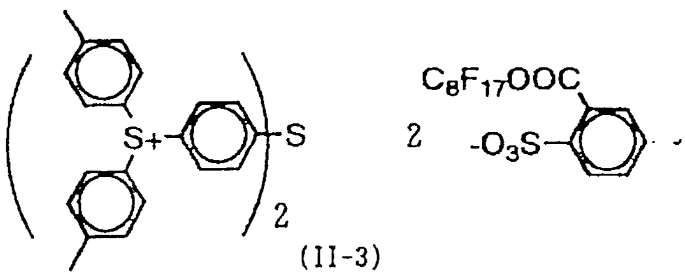

(II-3)

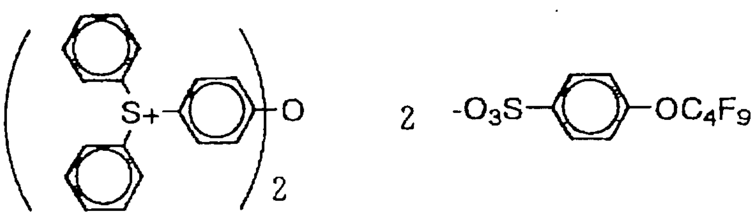

(II-4)

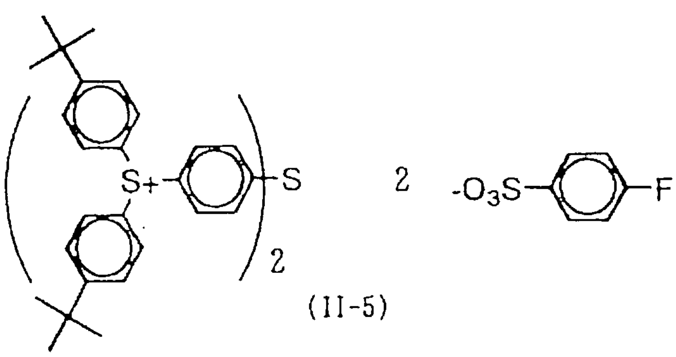

(II-5)

Specific examples of the compound represented by formula (III) are set forth below.

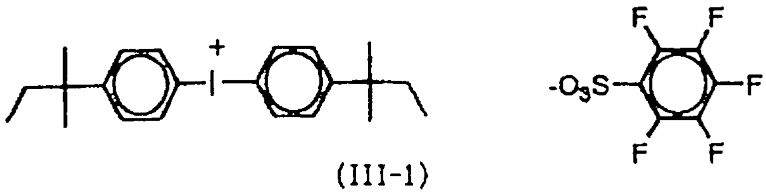

(III-1)

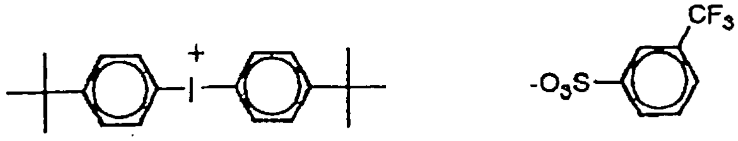

(III-2)

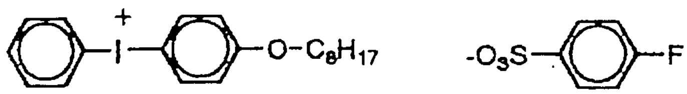

(III-3)

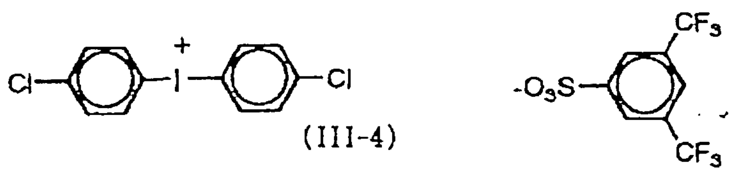

(III-4)

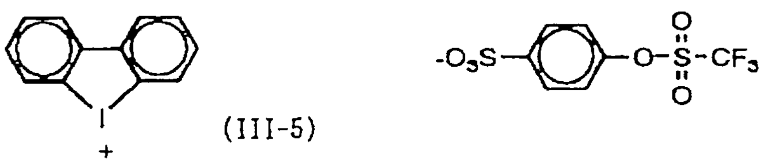

(III-5)

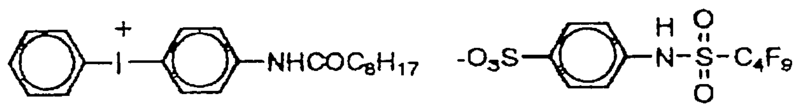

(III-6)

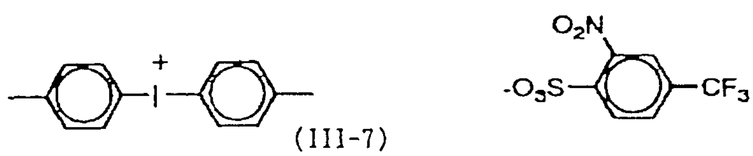

(III-7)

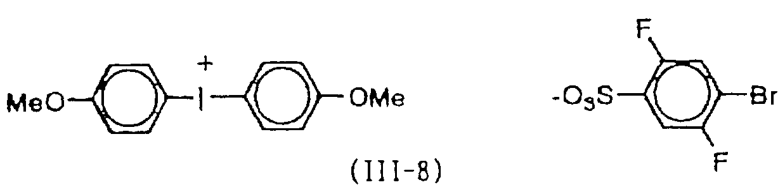

(III-8)

The compounds represented by formulae (I) to (III) may be used individually or in combination of two or more thereof.

The compounds of formulae (I) and (II) each may be synthesized by a method of reacting an aryl Grignard's reagent such as aryl magnesium bromide with a substituted or unsubstituted phenylsulfoxide and salt-exchanging the obtained triarylsulfonium halide with a corresponding sulfonic acid, a method of condensing and salt-exchanging a substituted or unsubstituted phenylsulfoxide with a corresponding aromatic compound using an acid catalyst such as methanesulfonic acid/phosphorus pentoxide or aluminum chloride, or a method of condensing and salt-exchanging a diaryliodonium salt and a diarylsulfide using a catalyst such as copper acetate.

The compound of formula (III) can be synthesized by reacting an aromatic compound using a periodate.

The sulfonic acid or sulfonate for use in the salt-exchange can be obtained by a method of hydrolyzing a commercially available sulfonic acid chloride, a method of reacting an aromatic compound with a chlorosulfonic acid, or a method of reacting an aromatic compound with a sulfamic acid.

The method for synthesizing specific compounds of formulae (I) to (III) is specifically described below.

(Synthesis of Tetramethylammonium Pentafluorobenzenesulfonate)

Under ice cooling, 25 g of pentafluorobenzenesulfonium chloride was dissolved in 100 ml of methanol and thereto, 100 g of an aqueous 25% tetramethylammonium hydroxide solution was gradually added. After stirring at room temperature for 3 hours, a solution of tetramethylammonium pentafluorobenzenesulfonate was obtained. This solution was used for the salt-exchange with a sulfonium salt or an iodonium salt.

(Synthesis of Triphenylsulfonium Pentafluorobenzenesulfonate: Synthesis of Compound (I-1))

In 800 ml of benzene, 50 g of diphenylsulfoxide was dissolved and thereto, 200 g of aluminum chloride was added and refluxed for 24 hours. The reaction solution was gradually poured into 2 liter of water and thereto, 400 ml of concentrated hydrochloric acid was added and heated at 70°C for 10 minutes. The resulting aqueous solution was washed with 500 ml of ethyl acetate and filtered and thereto, 200 g of ammonium iodide dissolved in 400 ml of water was added.

The precipitated powder was filtered, washed with water and then with ethyl acetate, and dried, as a result, 70 g of triphenylsulfonium iodide was obtained.

In 1,000 ml of methanol, 30.5 g of triphenylsulfonium iodide was dissolved and to the resulting solution, 19.1 g of silver oxide was added and stirred at room temperature for 4 hours. The obtained solution was filtered and thereto a solution containing an excess amount of tetramethylammonium pentafluorobenzenesulfonate prepared above was added. The reaction solution was concentrated and then dissolved in 500 ml of dichloromethane and the resulting solution was washed with an aqueous 5% tetramethylammonium hydroxide solution and with water. The organic phase was dried over anhydrous sodium sulfate and concentrated, as a result, triphenylsulfonium pentafluorobenzenesulfonate was obtained.

(Synthesis of Triarylsulfonium Pentafluorobenzenesulfonate: Synthesis of Mixture of Compounds (I-9) and (II-1))

In 500 ml of water, 50 g of triarylsulfonium chloride (an aqueous 50% triphenylsulfonium chloride solution, produced by Fluka) was dissolved and thereto, a solution containing an excess amount of tetramethylammonium pentafluorobenzenesulfonate was added, as a result, an oily substance was precipitated. The supernatant was removed by decantation and the obtained oily substance was washed with water and then dried, whereby triarylsulfonium pentafluorobenzenesulfonate (mainly comprising Compounds (I-9) and (II-1)) was obtained.

(Synthesis of Di(4-tert-amylphenyl)iodonium Pentafluorobenzenesulfonate: Synthesis of Compound (III-1))

60 g of tert-amylbenzene, 39.5 g of potassium iodate, 81 g of acetic acid anhydride and 170 ml of dichloromethane were mixed and thereto, 66.8 g of concentrated sulfuric acid was gradually added dropwise under ice cooling. The resulting solution was stirred under ice cooling for 2 hours and then stirred at room temperature for 10 hours. To the reaction solution, 500 ml of water was added under ice cooling, the solution obtained was extracted with dichloromethane and the organic phase was washed with sodium hydrogencarbonate and with water and then concentrated, as a result, a di(4-tert-amylphenyl)iodonium sulfate was obtained. This sulfate was added to a solution containing an excess amount of tetramethylammonium pentafluorobenzenesulfonate. After adding 500 ml of water thereto, the resulting solution was extracted with dichloromethane and the organic phase was washed with an aqueous 5% tetramethylammonium hydroxide solution and with water and then concentrated, as a result, di(4-tert-amylphenyl) iodonium pentafluorobenzenesulfonate was obtained.

Other compounds can also be synthesized by similar methods.

[II-2] Other acid generators which can be used as the component (a)

In the present invention, the following compounds which each decomposes upon irradiation with a radiation to generate an acid can also be used as the component (a).

Furthermore, the following compounds which each decomposes upon irradiation with a radiation to generate an acid can be used as the component (a) in combination with the compounds represented by formulae (I) to (III).

The amount used of the acid generator which can be used in combination with the compounds represented by formula (I) to (III) is, in terms of molar ratio (component (a)/other acid generator), usually from 100/0 to 20/80, preferably from 100/0 to 40/60, more preferably from 100/0 to 50/50.

The total content of the component (a) is usually from 0.1 to 20 wt%, preferably from 0.5 to 10 wt%, more preferably from 1 to 7 wt%, based on the solid content in the entire composition of the positive electron beam or X-ray resist composition of the present invention.

This acid generator may be appropriately selected from a photoinitiator for photocationic polymerization, a photoinitiator for photoradical polymerization, a photo-decoloring agent for dyes, a photo-discoloring agent, a known compound used for microresist or the like and capable of generating an acid upon irradiation with a radiation, and a combination thereof.

Examples thereof include onium salts such as diazonium salts described in S.I. Schlesinger, Photogr. Sci. Eng., 18, 387 (1974), T.S. Bal et al., Polymer, 21, 423 (1980), etc., ammonium salts described in U.S. Patents 4,069,055, 4,069,056 and Re27,992, Japanese Patent Application No. 3-140140, etc., phosphonium salts described in D.C. Necker et al., Macromolecules, 17, 2468 (1984), C.S. Wen et al., Teh, Proc. Conf. Rad. Curing ASIA, p. 478, Tokyo, Oct. (1988), U.S. Patents 4,069,055 and 4,069,056, etc., iodonium salts described in J.V. Crivello et al., Macromolecules, 10 (6) 1307 (1977), Chem. & Eng. News, Nov. 28, p. 31 (1988), European Patents 104,143, 339,049 and 410,201, JP-A-2-150848, JP-A-2-296514, etc., sulfonium salts described in J.V. Crivello et al., Polymer J., 17, 73 (1985), J.V. Crivello et al., J. Org. Chem., 43, 3055 (1978), W.R. Watt et al., J. Polymer Sci., Polymer Chem. Ed., 22, 1789 (1984), J.V. Crivello et al., Polymer Bull., 14, 279 (1985), J.V. Crivello et al., Macromolecules, 14 (5), 1141 (1981), J.V. Crivello et al., J. Polymer Sci., Polymer Chem. Ed., 17, 2877 (1979), European Patents 370,693, 233,567, 297,443, 297,442, 161,811, 410,201 and 339,049, U.S. Patents 3,902,114, 4,933,377, 4,760,013, 4,734,444 and 2,833,827, German Patent 2,904,626, 3,604,580 and 3,604,581, etc., selenonium salts described in J.V. Crivello et al., Macromolecules, 10 (6), 1307 (1977), J.V. Crivello et al., J. Polymer Sci., Polymer Chem. Ed., 17, 1047 (1979), etc., and arsonium salts described in C.S. Wen et al., Teh, Proc. Conf. Rad. Curing ASIA, p. 478, Tokyo, Oct. (1988), etc.; organic halogen compounds described in U.S. Patent 3,905,815, JP-B-46-4605 (the term "JP-B" as used herein means an "examined Japanese patent publication"), JP-A-48-36281 (the term "JP-A" as used herein means an "unexamined published Japanese patent application"), JP-A-55-32070, JP-A-60-239736, JP-A-61-169835, JP-A-61-169837, JP-A-62-58241, JP-A-62-212401, JP-A-63-70243, JP-A-63-298339, etc.; organic metals/organic halides described in K. Meier et al., J. Rad. Curing, 13 (4), 26 (1986), T.P. Gill et al., Inorg. Chem., 19, 3007 (1980), D. Astruc, Acc. Chem. Res., 19 (12), 377 (1896), JP-A-2-161445, etc.; photo-acid generators having an o-nitrobenzyl type protective group described in S. Hayase et al., J. Polymer Sci., 25, 753 (1987), E. Reichmanis et al., J. Polymer Sci., Polymer Chem. Ed., 23, 1 (1985), Q.Q. Zhu et al., J. Photochem., 36, 85, 39, 317 (1987), B. Amit et al., Tetrahedron Lett., (24) 2205 (1973), D.H.R. Barton et al., J. Chem. Soc., 3571 (1965), P.M. Collins et al., J. Chem. Soc., Perkin I, 1695 (1975), M. Rudinstein et al., Tetrahedron Lett., (17), 1445 (1975), J.W. Walker et al., J. Am. Chem. Soc., 110, 7170 (1988), S.C. Busman et al., J. Imaging Technol., 11 (4), 191 (1985), H.M. Houlihan et al., Macromolecules, 21, 2001 (1988), P.M. Collins et al., J. Chem. Soc., Chem. Commun., 532 (1972), S. Hayase et al., Macromolecules, 18, 1799 (1985), E. Reichmanis et al., J. Electrochem. Soc., Solid State Sci. Technol., 130 (6), F.M. Houlihan et al., Macromolecules, 21, 2001 (1988), European Patents 0,290,750, 046,083, 156,535, 271,851 and 0,388,343, U.S. Patents 3,901,710 and 4,181,531, JP-A-60-198538, JP-A-53-133022, etc.; compounds which are photochemically decomposed to generate sulfonic acid, represented by iminosulfonate, described in M. TUNOOKA et al., Polymer Preprints Japan, 35 (8), G. Berner et al., J. Rad. Curing, 13 (4), W.J. Mijs et al., Coating Technol., 55 (697), 45 (1983), Akzo, H. Adachi et al., Polymer Preprints, Japan, 37 (3), European Patents 0,199,672, 84,515, 199,672, 044,115, 618,564 and 0,101,122, U.S. Patents 4,371,605 and 4,431,774, JP-A-64-18143, JP-A-2-245756, Japanese Patent Application No. 3-140109, etc.; and disulfone compounds described in JP-A-61-166544, etc.

In addition, compounds in which the above-described group or compound capable of generating an acid upon irradiation with a radiation is introduced into the main chain or side chain may also be used and examples thereof include the compounds described in M.E. Woodhouse et al., J. Am. Chem. Soc., 104, 5586 (1982), S.P. Pappas et al., J. Imaging Sci., 30 (5), 218 (1986), S. Kondo et al., Makromol. Chem., Rapid Commun., 9, 625 (1988), Y. Yamada et al., Makromol. Chem., 152, 153, 163 (1972), J.V. Crivello et al., J. Polymer Sci., Polymer Chem. Ed., 17, 3845 (1979), U.S. Patent 3,849,137, German Patent 3,914,407, JP-A-63-26653, JP-A-55-164824, JP-A-62-69263, JP-A-63-146038,

JP-A-63-163452, JP-A-62-153853, JP-A-63-146029, etc.

Furthermore, the compounds capable of generating an acid by light, described in V.N.R. Pillai, Synthesis, (1), 1 (1980), A. Abad et al., Tetrahedron Lett., (47) 4555 (1971), D.H.R. Barton et al., J. Chem. Soc., (C), 329 (1970), U. S. Patent 3,779,778, European Patent 126,712, etc. may also be used.

Among these compounds capable of decomposing upon irradiation with a radiation and thereby generating an acid, which can be used in combination, particularly effective compounds are described below.

(1) Oxazole derivatives represented by the following formula (PAG1) and S-triazine derivatives represented by the following formula (PAG2), which are substituted by a trihalomethyl group:

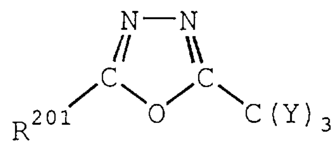

(PAG1)

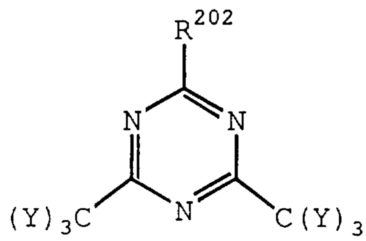

(PAG2)

wherein $R^{201}$ represents a substituted or unsubstituted aryl group or a substituted or unsubstituted alkenyl group, $R^{202}$ represents a substituted or unsubstituted aryl group, a substituted or unsubstituted alkenyl group, a substituted or unsubstituted alkyl group or $-C(Y)_3$, and Y represents a chlorine atom or a bromine atom.

Specific examples thereof include the following compounds, however, the present invention is by no means limited thereto.

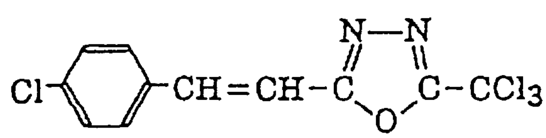

(PAG1-1)

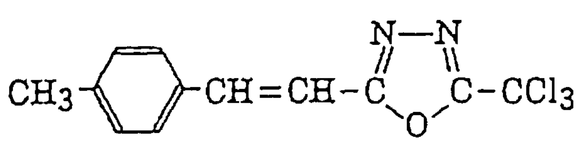

(PAG1-2)

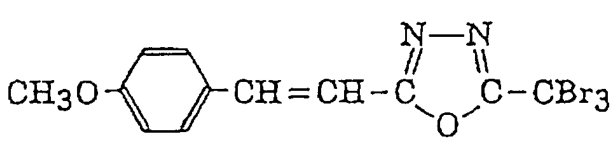

(PAG1-3)

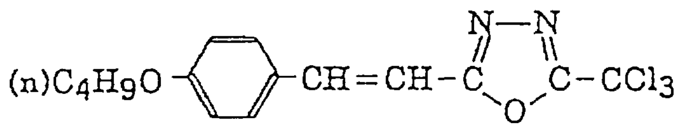

(PAG1-4)

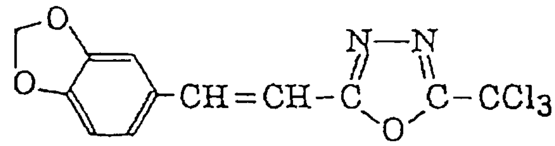

(PAG1-5)

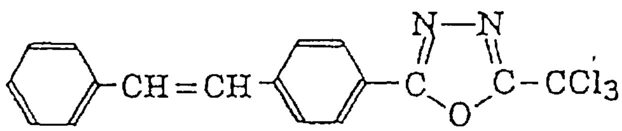

(PAG1-6)

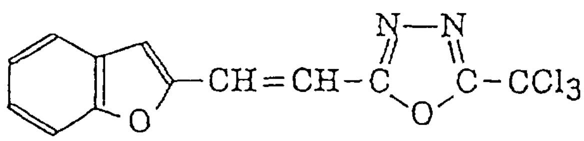

(PAG1-7)

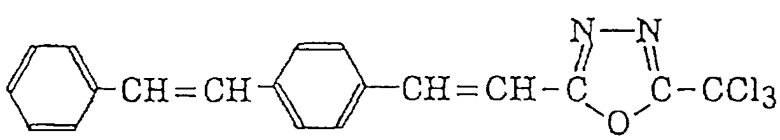

(PAG1-8)

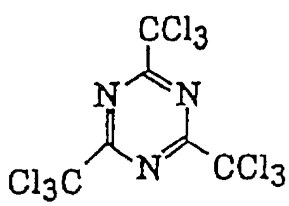

(PAG2-1)

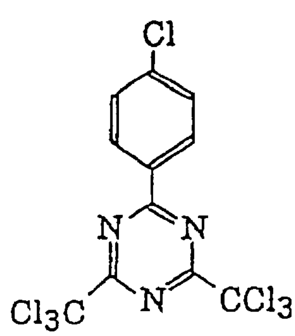

(PAG2-2)

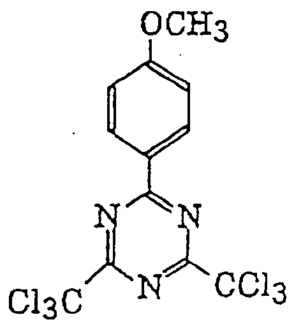

(PAG2-3)

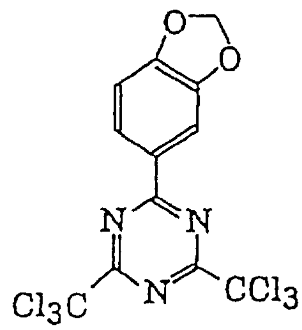

(PAG2-4)

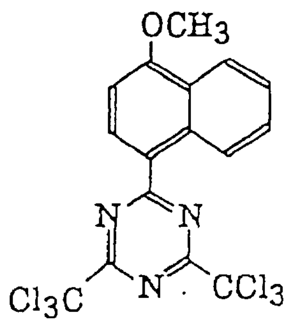

(PAG2-5)

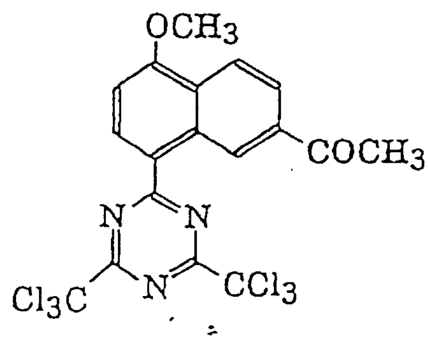

(PAG2-6)

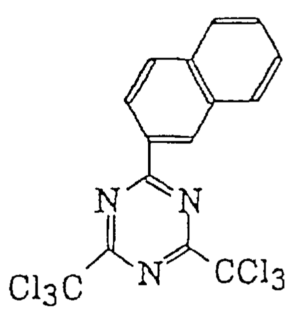

(PAG2-7)

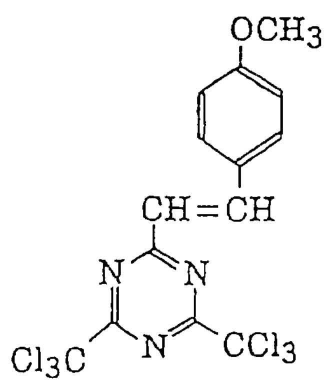

(PAG2-8)

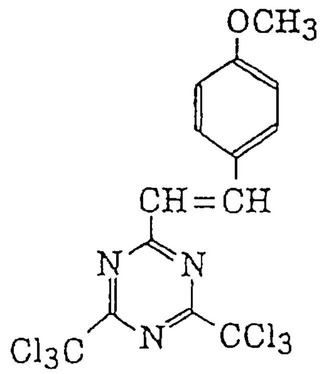

(PAG2-8)

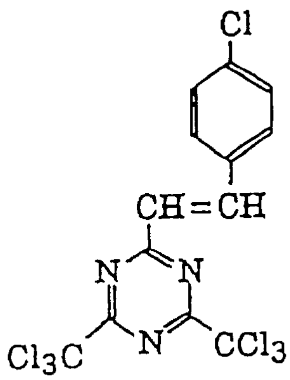

(PAG2-9)

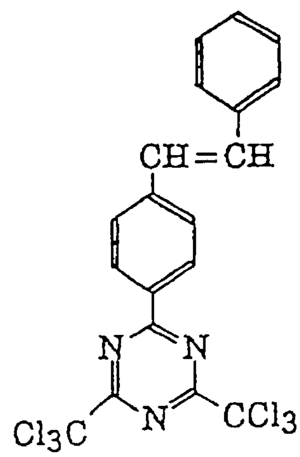

(PAG2-10)

(2) Iodonium salts represented by the following formula (PAG3) and sulfonium salts represented by the following formula (PAG4):

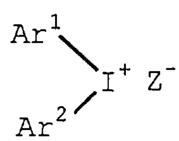

(PAG3)

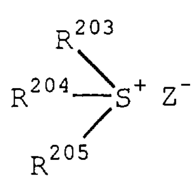

(PAG4)

In formula (PAG3), $Ar^1$ and $Ar^2$ each independently represents a substituted or unsubstituted aryl group. The substituent is preferably an alkyl group, a haloalkyl group, a cycloalkyl group, an aryl group, an alkoxy group, a nitro group, a carboxyl group, an alkoxycarbonyl group, a hydroxy group, a mercapto group or a halogen atom.

In formula (PAG4), $R^{203}$, $R^{204}$ and $R^{205}$ each independently represents a substituted or unsubstituted alkyl group or a substituted or unsubstituted aryl group, and preferably an aryl group having from 6 to 14 carbon atoms, an alkyl group having from 1 to 8 carbon atoms or a substituted derivative thereof. The substituent of the aryl group

is preferably an alkoxy group having from 1 to 8 carbon atoms, an alkyl group having from 1 to 8 carbon atoms, a nitro group, a carboxyl group, a hydroxy group or a halogen atom, and the substituent of the alkyl group is preferably an alkoxy group having from 1 to 8 carbon atoms, a carboxyl group or an alkoxycarbonyl group.

In formulae (PAG3) and (PAG4), $Z^-$ represents a counter anion and examples thereof include $BF_4^-$, As $F_6^-$, $PF_6^-$, $SbF_6^-$, $SiF_6^{2-}$, $ClO_4^-$ , perfluoroalkane sulfonate anion such as $CF_3SO_3^-$, condensed polynuclear aromatic sulfonate anion such as pentafluorobenzene sulfonate anion and naphthalene-1-sulfonate anion, anthraquinone sulfonate anion and sulfonic acid group-containing dye, however, the present invention is not limited thereto.

Two of $R^{203}$, $R^{204}$ and $R^{205}$, or $Ar^1$ and $Ar^2$ may be connected through a single bond or a substituent.

Specific examples thereof include the following compounds, however, the present invention is by no means limited thereto.

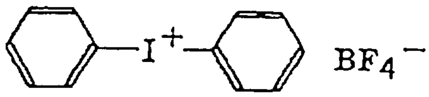

(PAG3-1)

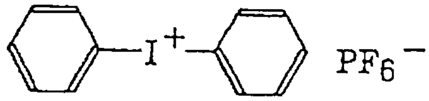

(PAG3-2)

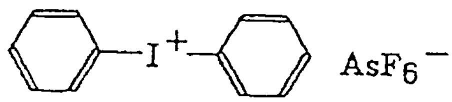

(PAG3-3)

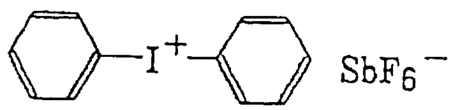

(PAG3-4)

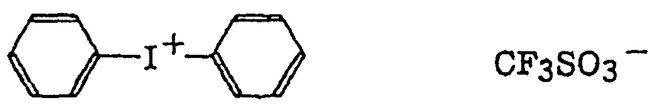

(PAG3-5)

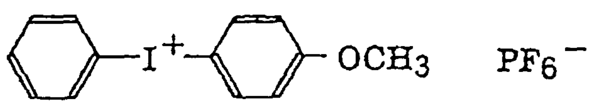

(PAG3-6)

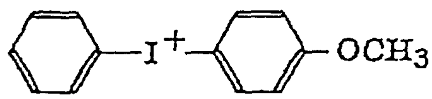

$SbF_6^-$

(PAG3-7)

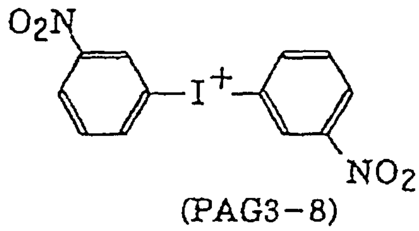

$PF_6^-$

(PAG3-8)

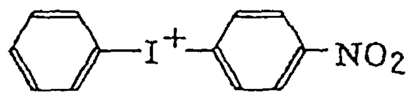

$CF_3SO_3^-$

(PAG3-9)

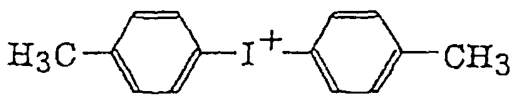

$AsF_6^-$

(PAG3-10)

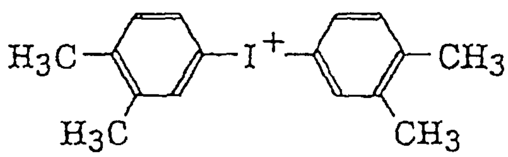

$SbF_6^-$

(PAG3-11)

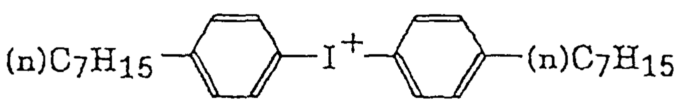

$PF_6^-$

(PAG3-12)

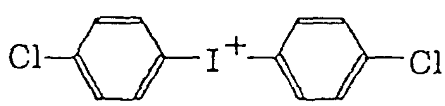

$PF_6^-$

(PAG3-13)

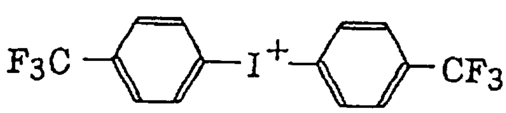

$CF_3SO_3^-$

(PAG3-14)

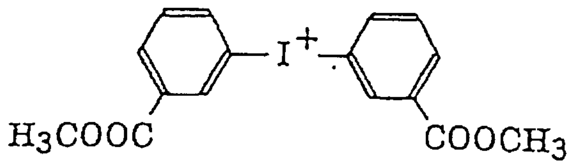

$PF_6^-$

(PAG3-15)

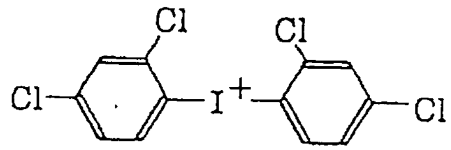

$PF_6^-$

(PAG3-16)

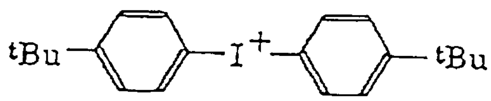

$SbF_6^-$

(PAG3-17)

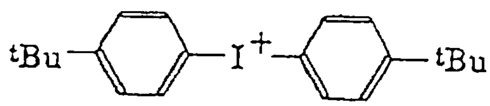

$PF_6^-$

(PAG3-18)

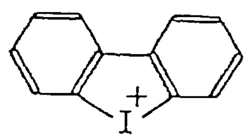

$PF_6^-$

(PAG3-19)

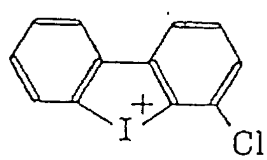

$CF_3SO_3^-$

(PAG3-20)

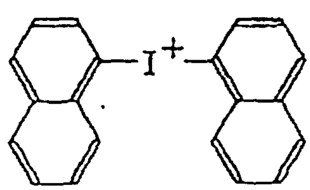

$CF_3SO_3^-$

(PAG3-21)

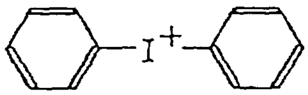 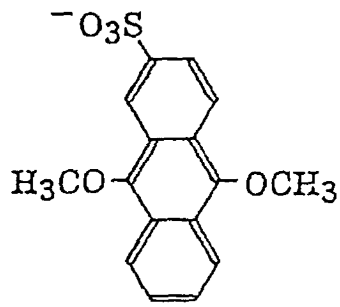

(PAG3-22)

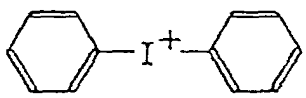 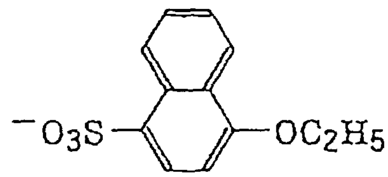

(PAG3-23)

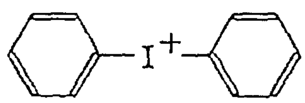 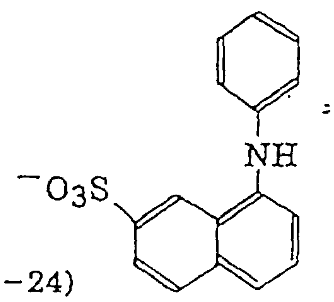

(PAG3-24)

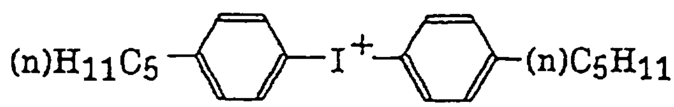

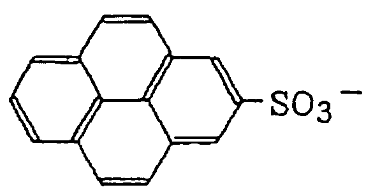

(PAG3-25)

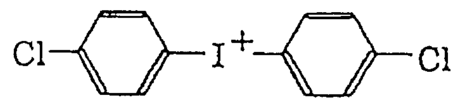

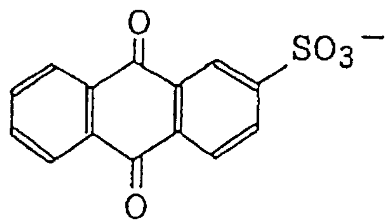

(PAG3-26)

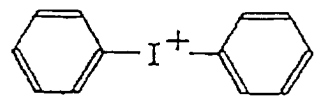

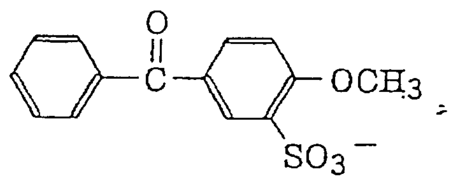

(PAG3-27)

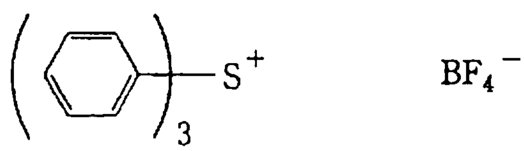

(PAG4-1)

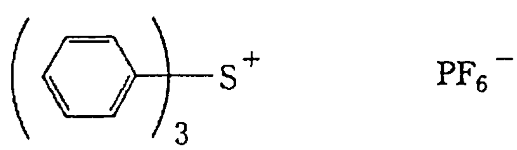

(PAG4-2)

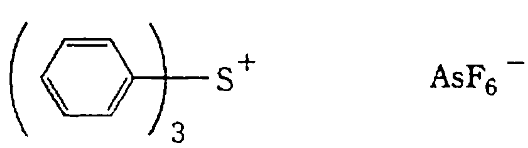

(PAG4-3)

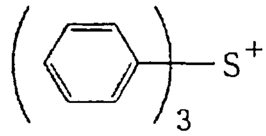

$SbF_6^-$

(PAG4-4)

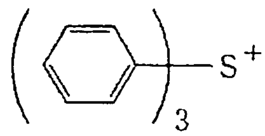

$CF_3SO_3^-$

(PAG4-5)

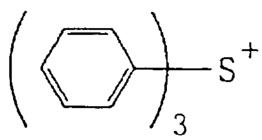

$C_8F_{17}SO_3^-$

(PAG4-6)

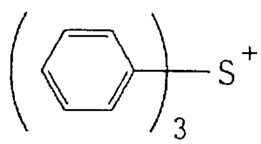

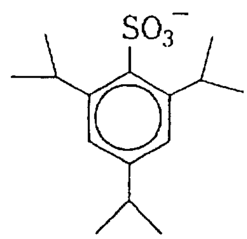

(PAG4-7)

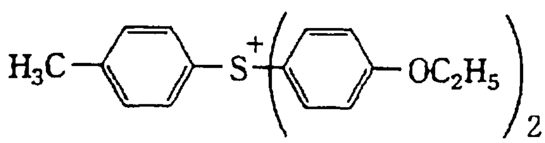

$CF_3SO_3^-$

(PAG4-8)

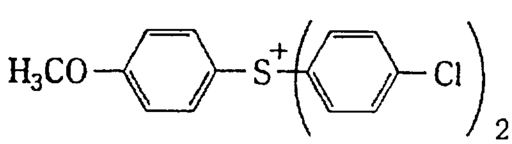

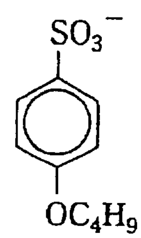

(PAG4-9)

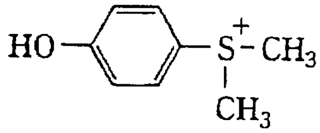
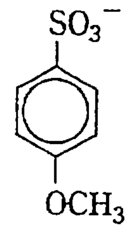

(PAG4-10)

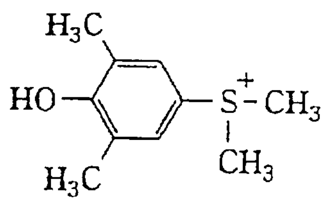
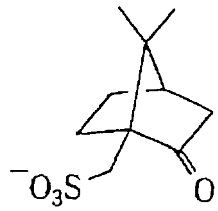

(PAG4-11)

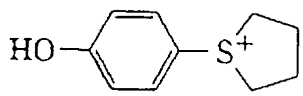

$BF_4^-$

(PAG4-12)

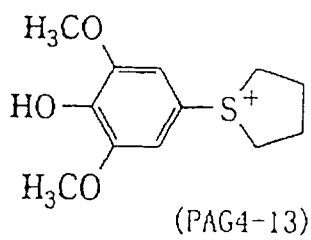

$CF_3SO_3^-$

(PAG4-13)

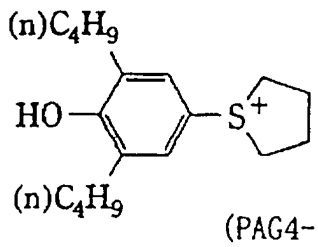

$PF_6^-$

(PAG4-14)

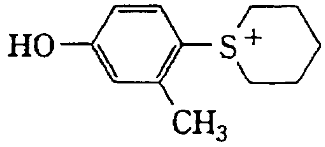
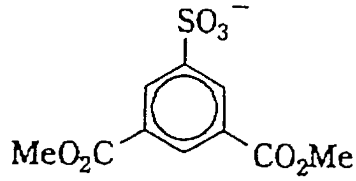

(PAG4-15)

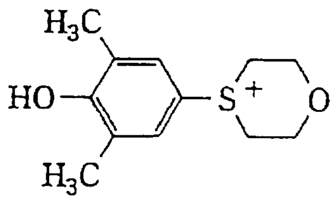

$PF_6^-$

(PAG4-16)

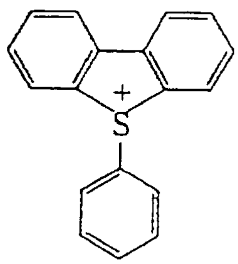

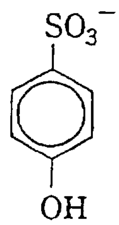

(PAG4-17)

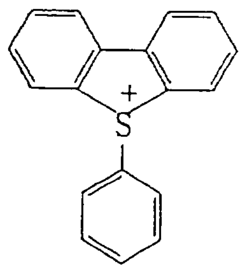

$C_8F_{17}SO_3^-$

(PAG4-18)

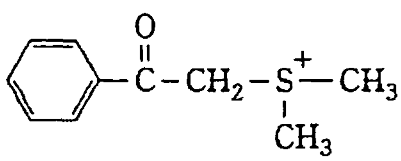

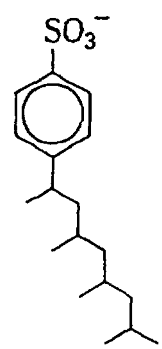

(PAG4-19)

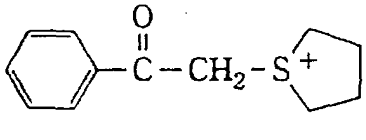

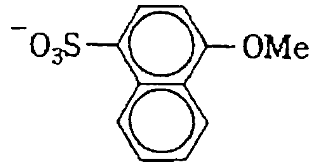

(PAG4-20)

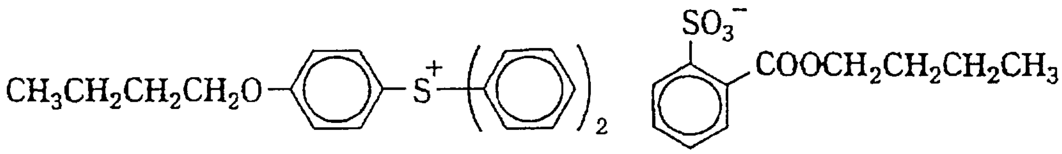

(PAG4-21)

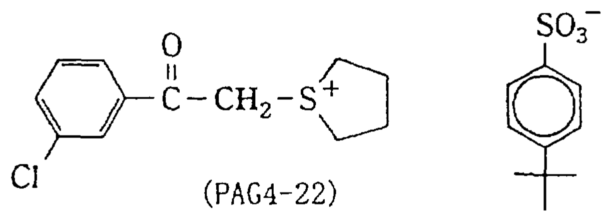

(PAG4-22)

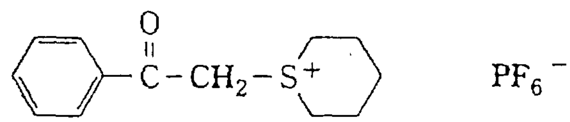

(PAG4-23)

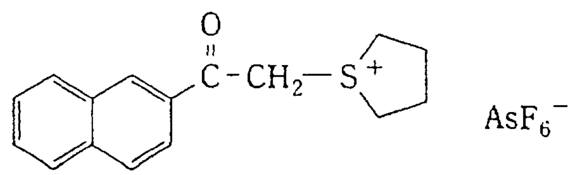

(PAG4-24)

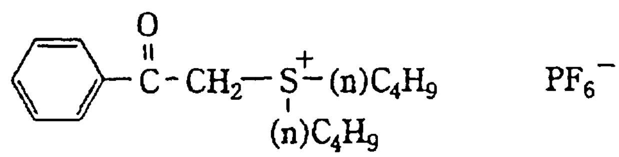

(PAG4-25)

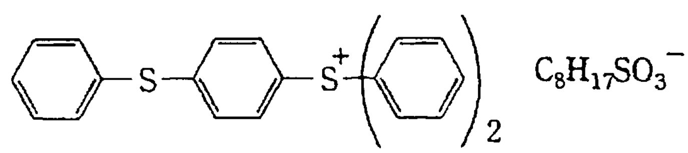

(PAG4-26)

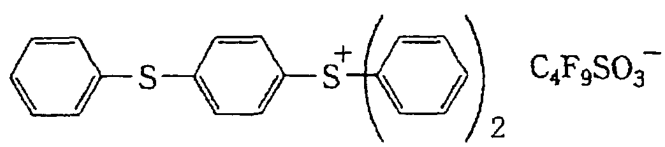

(PAG4-27)

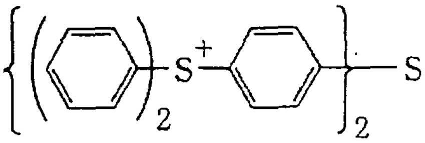 $2CF_3SO_3^-$

(PAG4-28)

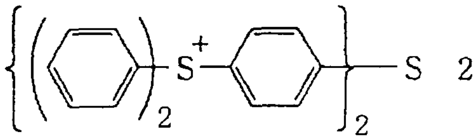

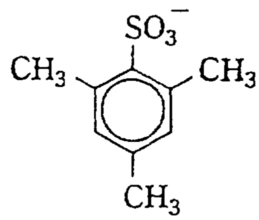

(PAG4-29)

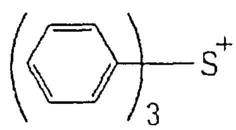

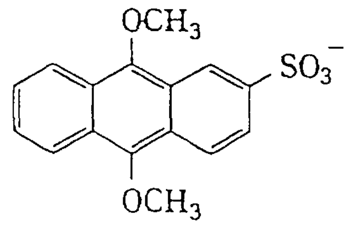

(PAG4-30)

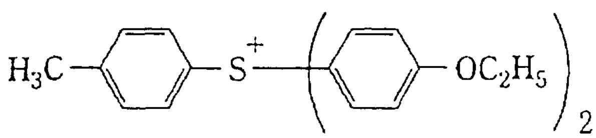

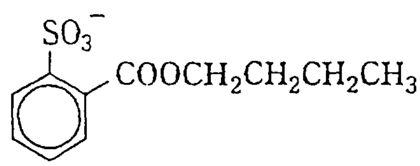

(PAG4-31)

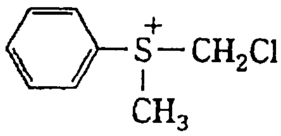

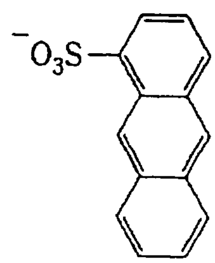

(PAG4-32)

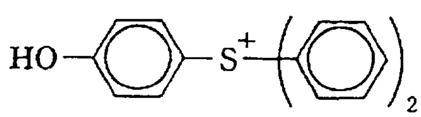

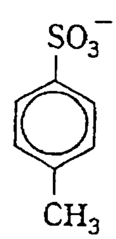

(PAG4-33)

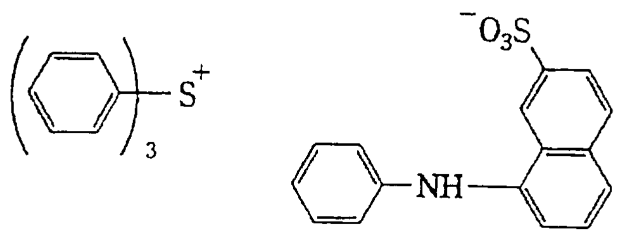

(PAG4-34)

The above-described onium salts represented by formulae (PAG3) and (PAG4) are known and can be synthesized by the method described, for example, in J.W. Knapczyl et al., J. Am. Chem. Soc., 91, 145 (1969), A.L. Maycok et al., J. Org. Chem., 35, 2532 (1970), E. Goethas et al., Bull. Soc. Chem. Belg., 73, 546 (1964), H.M. Leicester, J. Am. Chem. Soc., 51, 3587 (1929), J.V. Crivello et al., J. Polym. Chem. Ed., 18, 2677 (1980), U.S. Patents 2,807,648 and 4,247,473, JP-A-53-101331, etc.

(3) Disulfonic acid derivatives represented by the following formula (PAG5) and iminosulfonate derivatives represented by formula (PAG6):

$$Ar^3\text{-}SO_2\text{-}SO_2\text{-}Ar^4 \qquad \text{(PAG5)}$$

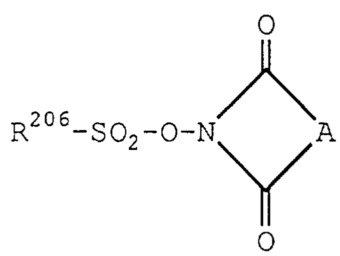

(PAG6)

wherein $Ar^3$ and $Ar^4$ each independently represents a substituted or unsubstituted aryl group, $R^{206}$ represents a substituted or unsubstituted alkyl group or a substituted or unsubstituted aryl group, A represents a substituted or unsubstituted alkylene group, a substituted or unsubstituted alkenylene group or a substituted or unsubstituted arylene group.

Specific examples thereof include the following compounds, however, the present invention is by no means limited thereto.

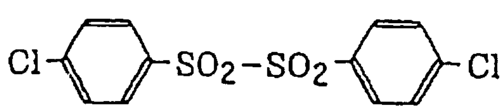

(PAG5-1)

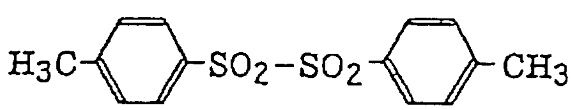

(PAG5-2)

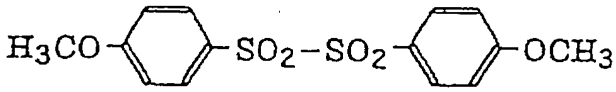

(PAG5−3)

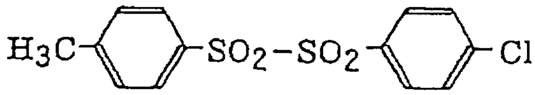

(PAG5−4)

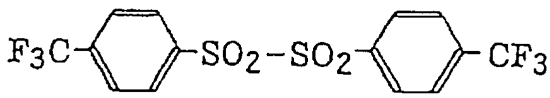

(PAG5−5)

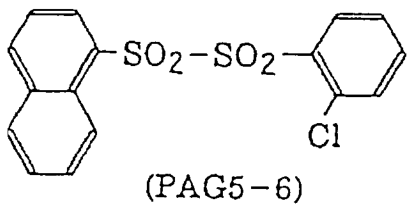

(PAG5−6)

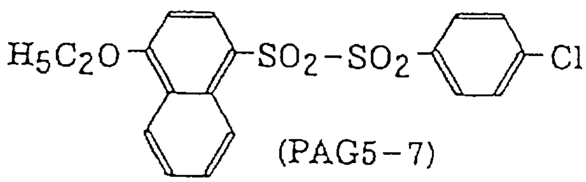

(PAG5−7)

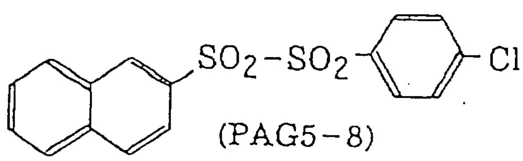

(PAG5−8)

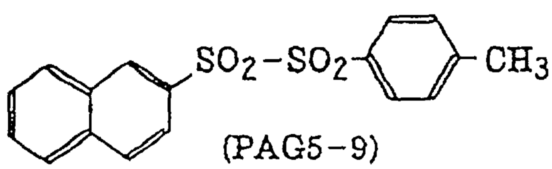

(PAG5−9)

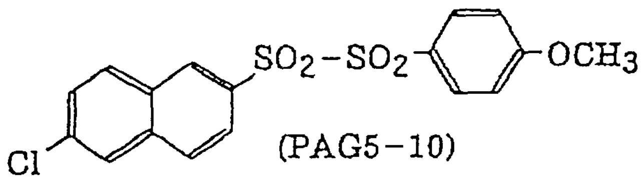

(PAG5-10)

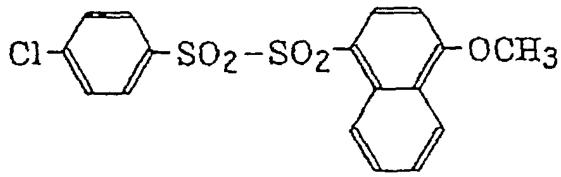

(PAG5-11)

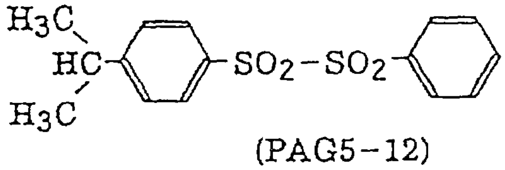

(PAG5-12)

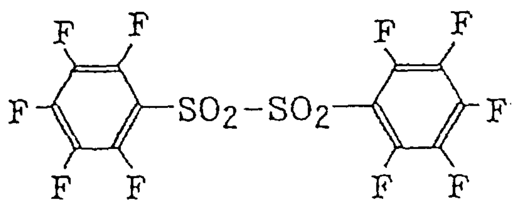

(PAG5-13)

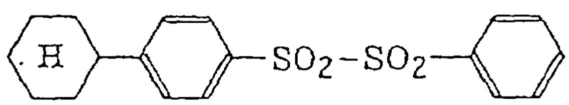

(PAG5-14)

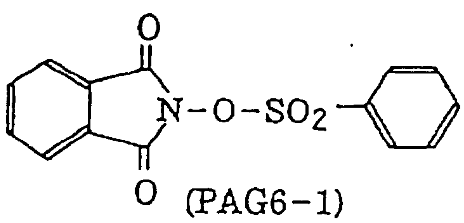

(PAG6-1)

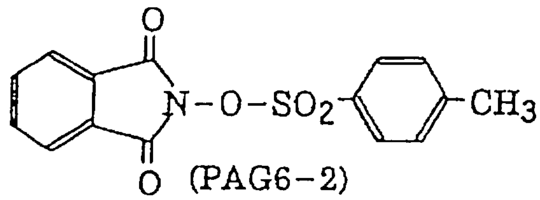

(PAG6-2)

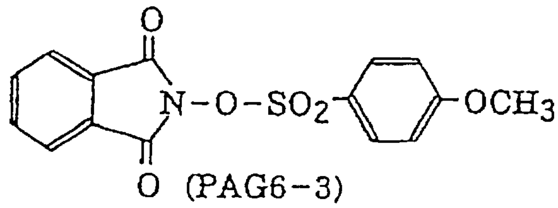

(PAG6-3)

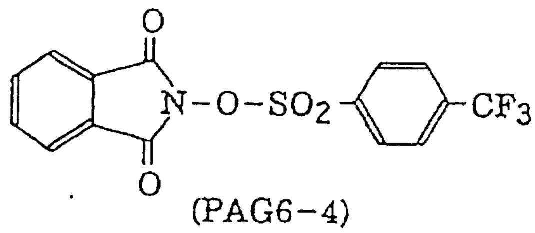

(PAG6-4)

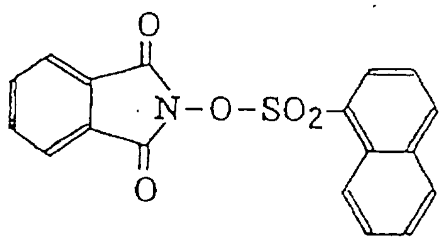

(PAG6-5)

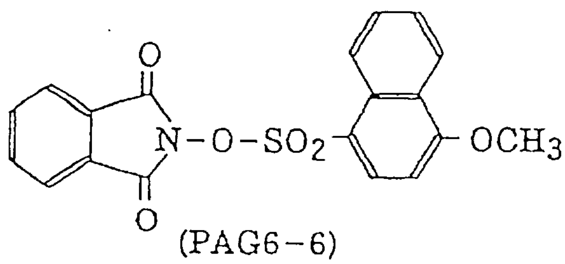

(PAG6-6)

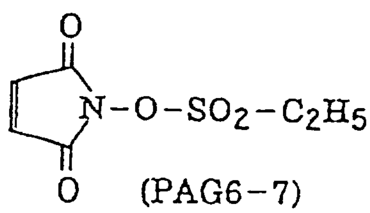

(PAG6-7)

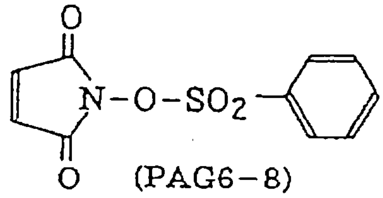

(PAG6-8)

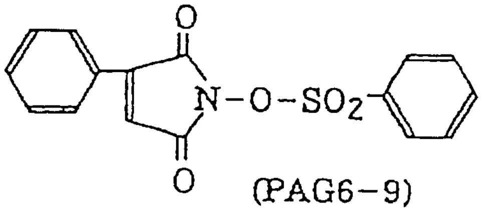

(PAG6-9)

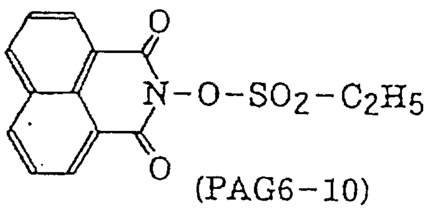

(PAG6-10)

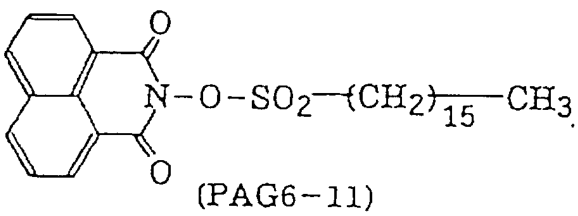

(PAG6-11)

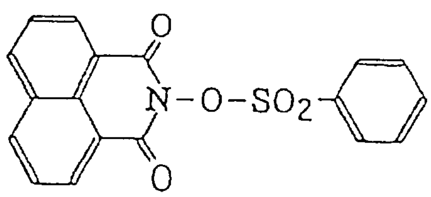

(PAG6-12)

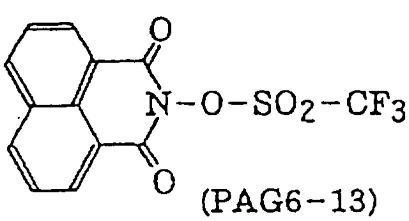

(PAG6-13)

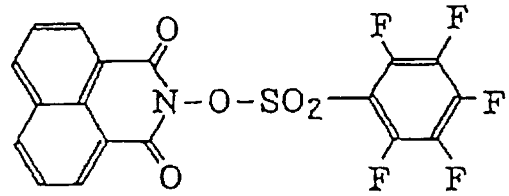

(PAG6-14)

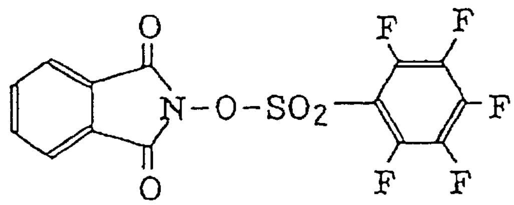

(PAG6-15)

The positive resist composition of the present invention preferably contains at least either one of (f) a resin having a group capable of decomposing by an acid, which increases in the solubility in an alkali developer under the action of an acid (hereinafter sometimes referred to as a "component (f)"), and (g) a low molecular dissolution-inhibiting compound having a molecular weight of 3,000 or less, which has a group capable of decomposing by an acid and increases in the solubility in an alkali developer under the action of an acid (hereinafter sometimes referred to as a "component (g)").

[III] (f)Resin having a group capable of decomposing by an acid, which increases in the solubility in an alkali developer under the action of an acid

The component (f) for use in the positive electron beam or X-ray resist composition of the present invention includes resins having on either one or both of the main chain and the side chain thereof a group capable of decomposing by an acid. Among these, resins having on the side chain thereof a group capable of decomposing by an acid are preferred.

The group capable of decomposing by an acid is preferably a $-COOA^0$ group or a $-O-B^0$ group, and examples of the group containing such a group include those represented by $-R^0-COOA^0$ and $-Ar-O-B^0$ (wherein $A^0$ represents a $-C(R^{01})(R^{02})(R^{03})$ group, a $-Si(R^{01})(R^{02})(R^{03})$ group or a $-C(R^{04})(R^{05})-O-R^{06}$ group, and $B^0$ represents $-CO-O-A^0$ group (wherein $R^0$, $R^{01}$ to $R^{06}$ and Ar have the same meanings as defined later)).

The acid-decomposing group is preferably a silyl ether group, a cumyl ester group, an acetal group, a tetrahydropyranyl ether group, an enol ether group, an enol ester group, a tertiary alkyl ether group, a tertiary alkyl ester group or a tertiary alkyl carbonate group, more preferably a tertiary alkyl ester group, a tertiary alkyl carbonate group, a cumyl ester group, an acetal group or a tetrahydropyranyl ether group.

In the case where the group capable of decomposing by an acid is bonded as a side chain, the matrix resin is an alkali-soluble resin having on the side chain thereof an -OH group or a -COOH group, preferably an $-R^0-COOH$ group or an -Ar-OH group. Examples thereof include alkali-soluble resins described later.

The alkali-soluble resin preferably has an alkali solubility rate of 170 A/sec or more, preferably 330 A/sec or more (A: angstrom), when measured with 0.261N tetramethylammonium hydroxide (TMAH) at 23°C.

From this standpoint, preferred examples of the alkali-soluble resin include o-, m- or p-poly(hydroxy-styrene) and a copolymer thereof, hydrogenated poly(hydroxystyrene), halogen- or alkyl-substituted poly(hydroxystyrene), a partially O-alkylated or O-acylated product of poly(hydroxystyrene), a styrene-hydroxystyrene copolymer, an α-methylstyrene-hydroxystyrene copolymer, and hydrogenated novolak resin.

The component (f) for use in the present invention can be obtained by reacting a precursor of an acid-decomposing group with an alkali-soluble resin or by copolymerizing an alkali-soluble resin monomer having bonded thereto an acid-decomposing group with a monomer of variety, as disclosed in European Patent 254,853, JP-A-2-25850, JP-A-3-223860 and JP-A-4-251259.

Specific examples of the component (f) for use in the present invention are set forth below, however, the present invention is not limited thereto.

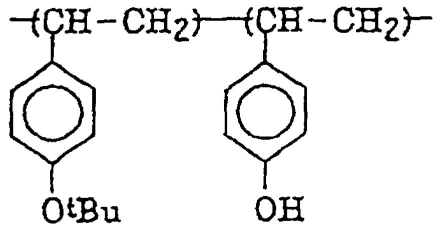

(c-1)

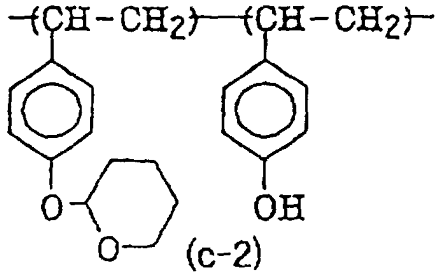

(c-2)

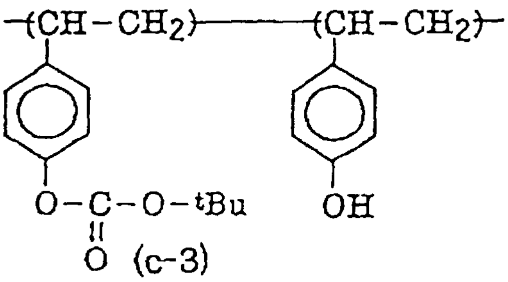

(c-3)

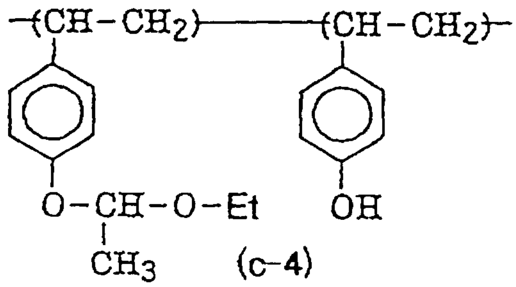

(c-4)

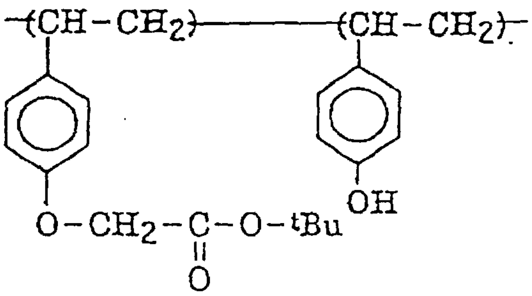

(c-5)

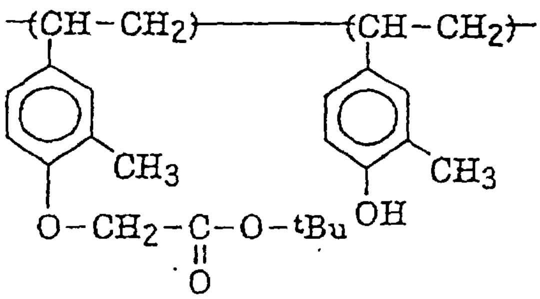

(c-6)

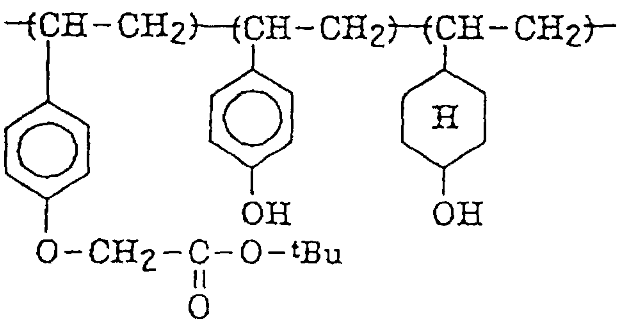

(c-7)

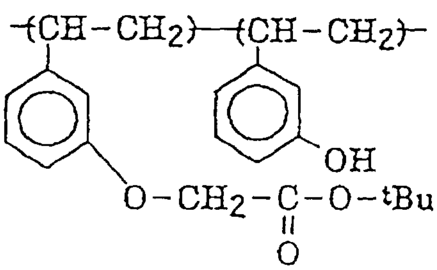

(c-8)

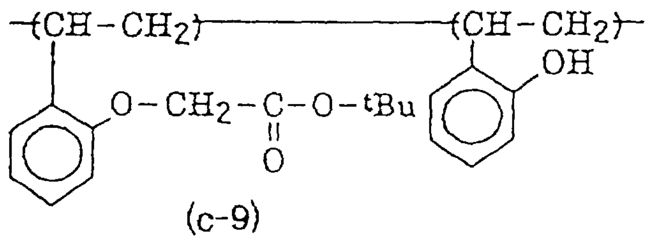

(c-9)

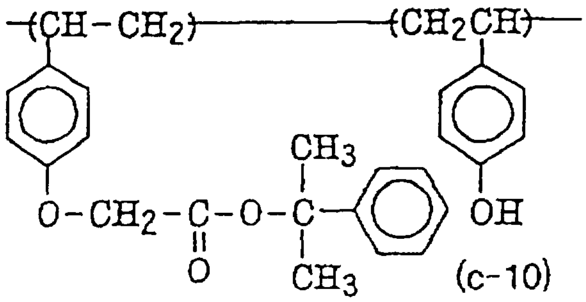

(c-10)

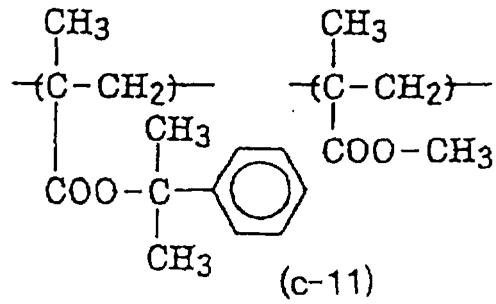

(c-11)

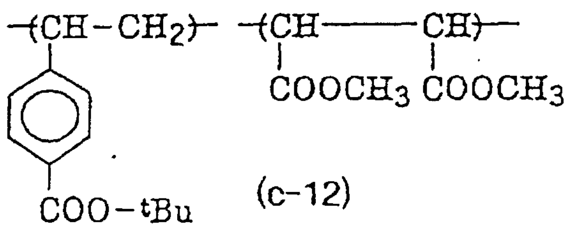

(c-12)

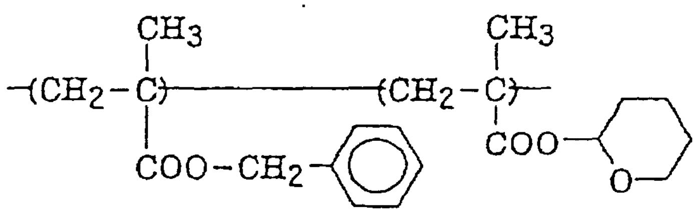

(c-13)

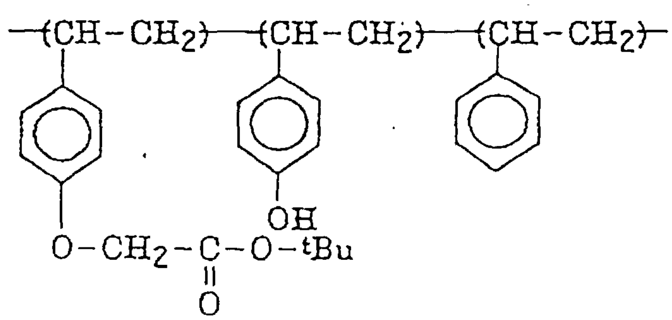

(c-14)

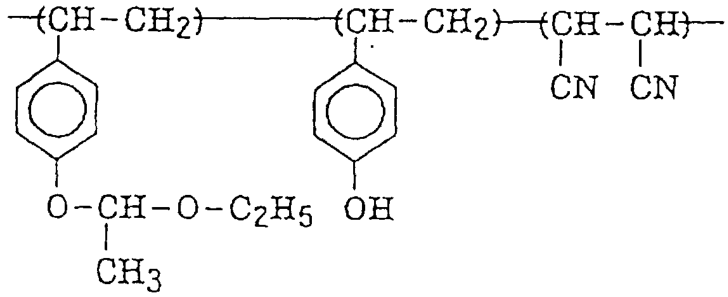

(c-15)

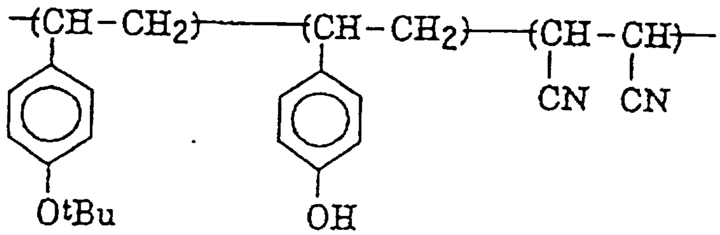

(c-16)

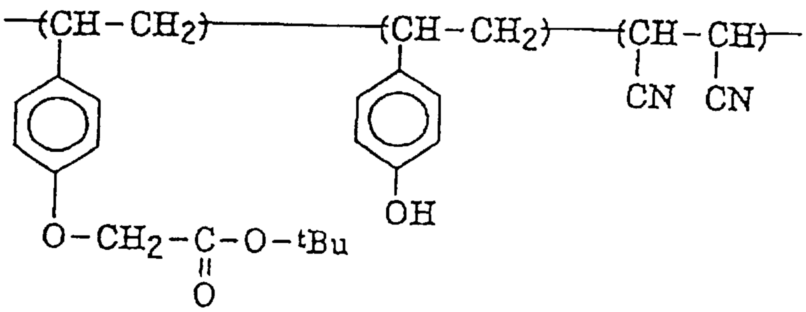

(c-17)

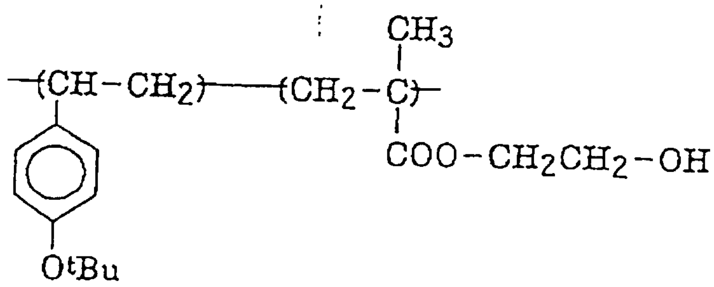

(c-18)

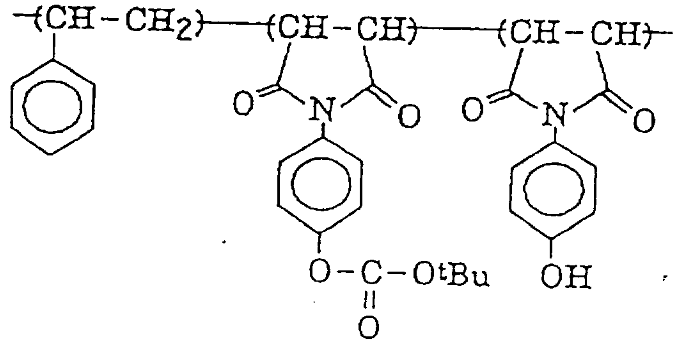

(c-19)

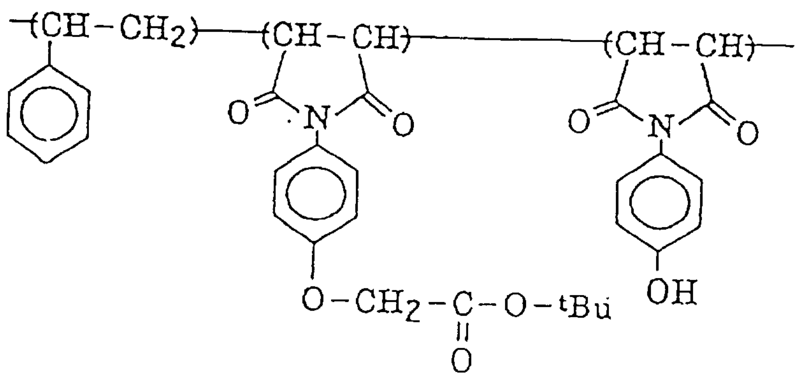

(c-20)

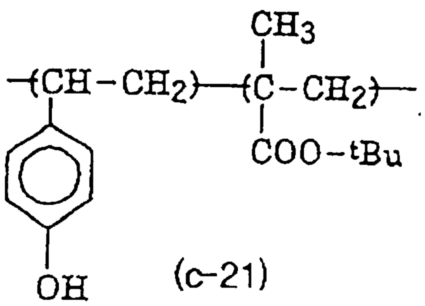

(c-21)

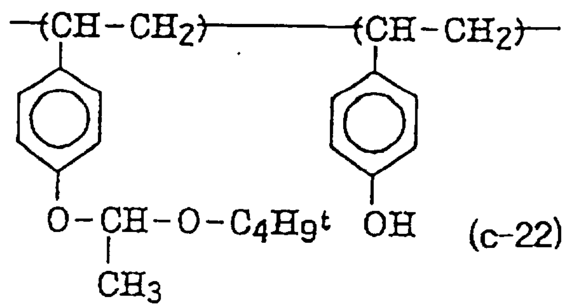

(c-22)

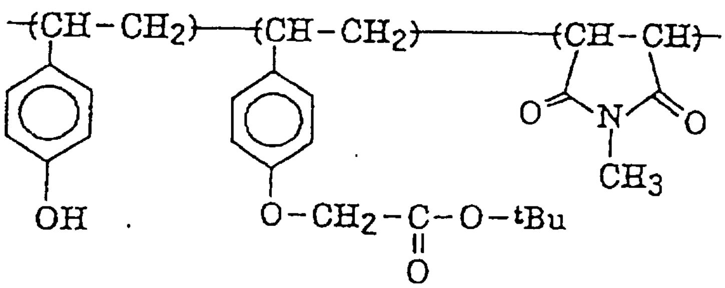

(c-23)

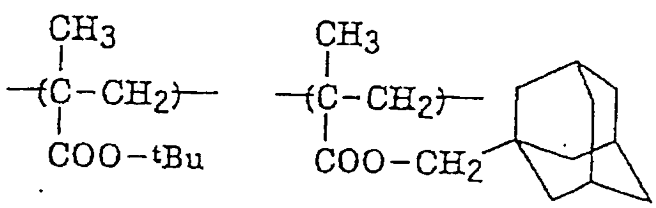

(c-24)

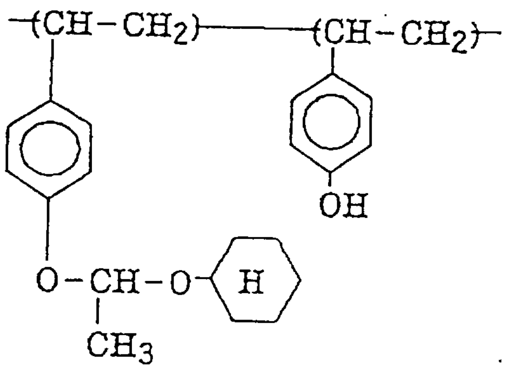

(c-25)

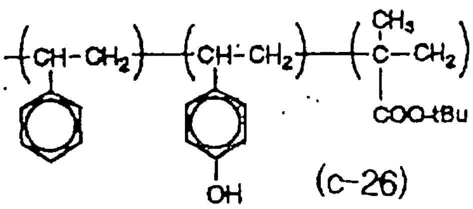

(c-26)

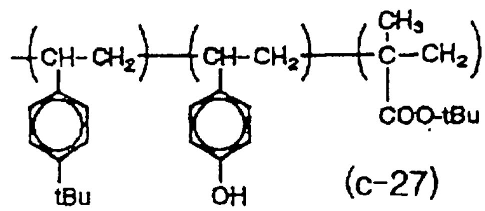

(c-27)

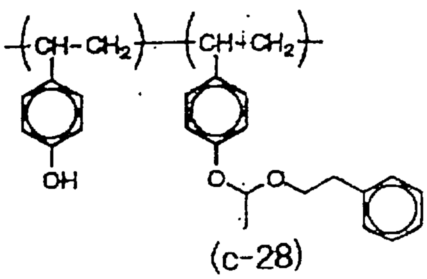

(c-28)

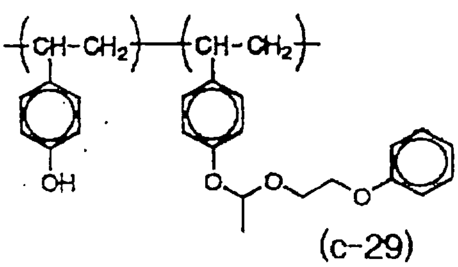

(c-29)

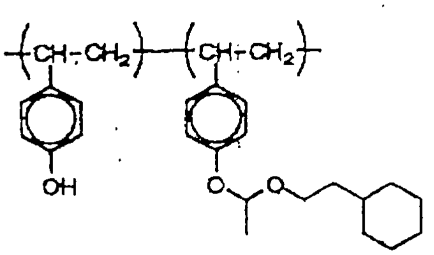

(c-30)

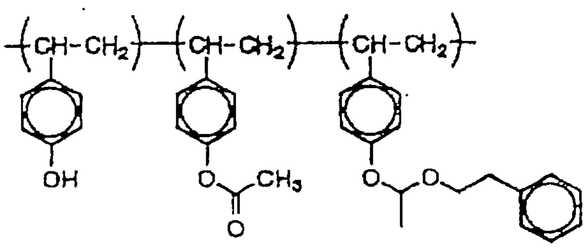

(c-31)

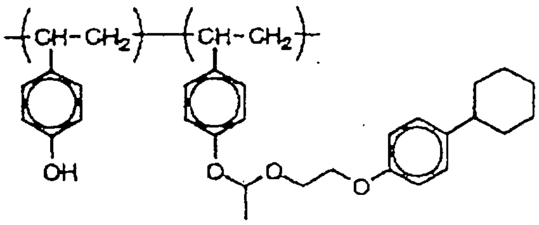

(c-32)

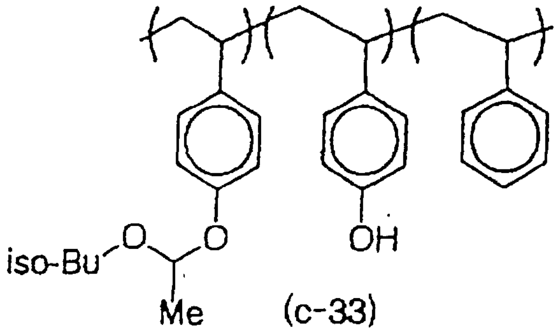

(c-33)

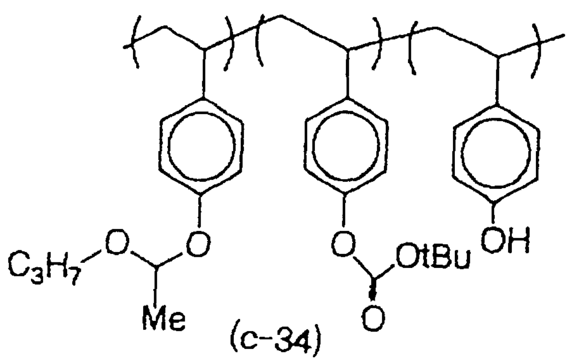

(c-34)

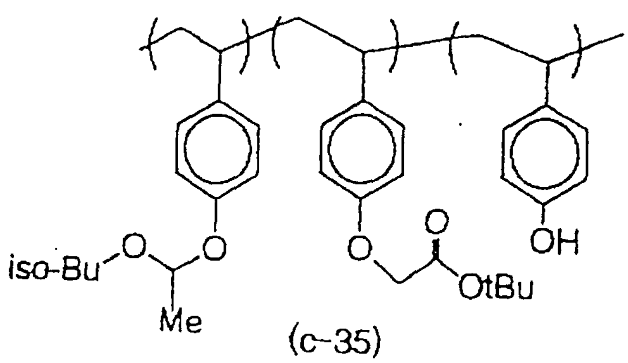

(c-35)

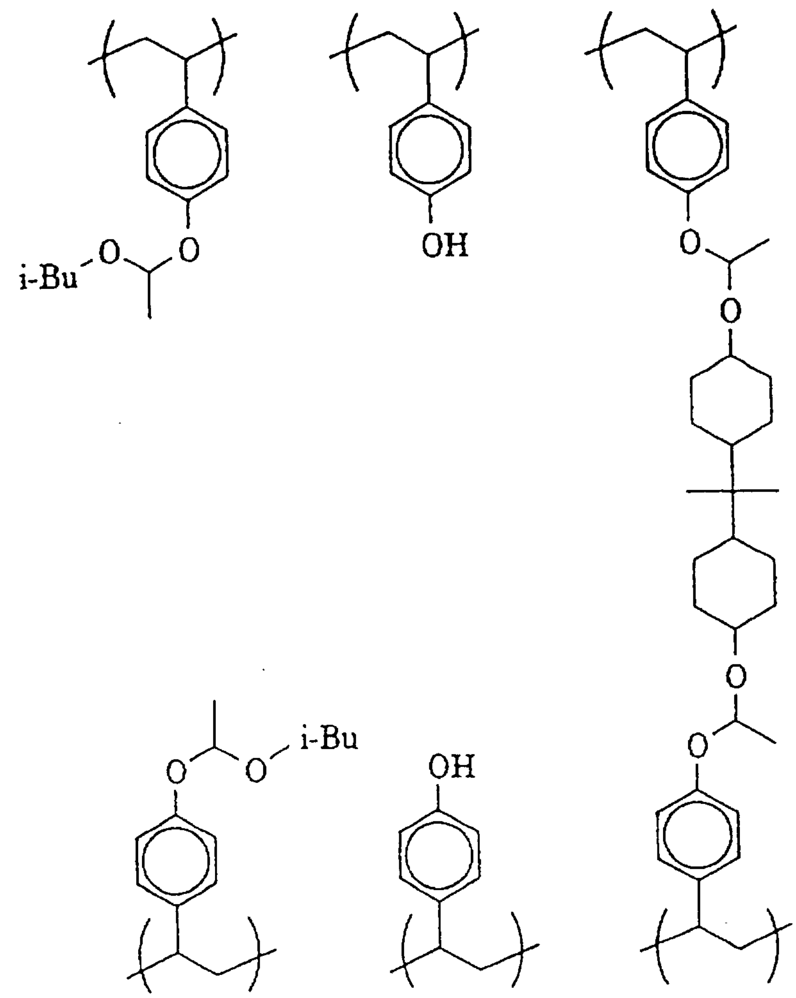

(c-36)

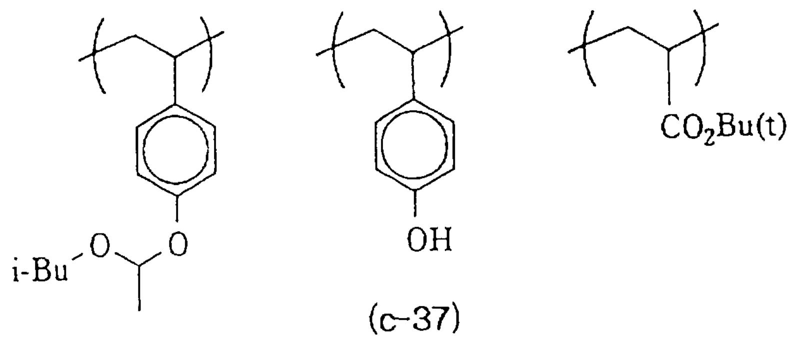

(c-37)

The content of the acid-decomposing group can be expressed by B/(B+S) using the number (B) of groups capable of decomposing by an acid in the resin and the number (S) of alkali-soluble groups not protected by an acid-decomposing group. The content is preferably from 0.01 to 0.7, more preferably from 0.05 to 0.50, still more preferably from 0.05 to 0.40. If B/(B+S) exceeds 0.7, this disadvantageously causes film shrinkage after PEB, adhesion failure to the substrate or scumming, whereas if B/(B+S) is less than 0.01, a standing wave seriously remains on the side wall of pattern and this is not preferred.

The weight average molecular weight (Mw) of the component (f) is preferably from 2,000 to 200,000. If the weight average molecular weight is less than 2,000, the unexposed area undergoes large layer loss by the development, whereas if it exceeds 200,000, the alkali-soluble resin itself decreases in the dissolution rate in an alkali and the sensitivity lowers. The weight average molecular weight is more preferably from 5,000 to 100,000, still more preferably from 8,000 to 50,000.

The molecular weight distribution (Mw/Mn) is preferably from 1.0 to 4.0, more preferably from 1.0 to 2.0, still more preferably from 1.0 to 1.6, and as the degree of dispersion is smaller, the heat resistance and the image forming property (for example, pattern profile) are better.

The weight average molecular weight as used herein is defined as a value calculated in terms of polystyrene by gel permeation chromatography.

The components (f) may be used in combination of two or more thereof.

[IV]Low molecular acid-decomposing dissolution-inhibiting compound (component (g))

In the present invention, a component (g) may be used. The component (g) is a low molecular acid-decomposing dissolution-inhibiting compound having a molecular weight of 3,000 or less, which has a group capable of decomposing by an acid and increases in the solubility in an alkali developer under the action of an acid.

The component (g) blended in the composition of the present invention is preferably a compound having at least two acid-decomposing groups in the structure thereof, where adjacent acid-decomposing groups are separated from each other, at the remotest site, via at least 8 bonding atoms excluding the acid-decomposing groups.

The component (g) is more preferably a compound having at least two acid-decomposing groups in the structure thereof, where adjacent acid-decomposing groups are separated from each other, at the remotest site, via at least 10, preferably at least 11, more preferably at least 12 bonding atoms excluding the acid-decomposing groups, or a compound having at least three acid-decomposing groups, where adjacent acid-decomposing groups are separated from each other, at the remotest site, via at least 9, preferably at least 10, more preferably at least 11 bonding atoms excluding the acid-decomposing groups. The upper limit of the number of bonding atoms is preferably 50, more preferably 30.

In the case where the acid-decomposing dissolution-inhibiting compound as the component (g) has three or more, preferably four or more acid-decomposing groups, or even when the compound has two acid-decomposable groups, insofar as the adjacent acid-decomposing groups are separated from each other via a certain distance or more, the ability to inhibit the solubility of the alkali-soluble resins is extremely enhanced.

The distance between adjacent acid-decomposing groups is shown by the number of bonding atoms interposed therebetween, excluding the acid-decomposing groups. For example, in each of the following compounds (1) and (2), the distance is 4 bonding atoms and in the following compound (3), the distance is 12 bonding atoms.

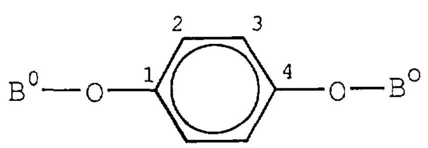

(1)

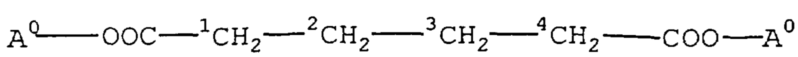

(2)

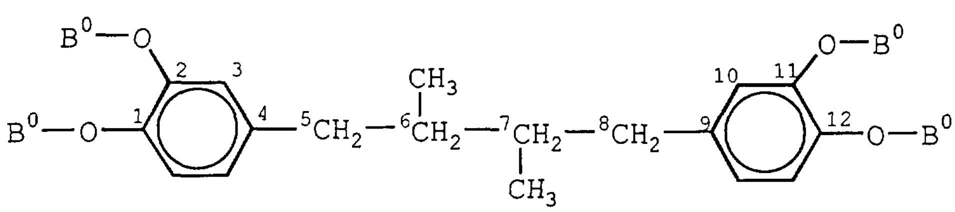

(3)

-COO-$A^0$, -O-$B^0$; acid-decomposing group

The acid-decomposing dissolution-inhibiting compounds as the component (g) may have a plurality of acid-decomposing groups on one benzene ring, however, a compound constructed by a skeleton having one acid-decomposing group on one benzene ring is preferred. The molecular weight of the acid-decomposing dissolution-inhibiting compound for use in the present invention is 3,000 or less, preferably from 300 to 3,000, more preferably from 500 to 2,500.

In a preferred embodiment of the present invention, the group containing a group capable of decomposing by an acid, namely, a -COO-$A^0$ or -O-$B^0$ includes a group represented by -$R^0$-COO-$A^0$ or -Ar-O-$B^0$, wherein $A^0$ represents -C($R^{01}$) ($R^{02}$) ($R^{03}$), -Si($R^{01}$) ($R^{02}$) ($R^{03}$) or -C($R^{04}$) ($R^{05}$) -O-$R^{06}$ and $B^0$ represents $A^0$ or -CO-O-$A^0$.

$R^{01}$, $R^{02}$, $R^{03}$, $R^{04}$ and $R^{05}$, which may be the same or different, each represents a hydrogen atom, an alkyl group, a cycloalkyl group, an alkenyl group or an aryl group, $R^{06}$ represents an alkyl group or an aryl group, provided that at least two of $R^{01}$ to $R^{03}$ are a group than a hydrogen atom and that two of respective groups $R^{01}$ to $R^{03}$, and $R^{04}$ to $R^{06}$ may combine to form a ring, $R^0$ represents a divalent or greater valent aliphatic or aromatic hydrocarbon group which may have a substituent, and -Ar- represents a monocyclic or polycyclic, divalent or greater valent aromatic group.

The alkyl group here is preferably an alkyl group having from 1 to 4 carbon atoms, such as methyl group, ethyl group, propyl group, n-butyl group, sec-butyl group and tert-butyl group, the cycloalkyl group is preferably a cycloalkyl group having from 3 to 10 carbon atoms, such as cyclopropyl group, cyclobutyl group, cyclohexyl group and adamantyl group, the alkenyl group is preferably an alkenyl group having from 2 to 4 carbon atoms, such as vinyl group, propenyl group, allyl group and butenyl group, the aryl group is preferably an aryl group having from 6 to 14 carbon atoms, such as phenyl group, xylyl group, toluyl group, cumenyl group, naphthyl group and anthracenyl group.

Examples of the substituent include a hydroxyl group, a halogen atom (e.g., fluorine, chlorine, bromine, iodine), a nitro group, a cyano group, the above-described alkyl group, an alkoxy group (e.g., methoxy, ethoxy, hydroxyethoxy, propoxy, hydroxypropoxy, n-butoxy, isobutoxy, sec-butoxy, tert-butoxy), an alkoxycarbonyl group (e.g., methoxycarbonyl, ethoxycarbonyl), an aralkyl group (e.g., benzyl, phenethyl, cumyl), an aralkyloxy group, an acyl group (e.g., formyl, acetyl, butyryl, benzoyl, cyanamyl, valeryl), an acyloxy group (e.g., butyryloxy), the above-described alkenyl group, an alkenyloxy group (e.g., vinyloxy, propenyloxy, allyloxy, butenyloxy), the above-described aryl group, an aryloxy group (e.g., phenoxy), and an aryloxycarbonyl group (e.g., benzoyloxy).

Among these, preferred are a silyl ether group, a cumyl ester group, an acetal group, a tetrahydropyranyl ether group, an enol ether group, an enol ester group, a tertiary alkyl ether group, a tertiary alkyl ester group and a tertiary alkylcarbonate group, and more preferred are a tertiary alkyl ester group, a tertiary alkylcarbonate group, a cumyl ester group and a tetrahydropyranyl ether group.

Preferred examples of the component (g) include compounds where a part or all of phenolic OH groups of a polyhydroxy compound is bonded and thereby protected by a group described above, a $-R^0-COO-A^0$ group or a $B^0$ group, and these compounds are described in JP-A-1-289946, JP-A-1-289947, JP-A-2-2560, JP-A-3-128959, JP-A-3-158855, JP-A-3-179353, JP-A-3-191351, JP-A-3-200251, JP-A-3-200252, JP-A-3-200253, JP-A-3-200254, JP-A-3-200255, JP-A-3-259149, JP-A-3-279958, JP-A-3-279959, JP-A-4-1650, JP-A-4-1651, JP-A-4-11260, JP-A-4-12356, JP-A-4-12357 and Japanese Patent Application Nos. 3-33229, 3-230790, 3-320438, 4-25157, 4-52732, 4-103215, 4-104542, 4-107885, 4-107889 and 4-152195.

Among these compounds, preferred are those using a polyhydroxy compound described in JP-A-1-289946, JP-A-3-128959, JP-A-3-158855, JP-A-3-179353, JP-A-3-200251, JP-A-3-200252, JP-A-3-200255, JP-A-3-259149, JP-A-3-279958, JP-A-4-1650, JP-A-4-11260, JP-A-4-12356, JP-A-4-12357 and Japanese Patent Application Nos. 4-25157, 4-103215, 4-104542, 4-107885, 4-107889 and 4-152195.

More specifically, the compounds represented by the following formulae [I] to [XVI] may be used.

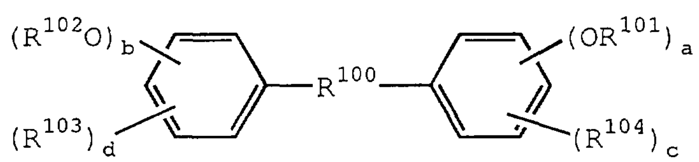

[I]

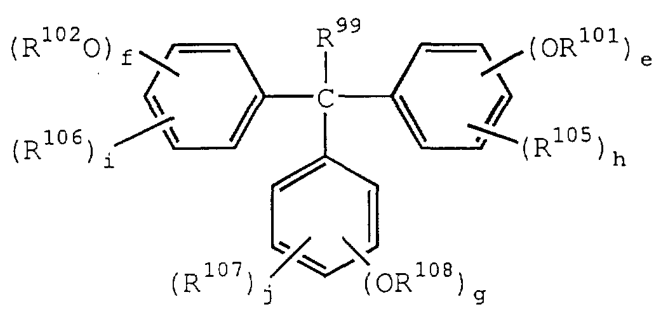

[II]

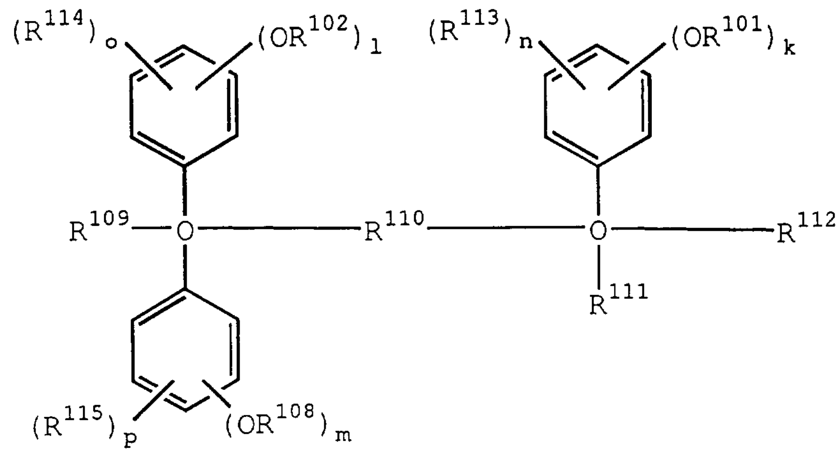

[III]

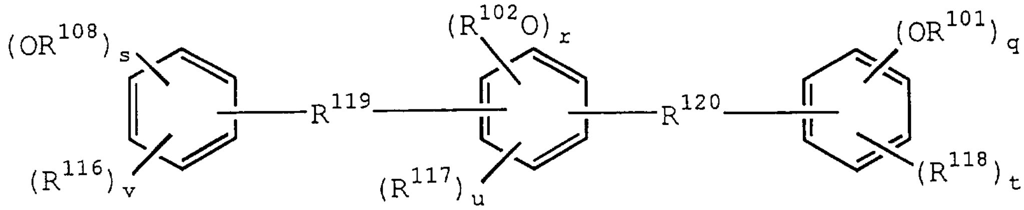

[IV]

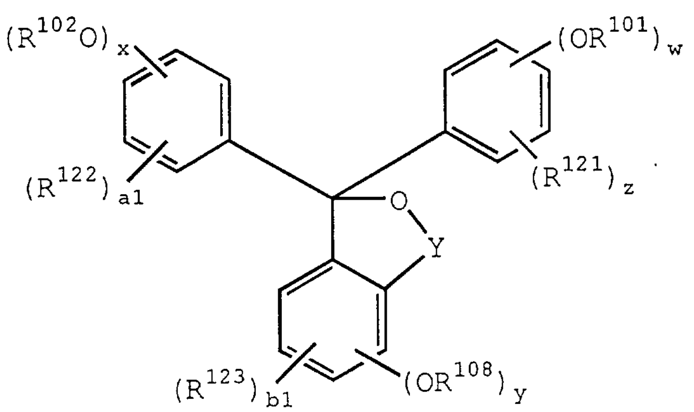

[V]

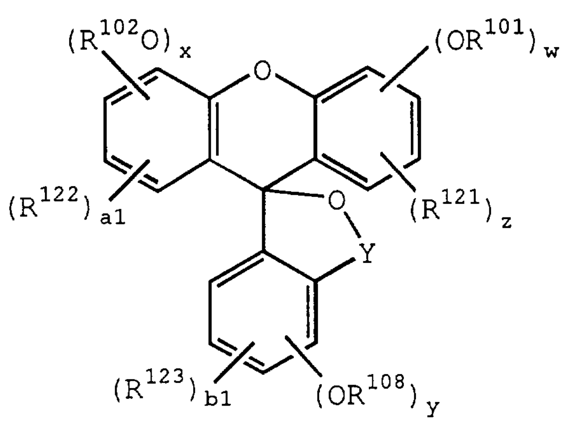

[VI]

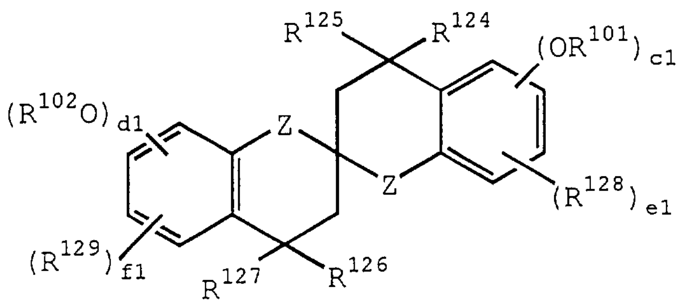

[VII]

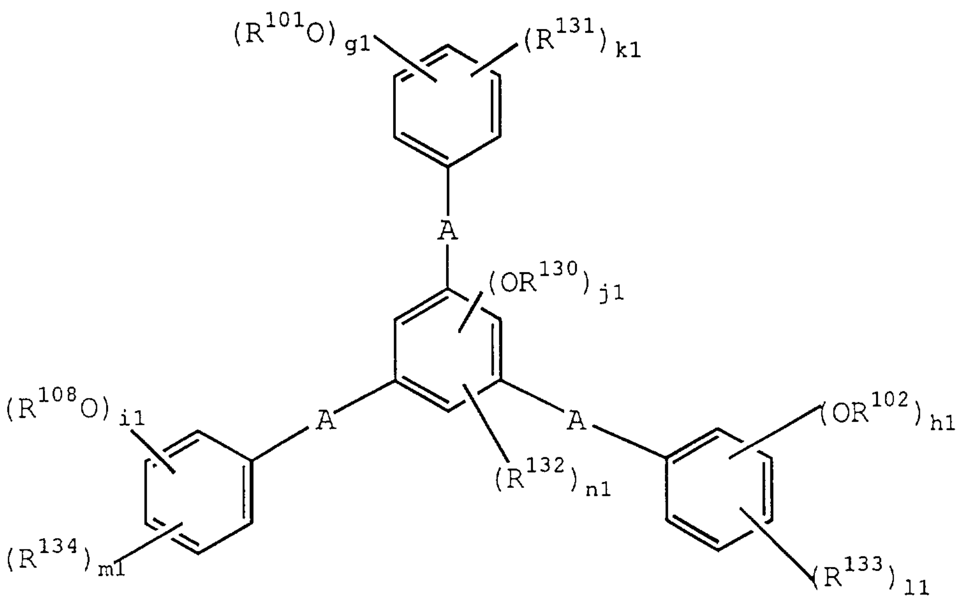

[VIII]

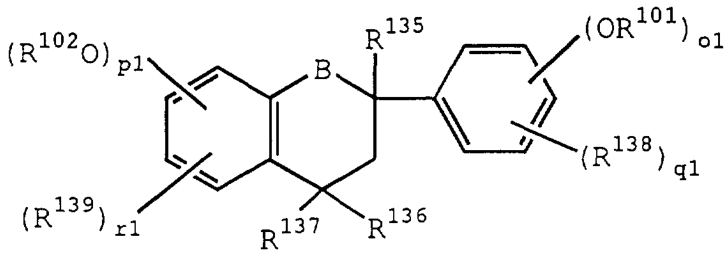

[IX]

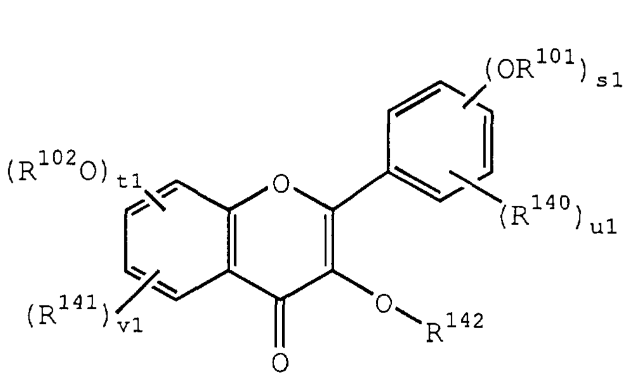

[X]

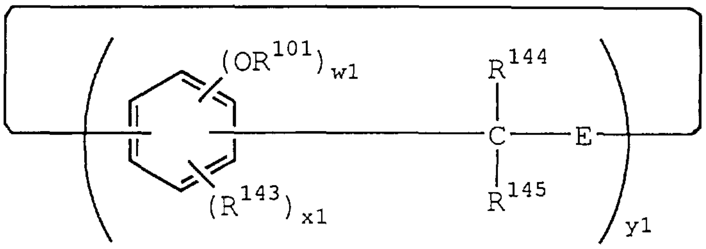

[XI]

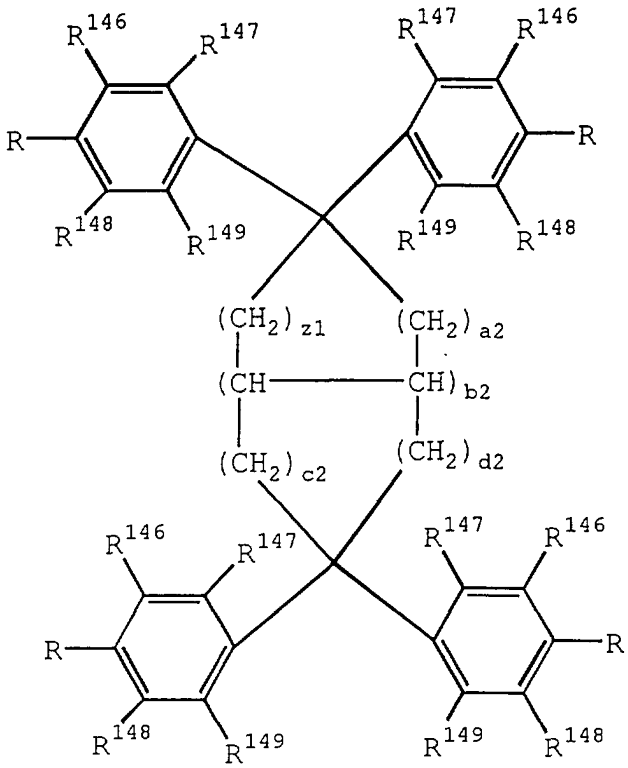

[XII]

wherein $R^{101}$, $R^{102}$, $R^{108}$ and $R^{130}$, which may be the same or different, each represents a hydrogen atom or $-R^0$-COO-C ($R^{01}$) ($R^{02}$) ($R^{03}$) or -CO-O-C($R^{01}$) ($R^{02}$) ($R^{03}$) (wherein $R^0$, $R^{01}$, $R^{02}$ and $R^{03}$ have the same meanings as defined above);

$R^{100}$ represents -CO-, -COO-, -NHCONH-, -NHCOO-, -O-, -S-, -SO-, $-SO_2-$, $-SO_3-$ or

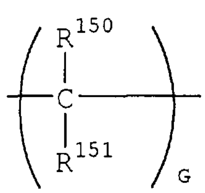

(wherein G is 2 to 6, provided that when G is 2, at least one of $R^{150}$ and $R^{151}$ is an alkyl group, and $R^{150}$ and $R^{151}$, which may be the same or different, each represents a hydrogen atom, an alkyl group, an alkoxy group, -OH, -COOH, -CN, a halogen atom, $-R^{152}$-COOR$^{153}$ or $-R^{154}$-OH);

$R^{152}$ and $R^{154}$ each represents an alkylene group;

$R^{153}$ represents a hydrogen atom, an alkyl group, an aryl group or an aralkyl group;

$R^{99}$, $R^{103}$ to $R^{107}$, $R^{109}$, $R^{111}$ to $R^{118}$, $R^{121}$ to $R^{123}$, $R^{128}$ to $R^{129}$, $R^{131}$ to $R^{134}$, $R^{138}$ to $R^{141}$, and $R^{143}$, which may

be the same or different, each represents a hydrogen atom, a hydroxyl group, an alkyl group, an alkoxy group, an acyl group, an acyloxy group, an aryl group, an aryloxy group, an aralkyl group, an aralkyloxy group, a halogen atom, a nitro group, a carboxyl group, a cyano group or -N($R^{155}$)($R^{156}$) (wherein $R^{155}$ and $R^{156}$ each represents H, an alkyl group or an aryl group);
$R^{110}$ represents a single bond, an alkylene group or

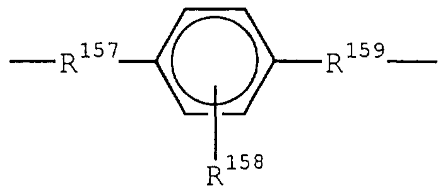

(wherein $R^{157}$ and $R^{159}$, which may be the same or different, each represents a single bond, an alkylene group, -O-, -S-, -CO- or a carboxyl group, and $R^{158}$ represents a hydrogen atom, an alkyl group, an alkoxy group, an acyl group, an acyloxy group, an aryl group, a nitro group, a hydroxy group, a cyano group or a carboxyl group, provided that the hydroxy group may be replaced by an acid-decomposing group (e.g., tert-butoxycarbonylmethyl group, tetrahydropyranyl group, 1-ethoxy-1-ethyl group, 1-tert-butoxy-1-ethyl group);
$R^{119}$ and $R^{120}$, which may be the same or different, each represents a methylene group, a lower alkyl-substituted methylene group, a halomethylene group or a haloalkyl group, provided that the lower alkyl group as used in the present invention means an alkyl group having from 1 to 4 carbon atoms;
$R^{124}$ to $R^{127}$, which may be the same or different, each represents a hydrogen atom or an alkyl group;
$R^{135}$ to $R^{137}$, which may be the same or different, each represents a hydrogen atom, an alkyl group, an alkoxy group, an acyl group or an acyloxy group;
$R^{142}$ is a hydrogen atom, -$R^0$-COO-C ($R^{01}$) ($R^{02}$) ($R^{03}$), -CO-O-C($R^{01}$) ($R^{02}$) ($R^{03}$) or

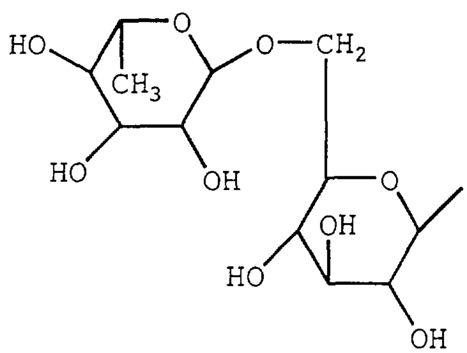

bonded to -O-;

$R^{144}$ and $R^{145}$, which may be the same or different, each represents a hydrogen atom, a lower alkyl group, a lower haloalkyl group or an aryl group;
$R^{146}$ to $R^{149}$, which may be the same or different, each represents a hydrogen atom, a hydroxyl group, a halogen atom, a nitro group, a cyano group, a carbonyl group, an alkyl group, an alkoxy group, an alkoxycarbonyl group, an aralkyl group, an aralkyloxy group, an acyl group, an acyloxy group, an alkenyl group, an alkenyloxy group, an aryl group, an aryloxy group or an aryloxycarbonyl group, provided that four substituents under the same symbol may not be the same;
Y represents -CO- or -$SO_2$-;
Z and B each represents a single bond or -O-;
A represents a methylene group, a lower alkyl-substituted methylene group, a halomethylene group or a haloalkyl group;
E represents a single bond or an oxymethylene group;
when a to z and a1 to y1 each represents a plural number, the group in the parenthesis may be the same or different;
a to q, s, t, v, g1 to i1, k1 to m1, o1, q1, s1 and u1 each represents 0 or an integer of 1 to 5;
r, u, w, x, y, z, a1 to f1, p1, r1, t1, v1 to x1 each represents 0 or an integer of 1 to 4;
j1 n1, z1, a2, b2, c2 and d2 each represents 0 or an integer of 1 to 3,
provided that at least one of z1, a2, c2 and d2 is 1 or more;

y1 is an integer of 3 to 8;
(a+b), (e+f+g), (k+l+m), (q+r+s), (w+x+y), (c1+d1), (g1+h1+i1+j1), (o1+p1) and (s1+t1) ≥ 2;
(j1+n1) ≤ 3;
(r+u), (w+z), (x+a1), (y+b1), (c1+e1), (d1+f1), (p1+r1), (t1+v1) and (x1+w1) ≤ 4, provided that in the case of formula [V], (w+z) and (x+a1) ≤ 5; and
(a+c), (b+d), (e+h), (f+i), (g+j), (k+n), (l+o), (m+p), (q+t), (s+v), (g1+k1), (h1+l1), (i1+m1), (o1+g1) and (s1+u1) ≤ 5.

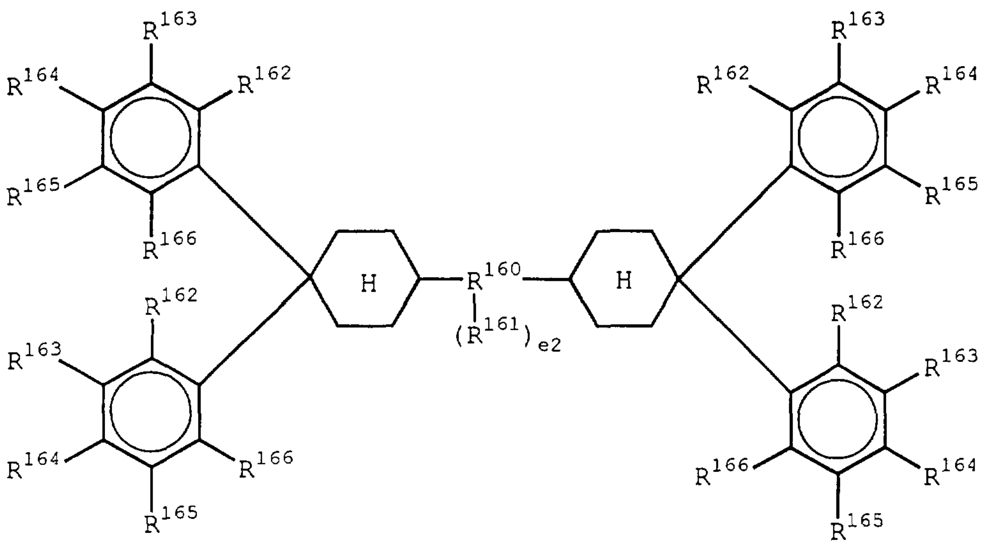

(XIII)

wherein $R^{160}$ represents an organic group, a single bond, -S-, -SO- or

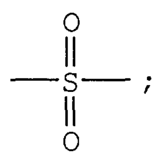

$R^{161}$ represents a hydrogen atom, a monovalent organic group or

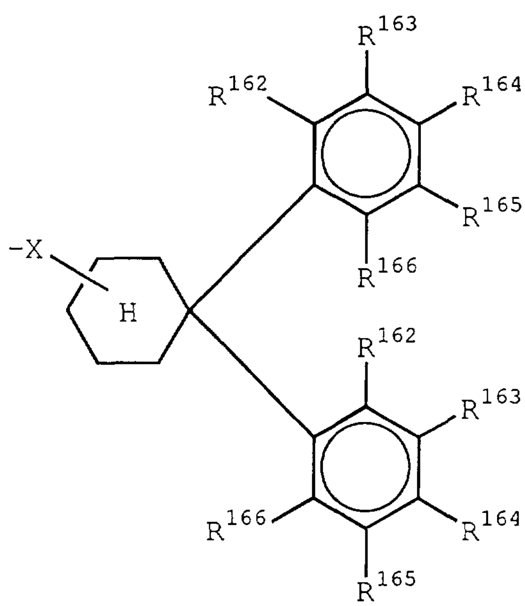

(wherein $R^{162}$ to $R^{166}$, which may be the same or different, each represents a hydrogen atom, a hydroxy group, a halogen atom, an alkyl group, an alkoxy group, an alkenyl group, -O-$R^0$-COO-C($R^{01}$) ($R^{02}$) ($R^{03}$) or -O-CO-O-C ($R^{01}$) ($R^{02}$) ($R^{03}$), provided at least two of $R^{162}$ to $R^{166}$ are -O-$R^0$-COO-C($R^{01}$) ($R^{02}$) ($R^{03}$) or -O-CO-O-C($R^{01}$) ($R^{02}$) ($R^{03}$) and that four or six substituents under the same symbol may not be the same group;
X is a divalent organic group; and
e2 is 0 or 1.

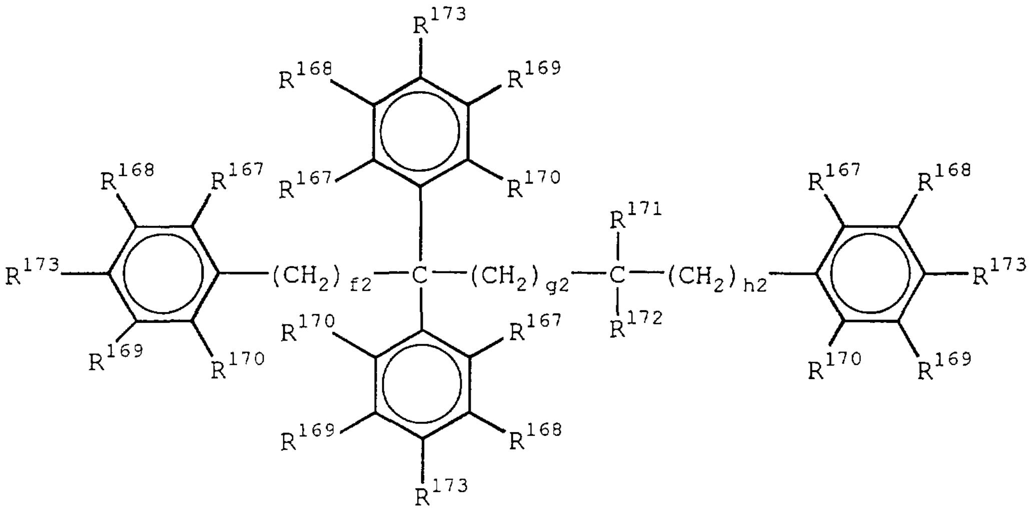 (XIV)

wherein $R^{167}$ to $R^{170}$, which may be the same or different, each represents a hydrogen atom, a hydroxy group, a halogen atom, an alkyl group, an alkoxy group or an alkenyl group, provided that four, five or six substituents under the same symbol may not be the same group;
$R^{171}$ and $R^{172}$ each represents a hydrogen atom, an alkyl group or

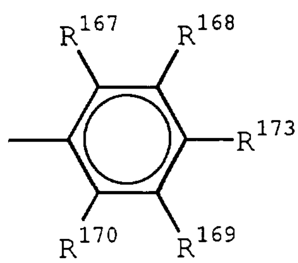

at least two of $R^{173}$ are -O-$R^0$-COO-($R^{01}$) ($R^{02}$) ($R^{03}$) - or -O-CO-O-C($R^{01}$) ($R^{02}$) ($R^{03}$) and the remaining is a hydroxy group;
f2 and h2 each represents 0 or 1; and
g2 represents 0 or an integer of 1 to 4.

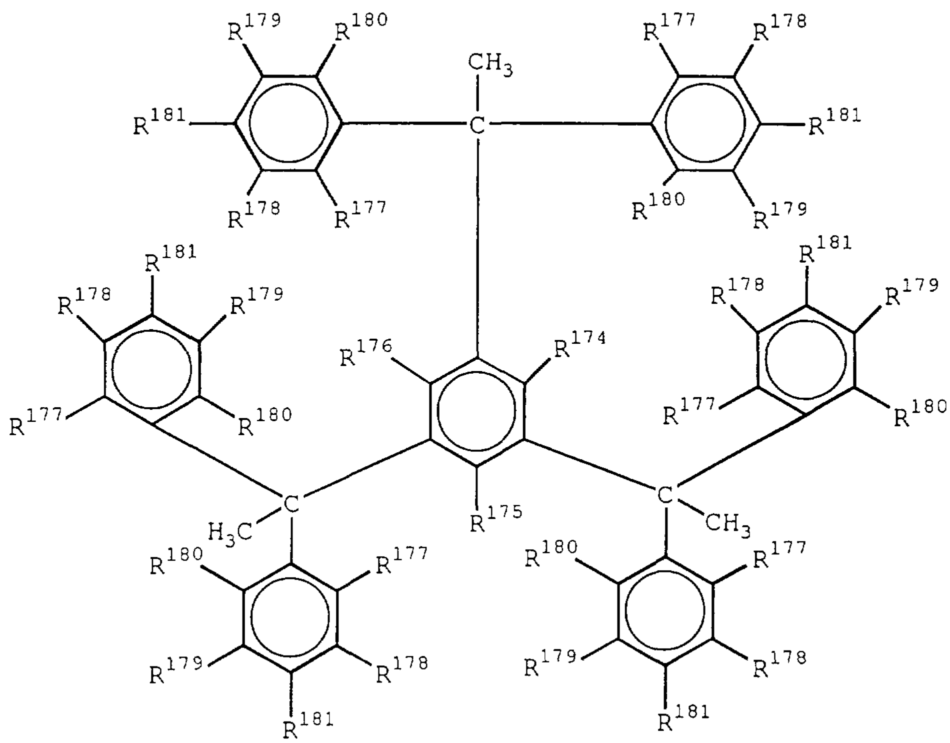

(XV)

$R^{174}$ to $R^{180}$, which may be the same or different, each represents a hydrogen atom, a hydroxy group, a halogen atom, an alkyl group, an alkoxy group, a nitro group, an alkenyl group, an aryl group, an aralkyl group, an alkoxycarbonyl group, an arylcarbonyl group, an acyloxy group, an acyl group, an aralkyloxy group or an aryloxy group, provided that six substituents under the same symbol may not be the same group; and
at least two of $R^{181}$ are -O-$R^0$-COO-C($R^{01}$) ($R^{02}$) ($R^{03}$) or -O-CO-O-C($R^{01}$) ($R^{02}$) ($R^{03}$) and the remaining is a hydroxy group.

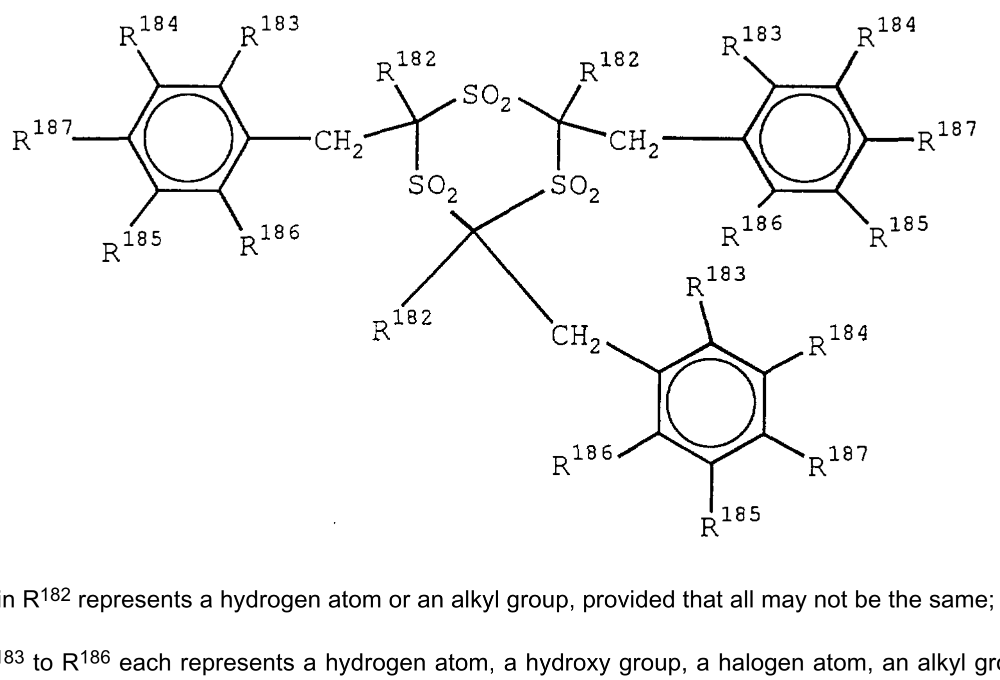

(XVI)

wherein $R^{182}$ represents a hydrogen atom or an alkyl group, provided that all may not be the same;

$R^{183}$ to $R^{186}$ each represents a hydrogen atom, a hydroxy group, a halogen atom, an alkyl group or an alkoxy group, provided that three substituents under the same symbol may not be the same group; and
at least two of $R^{187}$ are -O-$R^0$-COO-C($R^{01}$) ($R^{02}$) ($R^{03}$) or -O-CO-O-C($R^{01}$) ($R^{02}$) ($R^{03}$) and the remaining is a hydroxy group.

Specific examples of preferred compound skeletons are set forth below.

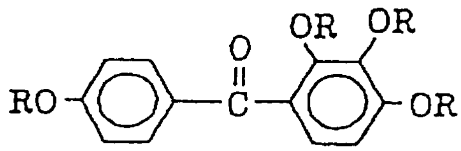

(1)

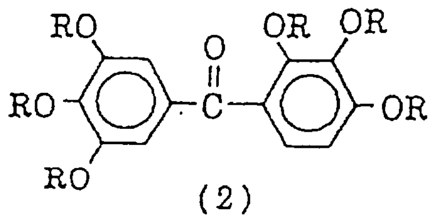

(2)

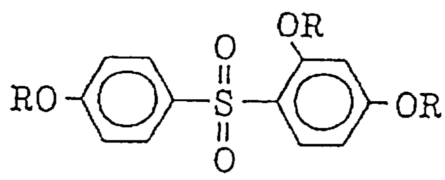

(3)

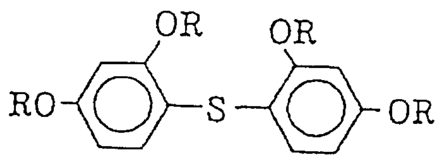

(4)

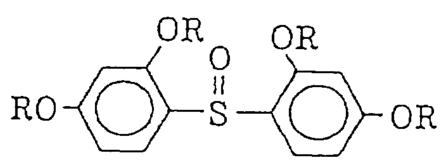

(5)

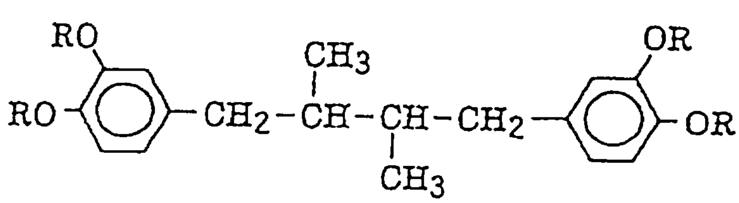

(6)

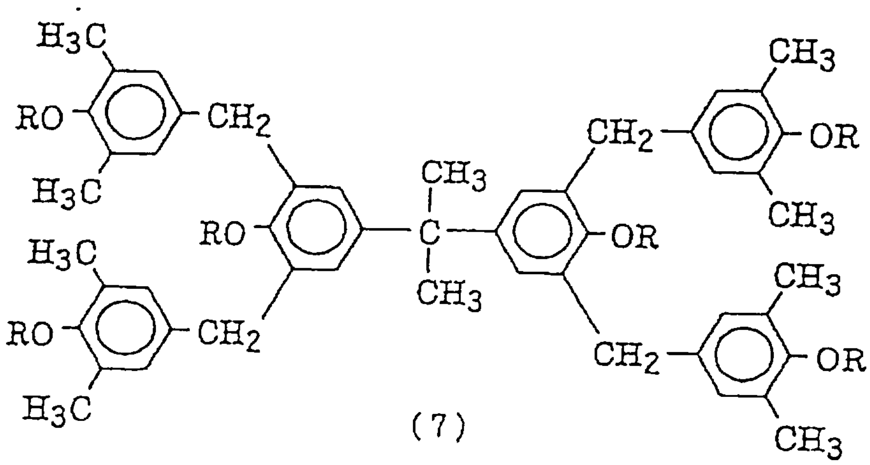

(7)

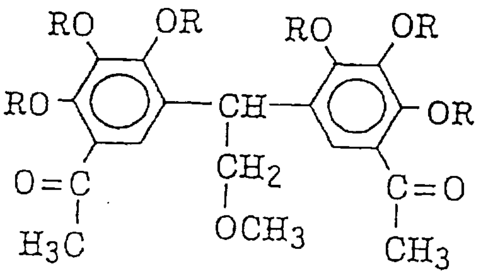

(8)

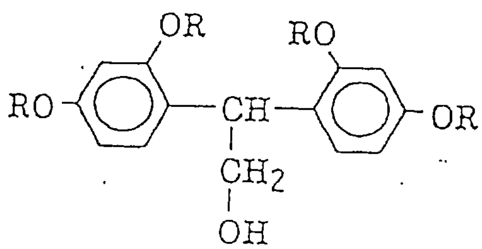

(9)

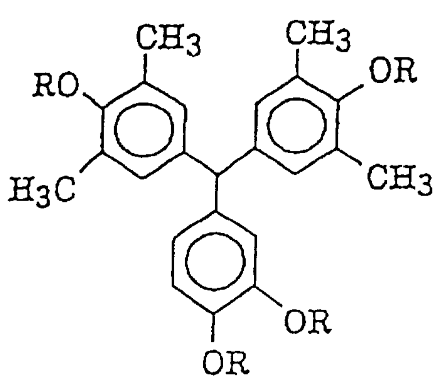

(10)

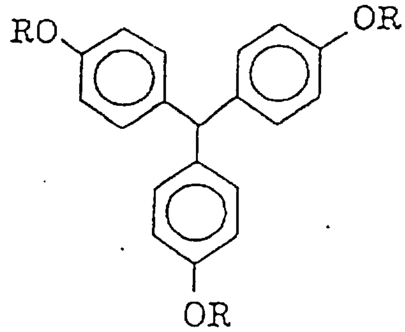

(11)

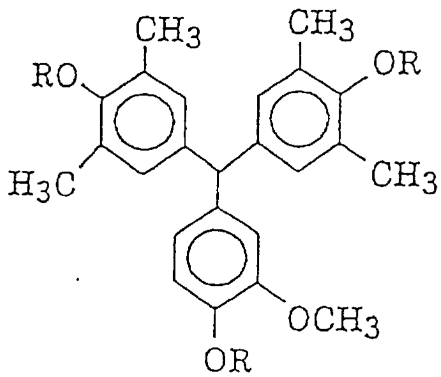

(12)

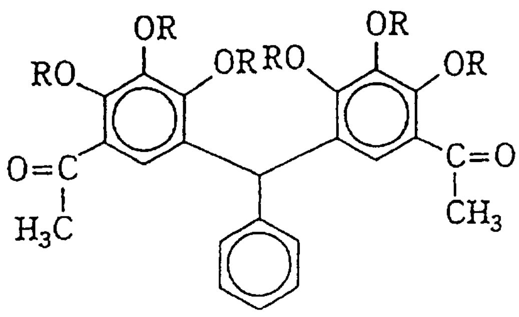

(13)

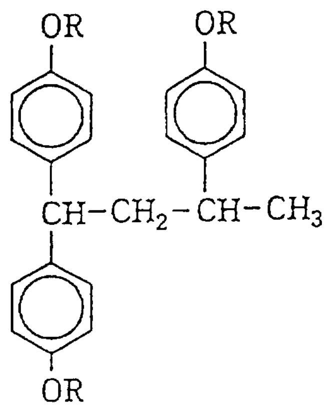

(14)

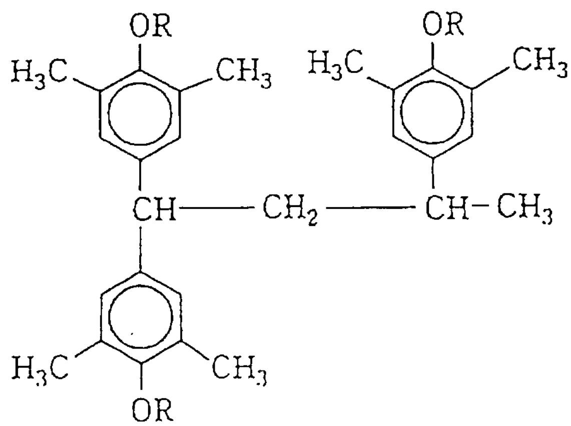

(15)

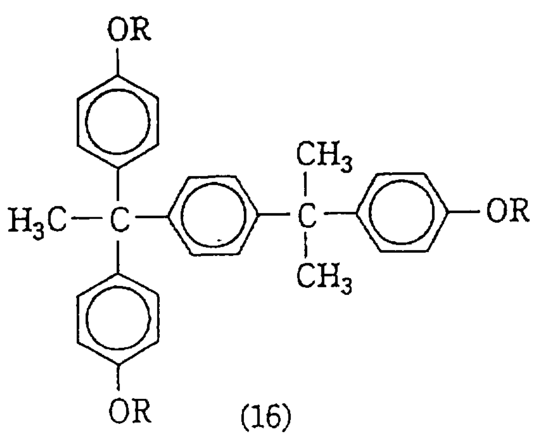

(16)

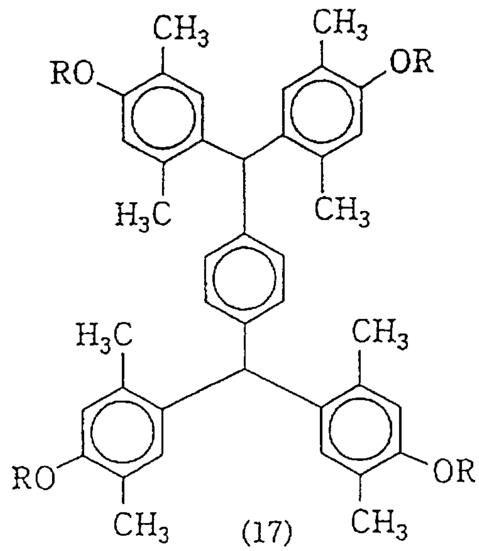

(17)

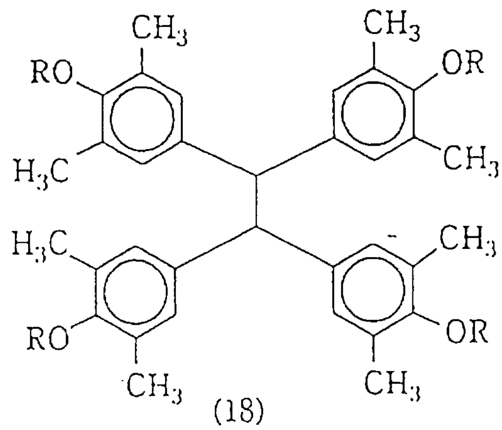

(18)

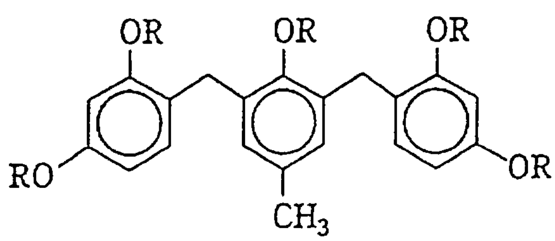

(19)

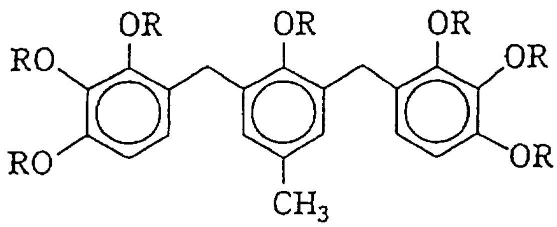

(20)

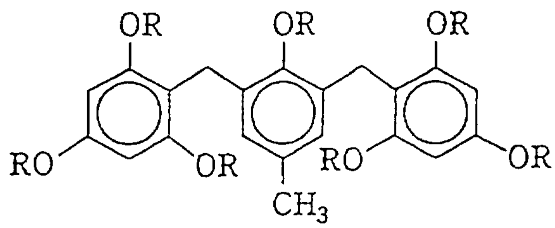

(21)

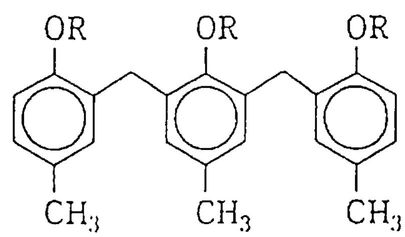

(22)

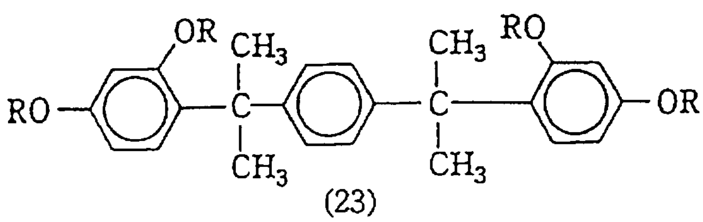

(23)

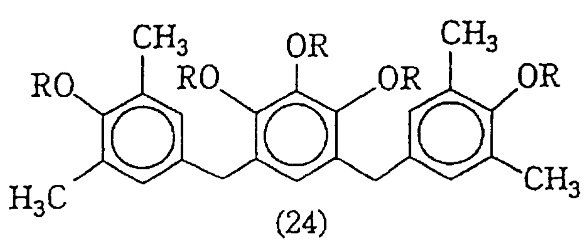

(24)

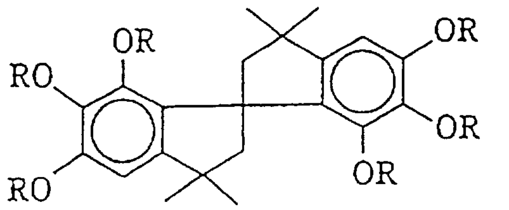

(25)

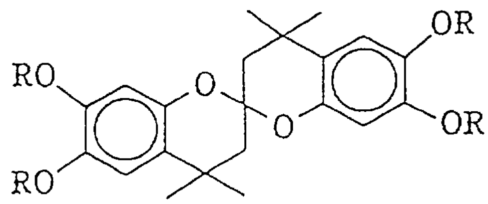

(26)

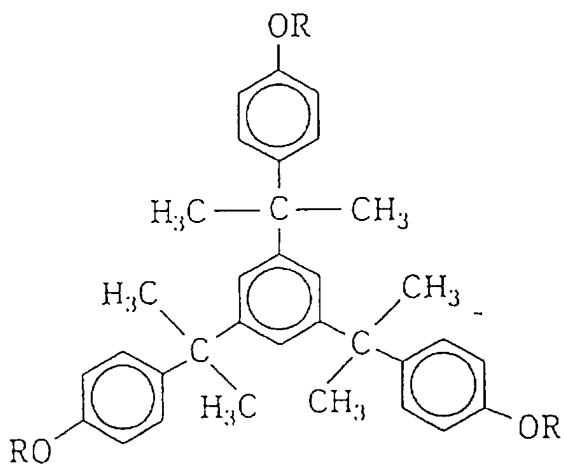

(27)

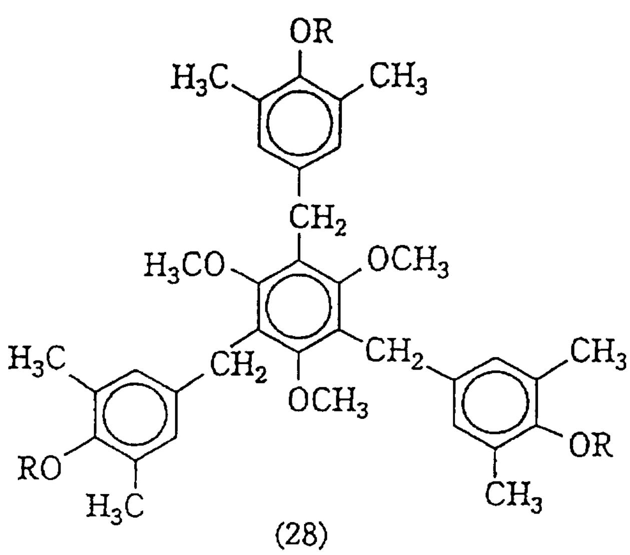

(28)

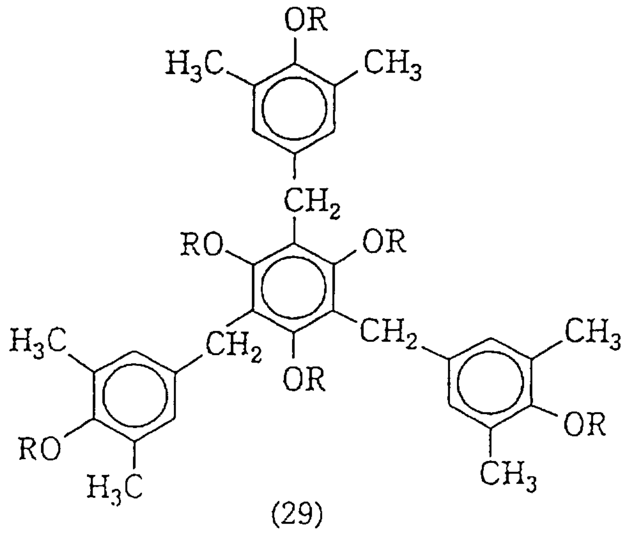

(29)

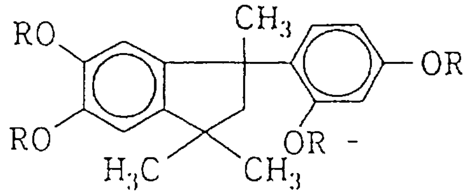

(30)

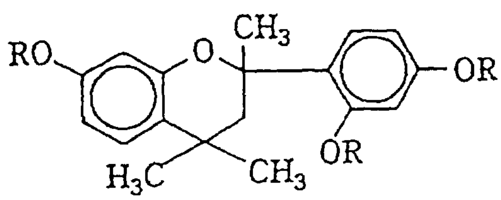

(31)

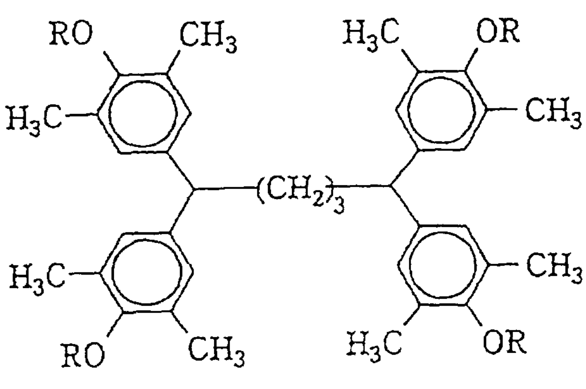

(32)

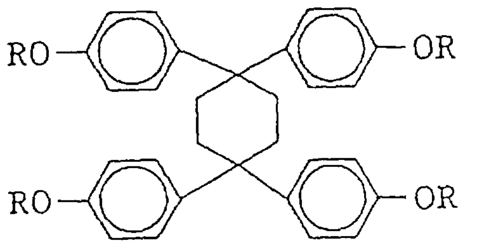

(33)

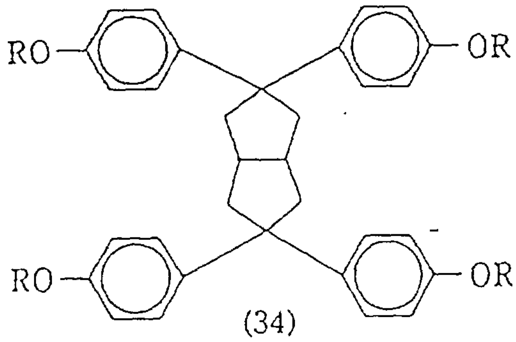

(34)

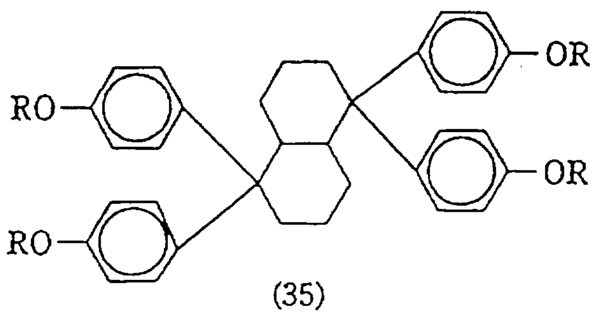

(35)

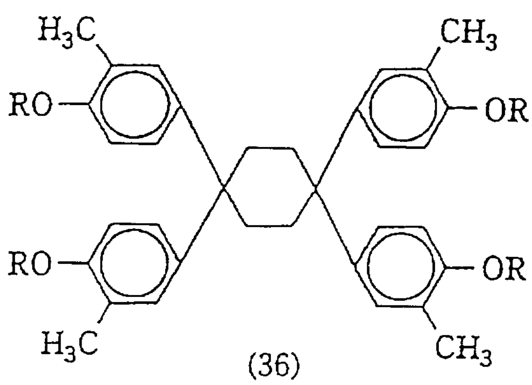

(36)

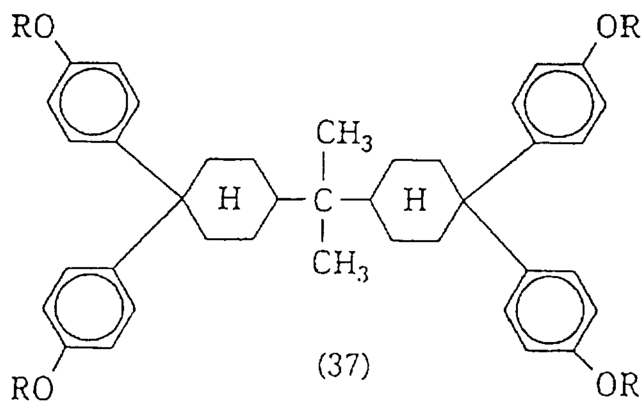

(37)

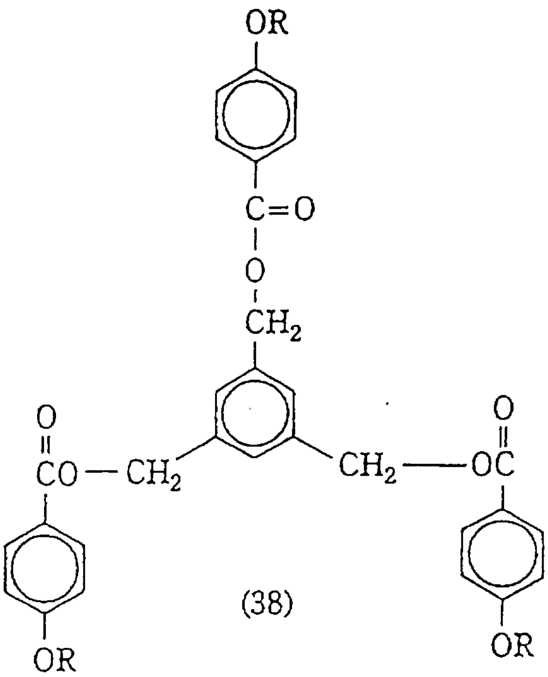

(38)

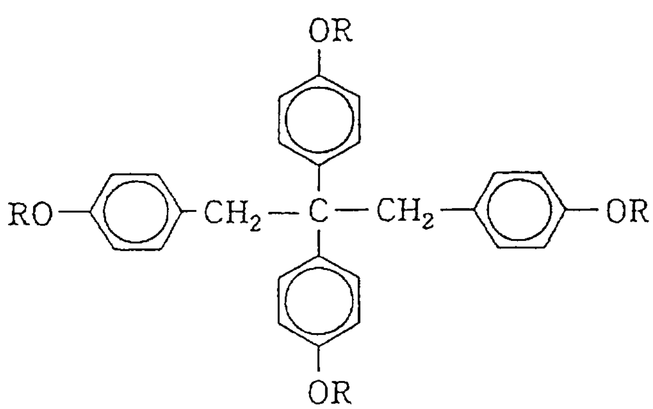

(39)

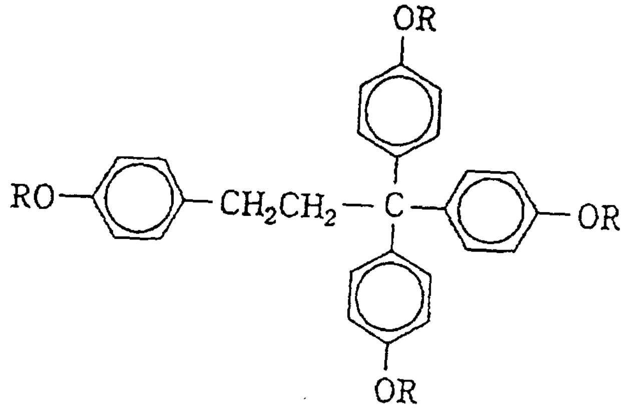

(40)

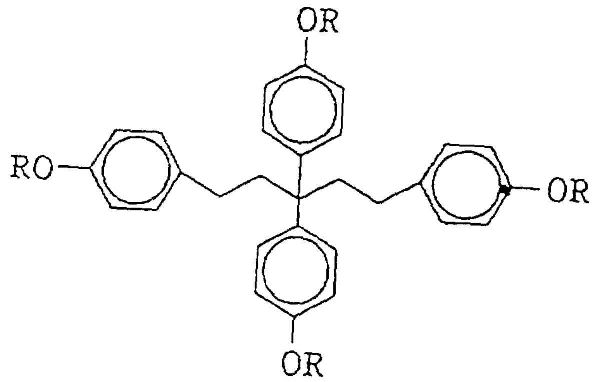

(41)

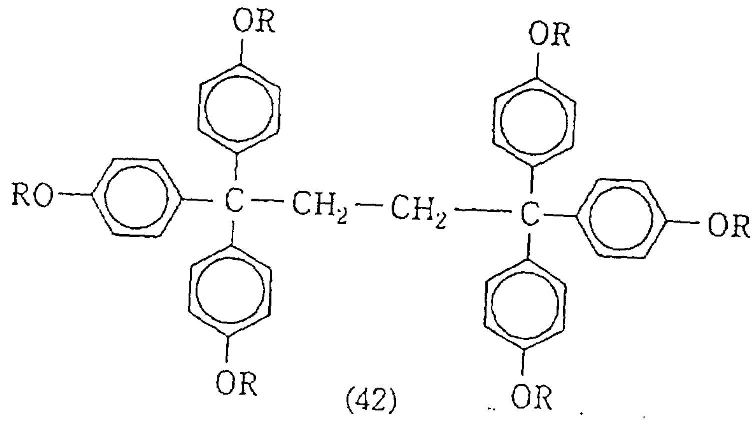

(42)

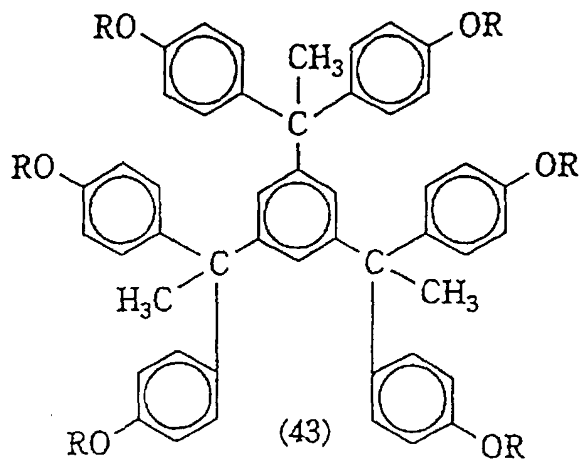

(43)

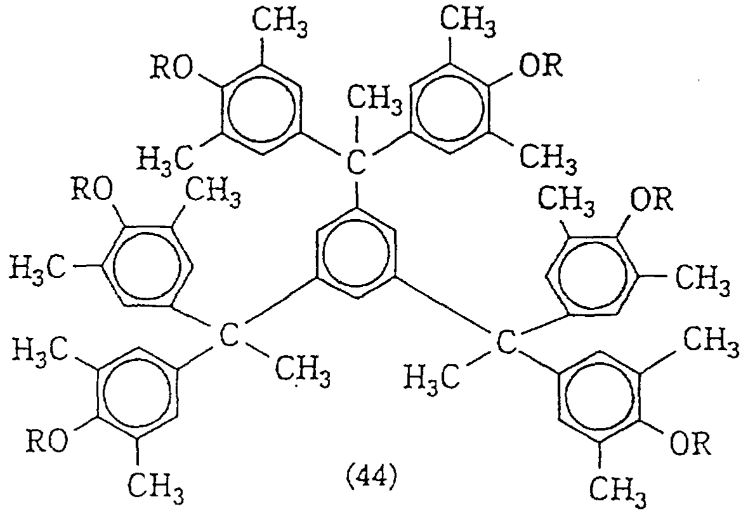

(44)

In Compounds (1) to (44), R represents a hydrogen atom,

$$—CH_2\text{-}COO\text{-}C(CH_3)_2C_6H_5, \quad —CH_2\text{-}COO\text{-}C_4H_9t,$$

$—COO\text{-}C_4H_9t$ or 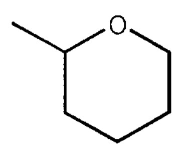,

provided that at least two of the R groups or depending on the structure, three R groups are a group other than a hydrogen atom. The substituents R may not be the same group. [V] In the present invention, a resin which is insoluble in water and soluble in an alkali developer (alkali-soluble resin) (component (h)) may be used.

In the positive electron beam or X-ray resist composition of the present invention, when the component (h) is used, the component (f), that is, a resin having a group capable of decomposing by an acid, which increases in the solubility in an alkali developer under the action of an acid, is not necessarily be blended. Of course, a combination use of the component (h) and the component (f) is not excluded.

The (h) alkali-soluble resin for use in the present invention is preferably the resin represented by the following formula (1):

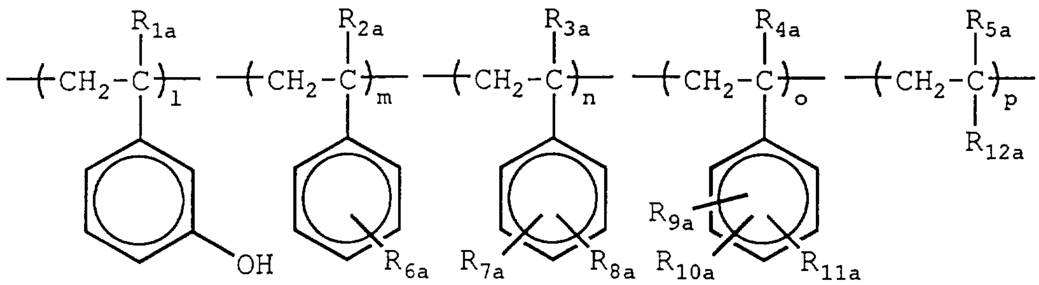

(1)

wherein $R_{1a}$ to $R_{5a}$ each independently represents a hydrogen atom or a methyl group;

$R_{6a}$ to $R_{11a}$ each represents a hydrogen atom, an alkyl or alkoxy group having from 1 to 4 carbon atoms, a hydroxyl group or -C(=O)-$R_{14a}$ (wherein $R_{14a}$ represents a hydrogen tom or an alkyl group having from 1 to 4 carbon atoms); $R_{12a}$ represents -COOR$_{15a}$ (wherein $R_{15a}$ represents a hydrogen atom or an alkyl group having from 1 to 4 carbon atoms);

$$0<1\leq 100;$$

$$0\leq m, n, o, p<100;$$

and

$$1+m+n+o+p = 100.$$

The objective alkali-soluble resin represented by formula (1) for use in the present invention can be obtained by a radial polymerization or living anion polymerization of the following monomer (2) and if desired, monomers (3) to (6).

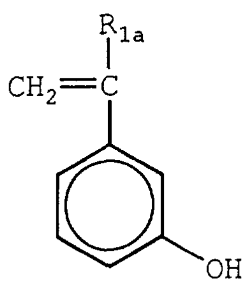

(2)

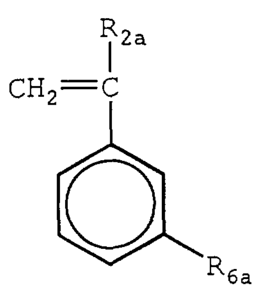

(3)

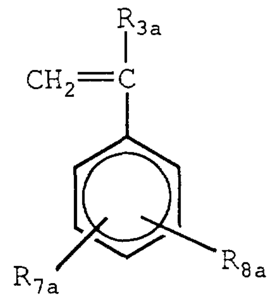

(4)

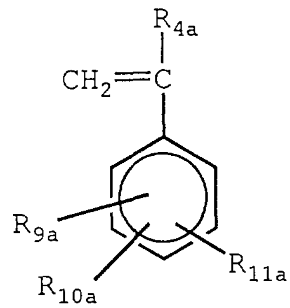

(5)

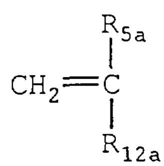

(6)

wherein $R_{1a}$ to $R_{12a}$ have the same meanings as above.

Out of these monomers, when a monomer having a hydroxyl group within the molecule is used, a method of previously protecting the hydroxyl group and after the polymerization, removing the protective group is preferred.

In the present invention, the content of the repeating structural unit represented by (2) in the resin may be sufficient if it is large enough to bring out the effect of the present invention. To speak specifically, the content is preferably from 30 to 100 mol%, more preferably from 50 to 90 mol%, based on all repeating units.

In formula (1), $R_{1a}$ to $R_{5a}$ each represents a hydrogen atom or a methyl group. The alkyl or alkoxy group having from 1 to 4 carbon atoms of $R_{6a}$ to $R_{11a}$, $R_{14a}$ and $R_{15a}$ may be linear or branched. Examples of the alkyl group include a methyl group, an ethyl group, a propyl group, an isopropyl group, a butyl group, an isobutyl group and a tert-butyl group. Examples of the alkoxy group include a methoxy group, an ethoxy group, a propoxy group, an isopropoxy group, a butoxy group, an isobutoxy group and a tert-butoxy group.

In formula (1), $0<1\leq100$, preferably $30<1\leq100$, more preferably $50<1\leq90$; m, n, o and p satisfy the condition of $0\leq m,n,o,p<100$, preferably $20\leq m,n,o,p\leq70$, more preferably $30\leq m,n,o,p\leq50$; and $l+m+n+o+p=100$.

The weight average molecular weight of the alkali-soluble resin is preferably from 1,000 to 30,000. If the weight average molecular weight is less than 1,000, the unexposed area undergoes a large layer loss after the development, whereas if it exceeds 30,000, the development rate decreases. The weight average molecularly weight is more preferably from 2,000 to 20,000.

The weight average molecularly weight is still more preferably from 3,000 to 17,000 and particularly preferably from 4,000 to 15,000.

The molecular weight distribution (Mw/Mn) of the alkali-soluble resin is preferably from 1.0 to 1.5 (monodisperse polymer) because the development residue is reduced. The molecular weight distribution (Mw/Mn) of the alkali-soluble resin is more preferably from 1.0 to 1.4, still more preferably from 1.0 to 1.3, particularly preferably from 1.0 to 1.2.

The weight average molecular weight is defined as the value determined in terms of polystyrene by gel permeation chromatography.

In the present invention, the alkali-soluble resin having a molecular weight distribution within the above-described range can be synthesized by a known living anion polymerization or may be obtained by a molecular weight

fractionation.

The living anion polymerization is describe in Shin Jikken Kagaku Koza 19, Kobunshi Kagaku (New Experimental Chemistry Course 19, Polymer Chemistry) (I), pp. 59-73, Maruzen, and the molecular weight fractionation is described in Shin Jikken Kaqaku Koza 19, Kobunshi Kagaku (New Experimental Chemistry Course 19, Polymer Chemistry) (II), pp. 522-527, Maruzen.

The alkali dissolution rate of the alkali-soluble resin is preferably 20 Å/sec or more, more preferably 200 Å/sec or more, by the measurement (at 23°C) with 0.261N tetramethylammonium hydroxide (TMAH).

Specific examples of the component (h) represented by formula (1) for use in the present invention re set forth below, however, the present invention is not limited thereto.

| | | Mw | Mw/Mn |
|---|---|---|---|
| P-1 | 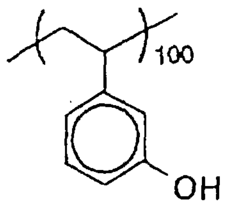 | 10,000 | 1.7 |
| P-2 | 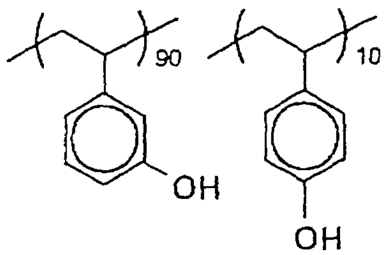 | 8,000 | 1.2 |
| P-3 | 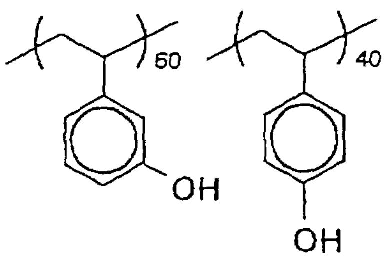 | 12,000 | 2.0 |
| P-4 | 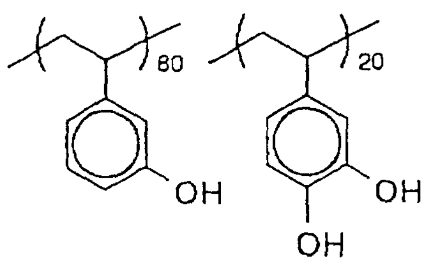 | 9,000 | 2.2 |
| P-5 | 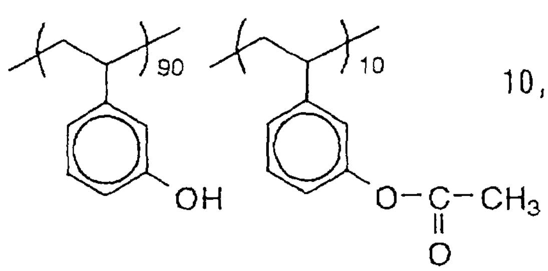 | 10,000 | 1.9 |

| | | Mw | Mw/Mn |
|---|---|---|---|
| P-6 | 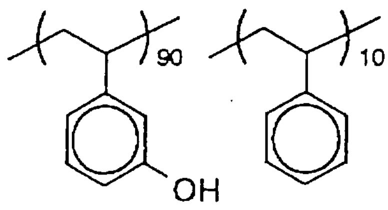 | 13,000 | 2.3 |
| P-7 | 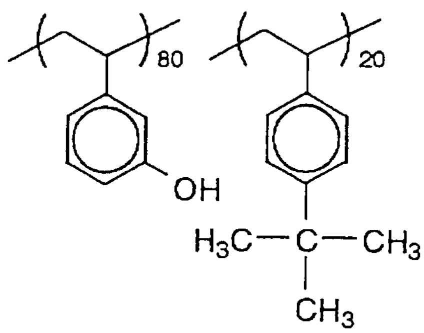 | 15,000 | 2.3 |
| P-8 | 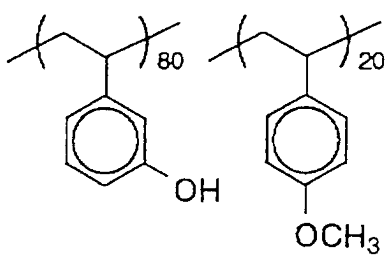 | 20,000 | 1.9 |
| P-9 | 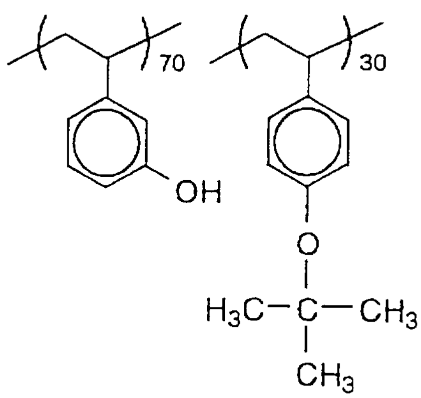 | 16,000 | 1.6 |

| | | Mw | Mw/Mn |
|---|---|---|---|
| P-10 | 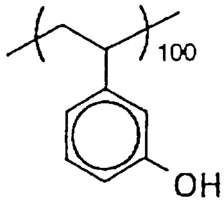 | 10,000 | 1.1 |
| P-11 | 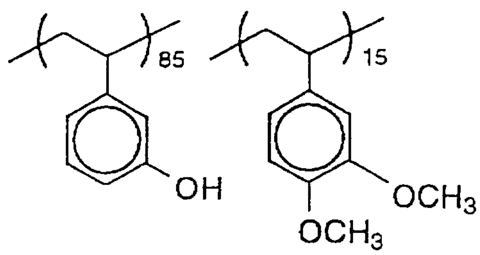 | 6,000 | 1.5 |
| P-12 | 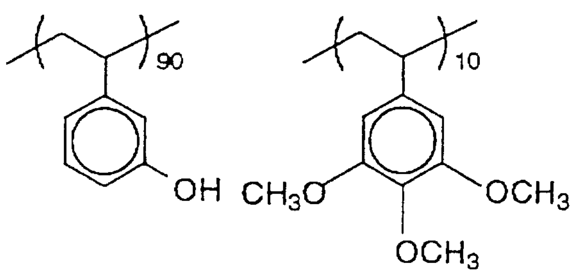 | 9,500 | 1.7 |

These resins can be synthesized as follows.

Synthesis of (P-1)

To 27 g of dry THF, 17.6 g of 3-tert-butoxystyrene was added and heated at 70°C in a nitrogen stream. When the reaction temperature was stabilized, an azo-based radical initiator V-601 produced by Wako Pure Chemical Industries, Ltd. was added in an amount of 2 mol% based on the monomer, thereby starting the reaction. After the reaction for 3 hours, 2 mol% of V-601 was again added and the reaction was performed for another 3 hours. The reaction mixture was diluted with THF, charged into a large amount of methanol and precipitated. The obtained polymer was decomposed by an ordinary method in an acidic solution of hydrochloric acid and precipitated in hexane. The reprecipitation and purification operation was repeated twice and then the precipitate was dried under reduced pressure to obtain (P-1). By the GPC measurement using a THF solvent, the molecular weight (Mw, as polystyrene) and the degree of molecular weight dispersion (Mw/Mn) were determined.

(P-3), (P-4), (P-6), (P-7), (P-8), (P-11) and (P-12) were obtained almost in the same manner except for changing the monomer.

Synthesis of (P-5)

To 24 g of dry THF, 16.2 g of 3-acetoxystyrene was added and heated at 70°C in a nitrogen stream. When the reaction temperature was stabilized, an azo-based radical initiator V-60 produced by Wako Pure Chemical Industries, Ltd. was added in an amount of 2 mol% based on the monomer, thereby starting the reaction. After the reaction for 3 hours, 2 mol% of V-60 was again added and the reaction was performed for another 3 hours. The reaction mixture was diluted with THF, charged into a large amount of methanol and precipitated. The obtained polymer was hydrolyzed

by an ordinary method in a solution under basic conditions and precipitated in hexane. The reprecipitation and purification operation was repeated twice and then the precipitate was dried under reduced pressure to obtain (P-5).

Synthesis of (P-9)

To 30 g of dry THF, 11.3 g of 3-hydroxystyrene and 5.3 g of 4-tert-butoxystyrene were added and heated at 70°C in a nitrogen stream. When the reaction temperature was stabilized, an azo-based radical initiator V-601 produced by Wako Pure Chemical Industries, Ltd. was added in an amount of 2 mol% based on the monomer, thereby starting the reaction. After the reaction for 3 hours, 2 mol% of V-601 was again added and the reaction was performed for another 3 hours. The reaction mixture was diluted with THF, charged into a large amount of methanol and precipitated. The reprecipitation and purification operation was repeated twice and then the precipitate was dried under reduced pressure to obtain (P-9).

Synthesis of (P-10)

In a deaerated dry THF at -78°C, 17.6 g of 3-tert-butoxystyrene was living anion-polymerized using s-butyl lithium as an initiator. After the reaction for 3 hours, the reaction was terminated by deaerated methanol. The reaction product was charged into a large amount of methanol and the precipitated powder was collected by filtration. The reprecipitation and purification operation was repeated twice and then the precipitate was dried under reduced pressure to obtain a resin. The t-butoxy group of the resin was decomposed by an ordinary method under an acidic condition of hydrochloric acid to obtain (P-10).

(P-2) was obtained almost in the same manner except for changing the monomer.

Other examples of (h) the alkali-soluble resin for use in the present invention include novolak resin, hydrogenated novolak resin, acetone-pyrogallol resin, poly(o-hydroxystyrene), poly(p-hydroxystyrene), hydrogenated polyhydroxystyrene, halogen- or alkyl-substituted polyhydroxystyrene, hydroxystyrene-N-substituted maleimide copolymer, o/p-hydroxystyrene copolymers, partially OH group-alkylated products of polyhydroxystyrene (e.g., O-methylated product, (1-methoxy)ethylated product, O-(1-ethoxy)ethylated product, O-2-tetrahydropyranylated product, O-(t-butoxycarbonyl)methylated product, each in an alkylation degree of 5 to 30 mol%), partially OH group-acylated products of polyhydroxystyrene (e.g., O-acetylated product, O-(tert-butoxy)carbonylated product, each in an acylation degree of 5 to 30 mol%), styrene-maleic anhydride copolymers, styrene-hydroxystyrene copolymers, α-methylstyrene-hydroxystyrene copolymers, carboxyl group-containing methacrylic resin and derivatives thereof, and polyvinyl alcohol derivatives, however, the present invention is not limited thereto.

Among these alkali-soluble resins (h), preferred are novolak resin, poly(o-hydroxystyrene), poly(p-hydroxystyrene), copolymers thereof, alkyl-substituted polyhydroxystyrene, partially O-alkylated or O-acylated products of polyhydroxystyrene, styrene-hydroxystyrene copolymers and α-methylstyrene-hydroxystyrene copolymers. The novolak resin can be obtained using a predetermined monomer as the main component by the addition-condensation reaction with an aldehyde in the presence of an acidic catalyst.

Examples of the predetermined monomer include phenol, cresols (e.g., m-cresol, p-cresol, o-cresol), xylenols (e.g., 2,5-xylenol, 3,5-xylenol, 3,4-xylenol, 2,3-xylenol), alkylphenols (e.g., m-ethylphenol, p-ethylphenol, o-ethylphenol, p-tert-butylphenol, p-octylphenol, 2,3,5-trimethylphenol), alkoxyphenols (e.g., p-methoxyphenol, m-methoxyphenol, 3,5-dimethoxyphenol, 2-methoxy-4-methylphenol, m-ethoxyphenol, p-ethoxyphenol, m-propoxyphenol, p-propoxyphenol, m-butoxyphenol and p-butoxyphenol), bisalkylphenols (e.g., 2-methyl-4-isopropylphenol), aromatic hydroxy compounds (e.g., m-chlorophenol, p-chlorophenol, o-chlorophenol, dihydroxybiphenyl, bisphenol A, phenylphenol, resorcinol, naphthol). These monomers may be used individually or in combination of two or more thereof, however, the present invention is not limited thereto.

Examples of aldehydes which can be used include formaldehyde, paraformaldehyde, acetaldehyde, propionaldehyde, benzaldehyde, phenylacetaldehyde, α-phenylpropyl aldehyde, β-phenylpropyl aldehyde, o-hydroxybenzaldehyde, m-hydroxybenzaldehyde, p-hydroxybenzaldehyde, o-chloro-benzaldehyde, m-chlorobenzaldehyde, p-chlorobenzaldehyde, o-nitrobenzaldehyde, m-nitrobenzaldehyde, p-nitrobenz-aldehyde, o-methylbenzaldehyde, m-methylbenzaldehyde, p-methylbenzaldehyde, p-ethylbenzaldehyde, p-n-butylbenzaldehyde, furfural, chloroacetaldehyde, and acetal forms thereof such as chloroacetaldehyde diethylacetal. Among these, formaldehyde is preferred.

Those aldehydes can be used individually or in combination of two or more thereof. Examples of the acidic catalyst which can be used include hydrochloric acid, sulfuric acid, formic acid, acetic acid and oxalic acid.

The weight average molecular weight of the novolak resin is preferably from 1,000 to 30,000. If the weight average molecular weight is less than 1,000, the unexposed area undergoes a serious layer loss after the development, whereas if it exceeds 30,000, the development decreases. The weight average molecular weight of the novolak resin is more preferably from 2,000 to 20,000.

The above-described polyhydroxystyrene (other than the novolak resin) and the derivatives and copolymers

thereof have a weight average molecular weight of 2,000 or more, preferably from 5,000 to 200,000, more preferably from 5,000 to 100,000.

The weight average molecular weight is defined as the value determined in terms of polystyrene by gel permeation chromatography.

In the present invention, these alkali-soluble resins (h) may be used in combination of two or more thereof.

Construction examples of the composition of the present invention are described below, however, the present invention is not limited thereto.

1) A positive electron beam or X-ray resist composition containing the component (a), the component (b), the component (c) and the component (f).
2) A positive electron beam or X-ray resist composition containing the component (a), the component (b), the component (c), the component (g) and the component (h).
3) A positive electron beam or X-ray resist composition containing the component (a), the component (b), the component (c), the component (f) and the component (g).

In these construction examples, the amounts of the component (f) used in 1), the component (h) in 2), and the component (f) in 3) each is preferably from 40 to 99 wt%, more preferably from 50 to 95 wt%, based on the solid content of the entire composition.

The amount of the component (g) used in the composition is, in any construction example, preferably from 3 to 45 wt%, more preferably from 5 to 30 wt%, still more preferably from 10 to 30 wt%, based on the solid content of the entire composition.

[VI] Organic basic compound (component (d))

The organic basic compound (d) for use in the present invention is a compound having a basicity stronger than that of phenol. In particular, a nitrogen-containing basic compound is preferred.

With respect to the chemical environment, nitrogen-containing basic compounds having a structure (A), (B), (C), (D) or (E) are preferred.

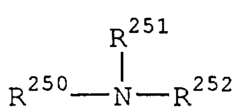

(A)

wherein $R^{250}$, $R^{251}$ and $R^{252}$, which may be the same or different, each represents a hydrogen atom, an alkyl group having from 1 to 6 carbon atoms, an aminoalkyl group having from 1 to 6 carbon atoms, a hydroxyalkyl group having from 1 to 6 carbon atoms or a substituted or unsubstituted aryl group having from 6 to 20 carbon atoms, provided that $R^{251}$ and $R^{252}$ may combine with each other to form a ring;

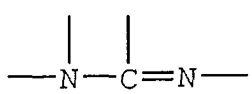

(B)

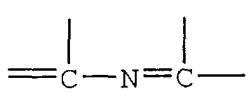

(C)

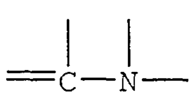

(D)

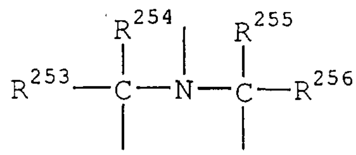

(E)

wherein $R^{253}$, $R^{254}$, $R^{255}$ and $R^{256}$, which may be the same or different, each represents an alkyl group having from 1 to 6 carbon atoms.

The compound is more preferably a nitrogen-containing basic compound having two or more nitrogen atoms different in the chemical environment within one molecule, still more preferably a compound having both a substituted or unsubstituted amino group and a ring structure containing a nitrogen atom, or a compound having an alkylamino group. Specific preferred examples thereof include substituted or unsubstituted guanidine, substituted or unsubstituted aminopyridine, substituted or unsubstituted aminoalkyl-pyridine, substituted or unsubstituted aminopyrrolidine, substituted or unsubstituted indazole, substituted or unsubstituted pyrazole, substituted or unsubstituted pyrazine, substituted or unsubstituted pyrimidine, substituted or unsubstituted purine, substituted or unsubstituted imidazoline, substituted or unsubstituted pyrazoline, substituted or unsubstituted piperazine, substituted or unsubstituted aminomorpholine and substituted or unsubstituted aminoalkylmorpholine. Preferred examples of the substituent include an amino group, an aminoalkyl group, an alkylamino group, an aminoaryl group,- an arylamino group, an alkyl group, an alkoxy group, an acyl group, an acyloxy group, an aryl group, an aryloxy group, a nitro group, a hydroxyl group and a cyano group.

More preferred examples include guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)-pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4, 6-dihydroxypyrimidine, 2-pyrazoline, 3-pyrazoline, N-aminomorpholine, N-(2-aminoethyl)morpholine, diazabicyclononene and diazabicycloundecene, however, the present invention is not limited thereto.

These organic basic compounds (d) may be used individually or in combination of two or more thereof. The amount of the organic basic compound used is usually from 0.01 to 10 mol%, preferably from 0.1 to 5 mol%, based on (a) the compound which generates an acid upon irradiation with a radiation. If the amount used is less than 0.01 mol%, the effect by the addition of the organic basic compound cannot be obtained, whereas if it exceeds 10 wt%, reduction in the sensitivity or deterioration of the developability in the non-exposed area is liable to result.

[VII] Solvent used in the Invention (component (c))

The positive photoresist composition of the present invention comprises (c) a solvent mixture.

The component (c) is a solvent mixture containing at least one solvent (a solvent of Group A) selected from the group consisting of propylene glycol monoalkyl ether carboxylates, at least one solvent (a solvent of Group B) selected from the group consisting of propylene glycol monoalkyl ether, alkyl lactate, acetic ester, chain ketone and alkyl alkoxypropionate, and/or a solvent (a solvent of Group C) selected from the group consisting of γ-butyrolactone, ethylene carbonate and propylene carbonate.

That is, the component (c) includes a combination of a solvent of Group A and a solvent of Group B, a combination of a solvent of Group A and a solvent of Group C, and a combination of a solvent of Group A, a solvent of Group B and a solvent of Group C.

Preferred examples of the propylene glycol monoalkyl ether carboxylate include propylene glycol monomethyl ether acetate, propylene glycol monomethyl ether propionate, propylene glycol monoethyl ether acetate and propylene glycol monoethyl ether propionate.

Preferred examples of the propylene glycol monoalkyl ether include propylene glycol monomethyl ether, propylene glycol monomethyl ether and propylene glycol monoethyl ether.

Preferred examples of the alkyl lactate include methyl lactate and ethyl lactate.

Preferred examples of the acetic ester solvent include butyl acetate, pentyl acetate and hexyl acetate, with butyl acetate being more preferred.

Examples of the chain ketone include heptanone and examples of the heptanone include 2-heptanone, 3-heptanone and 4-heptanone, with 2-heptanone being preferred.

Preferred examples of the alkyl alkoxypropionate include ethyl 3-ethoxypropionate, methyl 3-methoxypropionate, ethyl 3-methoxypropionate and methyl 3-ethoxypropionate.

The weight ratio (A:B) of the solvent of Group A to the solvent of Group B is preferably from 90:10 to 15:85, more preferably from 85:15 to 20:80, still more preferably from 80:20 to 25:75.

The weight ratio (A:C) of the solvent of Group A to the solvent of Group C is preferably from 99.9:0.1 to 75:25, more preferably from 99:1 to 80:20, still more preferably from 97:3 to 85:15.

In the case of combining these three kinds of solvents, the weight percentage of the solvent of Group C used is preferably from 0.1 to 25 wt%, more preferably from 1 to 20 wt%, still more preferably from 3 to 17 wt%, based on all solvents.

In the present invention, the solid contents in the resist composition containing the above-described components are preferably dissolved in the solvent mixtures, in an amount of, as a solid concentration, from 3 to 25 wt%, more preferably from 5 to 22 wt%, still more preferably from 7 to 20 wt%.

[VIII] Fluorine-Containing surfactant and/or silicon-containing surfactant

The positive photoresist composition of the present invention preferably contains a fluorine-containing surfactant and/or a silicon-containing surfactant.

The positive photoresist composition of the present invention preferably contains any one of or two or more of a fluorine-containing surfactant, a silicon-containing surfactant and a surfactant containing both a fluorine atom and a silicon atom.

Examples of these surfactants include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactants which can be used include fluorine-containing surfactants and silicon-containing surfactants, such as EFtop EF301 and EF303 (produced by Shin-Akita Kasei K.K.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical). In addition, polysiloxane polymer KP-341 (produced by Shin-Etsu Chemical Co., Ltd.) may also be used as a silicon-containing surfactant.

The amount of the fluorine-containing and/or silicon-containing surfactant blended is usually from 0.001 to 2 wt%, preferably from 0.001 to 1 wt%, more preferably from 0.01 to 1 wt%, based on the solid contents in the composition of the present invention. The above-described surfactants may be used individually or in combination of two or more thereof.

A surfactant other than the fluorine-containing and/or silicon-containing surfactant may also be used in combination. Specific examples thereof include nonionic surfactants such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkyl aryl ethers (e.g., polyoxyethylene octyl phenol ether, polyoxyethylene nonyl phenol ether), polyoxyethylene/polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); and acrylic acid-based or methacrylic acid-based (co)polymers POLYFLOW No. 75 and No. 95 (produced by Kyoei Yushi Kagaku Kogyo K.K.).

The amount of this surfactant blended is usually 2 wt% or less, preferably 1 wt% or less, based on the total solid contents in the composition of the present invention.

These surfactants may be used individually or in combination of two or more thereof.

[IX]Other components used in the Invention

The positive electron beam or X-ray resist composition of the present invention may additionally contain, if desired, a dye, a pigment, a plasticizer, a photosensitizer and a compound having two or more phenolic OH groups capable of accelerating the solubility in a developer.

The compound having two or more phenolic OH groups which can be used in the present invention is preferably a phenol compound having a molecular weight of 1,000 or less. This compound must have at least two phenolic hydroxyl groups within the molecule but if the number of phenolic hydroxyl groups exceeds 10, the effect of improving the development latitude is lost. Furthermore, if the ratio between the phenolic OH group and the aromatic ring is less than 0.5, the layer thickness dependence is large and the development latitude is liable to narrow, whereas if this ratio exceeds 1.4, the composition deteriorates in the stability and can hardly attain high resolution and satisfactory film

thickness dependence property.

The amount of the phenol compound added is from 2 to 50 wt%, preferably from 5 to 30 wt%, based on (h) the alkali-soluble resin. If the amount added exceeds 50 wt%, new problems disadvantageously arise in that development residue changes for the worse or the pattern deforms at the development.

The phenol compound having a molecular weight of 1,000 or less can be easily synthesized by one skilled in the art while referring to the methods described, for example, in JP-A-4-122938, JP-A-2-28531, U.S. Patent 4,916,210 and European Patent 219,294.

Specific examples of the phenol compound are described below, however, the compounds which can be used in the present invention is not limited thereto.

Specific examples of the phenol compound include resorcin, phloroglucin, 2,3,4-trihydroxybenzophenone, 2,3,4,4'-tetrahydroxybenzophenone, 2,3,4,3',4',5'-hexahydroxybenzophenone, acetone-pyrogallol condensed resin, phloroglucide, 2,4,2',4'-biphenyltetrol, 4,4'-thiobis(1,3-dihydroxy)benzene, 2,2',4,4'-tetrahydroxydiphenyl ether, 2,2',4,4'-tetrahydroxydiphenyl sulfoxide, 2,2',4,4'-tetrahydroxydiphenylsulfone, tris(4-hydroxyphenyl)methane, 1,1-bis(4-hydroxyphenyl)cyclohexane, 4,4-(α-methyl-benzylidene)bisphenol, α,α',α''-tris(4-hydroxyphenyl)-1,3,5-triisopropylbenzene, α,α',α''-tris(4-hydroxyphenyl)-1-ethyl-4-isopropylbenzene, 1,2,2-tris(hydroxyphenyl)propane, 1,1,2-tris(3,5-dimethyl-4-hydroxyphenyl)propane, 2,2,5,5-tetrakis(4-hydroxyphenyl)hexane, 1,2-tetrakis(4-hydroxy-phenyl)ethane, 1,1,3-tris(hydroxyphenyl)butane and para[α,α,α',α'-tetrakis(4-hydroxyphenyl)]xylene.

The composition of the present invention coated on a support after dissolving the above-described components in a solvent mixture as the component (c). In the present invention, in addition to the solvent mixture as the component (c), another solvent may be appropriately mixed, if desired. Preferred examples of the another compound include ethylene dichloride, cyclohexanone, cyclopentanone, ethylene glycol monomethyl ether, ethylene glycol monoethyl ether, 2-methoxyethyl acetate, ethylene glycol monoethyl ether acetate, toluene, methyl pyruvate, ethyl pyruvate, propyl pyruvate, N,N-dimethylformamide, N,N-dimethylacet-amide, dimethylsulfoxide, N,N,N',N'-tetramethylurea, N-methylpyrrolidone, tetrahydrofuran, methyl β-methoxyisobutyrate, ethyl butyrate and propyl butyrate. One or more of these solvents may be mixed. The amount of the another solvent added is usually 100 parts by weight or less per 100 parts by weight of (c) the solvent mixture.

In the course of seeking for further progress of semiconductors, a high-performance composition is required in addition to the substantial performance of resist, such as high resolution, from various aspects, for example, sensitivity, coatability, minimum amount necessary for coating, adhesive property to substrate, heat resistance and storage stability of composition.

In recent years, a device is liable to be fabricated using a large aperture wafer for the purpose of increasing the absolute amount which can be taken by the finished chip.

However, the coating to a large size may cause reduction in the coatability, particularly, in-plane layer thickness uniformity and therefore, the large aperture wafer is demanded to be improved in the in-plane layer thickness uniformity. This uniformity can be confirmed by a technique such that the film thickness is measured at many points inside a wafer, a standard deviation of respective measured values is obtained and a triple value thereof is used for confirming the uniformity. As this value is smaller, the in-plane uniformity is higher. The value is, in terms of the triple standard deviation, preferably 100 or less, more preferably 50 or less.

Also, in the production of a mask for photolithography, the CD linearity is regarded as most important and improvement in the in-plane layer thickness inside a blank is being demanded.

The resist composition of the present invention may be filtered after the dissolving in the solvent. The filter used therefor is selected from those used in the resist field. Specific examples thereof include filters made of a construction material containing polyethylene, nylon or polysulfone.

More specifically, Microguard, Microguard Plus, Microguard Minikem-D PR, Millipore Optimizer DEV/DEV-C and Millipore Optimizer 16/14, all produced by Millipore; and Ultibore N66, Bozidain and nylon falcon, all produced by Ball. The pore size of a filter which can be used may be determined by the following method, namely, PLS standard particles (polystyrene latex beads, particle size: 0.100 μm) are dispersed in ultrapure water and continuously flown at a constant flow rate to the primary side of a filter by a tube pump and the challenge concentration is measured by a particle counter. A filter succeeded in capturing 90% or more of particles can be used as a 0.1 μm-pore size filter.

The positive electron beam or X-ray resist composition of the present invention is coated on a substrate used in the production of a precision integrated circuit device (e.g., silicon/silicon dioxide coating) or a substrate used in the production of a mask for photolithography (e.g., glass/Cr coating) by an appropriate coating method such as spinner and coater, exposed through a predetermined mask and then developed by baking, whereby a good resist pattern can be obtained.

The developer which can be used for the composition of the present invention is an alkaline aqueous solution of an inorganic alkali such as sodium hydroxide, potassium hydroxide, sodium carbonate, sodium silicate, sodium metasilicate and aqueous ammonia, a primary amine such as ethylamine and n-propylamine, a secondary amine. such as diethylamine and di-n-butylamine, a tertiary amine such as triethylamine and methyldiethylamine, an alcohol amine

such as dimethyl ethanolamine and triethanolamine, a quaternary ammonium salt such as tetramethylammonium hydroxide and tetraethylammonium hydroxide, or a cyclic amine such as pyrrole and piperidine.

Furthermore, this alkaline aqueous solution may also be used after adding thereto an alcohol and a surfactant each in an appropriate amount.

The present invention is described in greater detail below, however, the present invention should not be construed as being limited thereto.

Synthesis Example 1

Synthesis of poly(p-hydroxystyrene/styrene) copolymer:

In 100 ml of tetrahydrofuran, 35.25 g (0.2 mol) of p-tert-butoxystyrene monomer dehydrated and distillation purified by an ordinary method and 6.21 g (0.05 mol) of styrene monomer were dissolved. While stirring in a nitrogen atmosphere, 0.033 g of azobisisobutyronitrile (AIBN) was added thereto at 80°C three times every 2.5 hours and in the end, the mixture was continuously stirred for 5 hours, thereby performing the polymerization reaction. The reaction solution was charged into 1,200 ml of hexane to precipitate a white resin. The obtained resin was dried and then dissolved in 150 ml of tetrahydrofuran.

Thereto, 4N hydrochloric acid was added and the resulting solution was heated under reflux for 6 hours, thereby performing the hydrolysis. The hydrolysate was reprecipitated in 5 L of ultrapure water and the precipitated resin was separated by filtration, washed with water and dried. The resin obtained was dissolved in 200 ml of tetrahydrofuran and the resulting solution was added dropwise to 5 L of ultrapure water while vigorously stirring, thereby performing the reprecipitation. This reprecipitation operation was repeated three times. The obtained resin was dried in a vacuum desiccator at 120°C for 12 hours to obtain a poly(p-hydroxystyrene/styrene) copolymer.

Synthesis Example 2

Synthesis of Resin (c-21) :

In 120 ml of butyl acetate, 32.4 g (0.2 mol) of p-acetoxystyrene and 7.01 g (0.07 mol) of tert-butyl methacrylate were dissolved. While stirring in a nitrogen atmosphere, 0.033 g of azobisisobutyronitrile (AIBN) was added thereto at 80°C three times every 2.5 hours and in the end, the mixture was continuously stirred for 5 hours, thereby performing the polymerization reaction. The reaction solution was charged into 1,200 ml of hexane to precipitate a white resin. The obtained resin was dried and then dissolved in 200 ml of methanol.

Thereto, an aqueous solution containing 7.7 g (0.19 mol) of sodium hydroxide and 50 ml of water was added and the resulting solution was heated under reflux for 1 hour, thereby performing the hydrolysis. The hydrolysate was diluted by adding 200 ml of water and neutralized with hydrochloric acid to precipitate a white resin. This resin was separated by filtration, washed with water and dried. The resin obtained was dissolved in 200 ml of tetrahydrofuran and the resulting solution was added dropwise to 5 L of ultrapure water while vigorously stirring, thereby performing the reprecipitation. This reprecipitation operation was repeated three times. The obtained resin was dried in a vacuum desiccator at 120°C for 12 hours to obtain a poly(p-hydroxystyrene/tert-butyl methacrylate) copolymer.

Synthesis Example 3

Synthesis of Resin (c-3):

In 50 ml of pyridine, 10 g of poly(p-hydroxystyrene (VP-8000, produced by Nippon Soda Co., Ltd.) was dissolved and thereto, 3.63 g of di-tert-butyl dicarbonate was added dropwise at room temperature while stirring.

After stirring at room temperature for 3 hours, the resulting solution was added dropwise to a solution of 1 L of ion exchanged water/20 g of concentrated hydrochloric acid. The precipitated powder was filtered, washed with water and dried, as a result, Resin (c-3) was obtained.

Synthesis Example 4

Synthesis of Resin (c-32) :

In 300 ml of toluene, 83.1 g (0.5 mol) of p-cyclohexylphenol was dissolved and subsequently, 150 g of 2-chloroethyl vinyl ether, 25 g of sodium hydroxide, 5 g of tetrabutylammonium bromide and 60 g of triethylamine were added and reacted at 120°C for 5 hours. The reaction solution was washed with water, the excess chloroethyl vinyl ether and

toluene were removed by distillation and the obtained oil was purified by distillation under reduced pressure, as a result, 4-cyclohexylphenoxyethyl vinyl ether was obtained.

In 80 ml of THF, 20 g of poly(p-hydroxystyrene) (PV-8000, produced by Nippon Soda Co., Ltd.) and 6.5 g of 4-cyclohexylphenoxyethyl vinyl ether obtained above were dissolved and thereto, 0.01 g of p-toluenesulfonic acid was added and reacted at room temperature for 18 hours. The reaction solution was added dropwise to 5 L of distilled water while vigorously stirring and the precipitated powder was filtered and dried, as a result, Resin (c-32) was obtained.

Resins (c-4), (c-28) and (c-30) were synthesized in the same manner using the corresponding trunk polymer and vinyl ether.

Furthermore, (c-4)' and (c-28)' were obtained by the same operation using poly(p-hydroxystyrene) (VP-5000, produced by Nippon Soda Co., Ltd.) in place of poly(p-hydroxystyrene) (VP-8000, produced by Nippon Soda Co., Ltd.).

Polymer (poly(p-hydroxystyrene/styrene) copolymer (2)) (c-21)' was obtained by adjusting the amount of initiator such that the molecular weight was reduced to about 60%.

<u>Synthesis Example 1 of Dissolution-Inhibiting Compound</u>

Synthesis of Compound 16:

In 300 ml of N,N-dimethylacetamide, 42.4 g (0.10 mol) of 1-[α-methyl-α-(4'-hydroxyphenyl)ethyl]-4-[α',α'-bis (4"-hydroxyphenyl)ethyl]benzene was dissolved and thereto, 49.5 g (0.35 mol) of potassium carbonate and 84.8 g (0.33 mol) of cumyl bromoacetate ester were added. The resulting solution was stirred at 120°C for 7 hours. The reaction mixture was poured into 2 liter of ion exchanged water, neutralized by acetic acid and extracted with ethyl acetate. The ethyl acetate extract was concentrated and purified to obtain 70 g of Compound 16 (all R are $-CH_2COOC(CH_3)_2C_6H_5$).

<u>Synthesis Example 2 of Dissolution-Inhibiting Compound</u>

Synthesis of Compound 41:

In 250 ml of N,N-dimethylacetamide, 44 g of 1,3,3,5-tetrakis(4-hydroxyphenyl)pentane was dissolved and thereto, 70.7 g of potassium carbonate and subsequently, 90.3 g of tert-butyl bromoacetate were added. The resulting solution was stirred at 120°C for 7 hours. The reaction mixture was poured into 2 liter of ion exchanged water, the obtained viscous matter was washed with water, and the product was purified by column chromatography to obtain 87 g of Compound 41 (all R are $-CH_2COOC_4H_9$(t)).

<u>Synthesis Example 3 of Dissolution-Inhibiting Compound</u>

Synthesis of Compound 43:

In 400 ml of diethyl ether, 20 g of α,α,α',α',α",α"-hexakis(4-hydroxyphenyl)-1,3,5-triethylbenzene was dissolved. To this solution, 42.4 g of 3,4-dihydro-2H-pyrane and a catalytic amount of hydrochloric acid were added and the resulting solution was refluxed for 24 hours. After the completion of reaction, a slight amount of sodium hydroxide was added and thereafter, the solution was filtered. The filtrate was concentrated and purified by column chromatography to obtain 55.3 g of Compound 43 (all R are THP).

<u>Synthesis Example 4 of Dissolution-Inhibiting Compound</u>

Synthesis of Compound 43-2:

In 200 ml of N,N-dimethylacetamide, 20 g of α,α,α',α',α",α"-hexakis (4-hydroxyphenyl)-1,3,5-triethyl-benzene was dissolved and thereto, 28.3 g of potassium carbonate and subsequently, 36.0 g of butyl bromoacetate were added. The resulting solution was stirred at 120°C for 7 hours. The reaction product was poured into 2 liter of ion exchanged water, the obtained viscous matter was washed with water, and the product was purified by column chromatography to obtain 37 g of Compound 43-2 (all R are $-CH_2COOC_4H_9$(t)).

Synthesis Example of Compound Represented by Formula (A)

Synthesis Example 1 (synthesis of A-22 (benzoyloxyethyl vinyl ether)):

In 3,000 ml of toluene, 244 g (2 mol) of benzoic acid was dissolved and thereto, 320 g of 2-chloroethyl vinyl ether was added. Furthermore, 88 g of sodium hydroxide, 25 g of tetrabutylammonium bromide and 100 g of triethylamine were added and the resulting solution was stirred while stirring at 120°C for 5 hours.

The reaction solution was washed with water and the excess 2-chloroethyl vinyl ether and toluene were removed by distillation under reduced pressure. From the obtained oil portion, 300 g of the objective benzoyloxyethyl vinyl ether was obtained by distillation under reduced pressure.

Synthesis Examples 2 to 8 (syntheses of A-23 to A-29):

A-23 to A-29 were synthesized in the same manner as in the synthesis of A-22.

EXAMPLES (EXAMPLES, COMPARATIVE EXAMPLES)

(1) Coating of Resist

Respective components shown in Table 1 below were dissolved and the obtained solution was filtered through 0.1-μm Teflon filter to prepare a resist solution.

Each sample solution was coated on a silicon wafer using a spin coater and dried on a vacuum adsorption-type hot plate at 120°C for 90 seconds to obtain Resist Film A having a thickness of 0.5 μm.

Separately, each sample solution was coated on a glass substrate with Cr (6025 substrate) using a spin coater and dried on a vacuum adsorption-type hot plate at 100°C for 10 minutes to obtain Resist Film B having a thickness of 0.5 μm.

(2) Formation of Resist Pattern

Resist Film A and Resist Film B each was irradiated using an electron drawing apparatus (applied voltage: 50 KV).

After the irradiation, each film was heated on a vacuum adsorption-type hot plate (Resist Film A: at 110°C for 60 seconds, Resist Film B: at 100°C for 600 seconds), then dipped in an aqueous 2.38% tetramethylammonium hydroxide (TMAH) solution for 60 seconds, rinsed with water for 30 seconds and dried. The cross-sectional shape of the obtained line-and-space pattern was observed by a scanning electron microscope.

(3) Evaluation of Sensitivity and Resolution

The dose necessary for resolving 0.2 μm at 1:1 in the line-and-space pattern was defined as sensitivity and the minimum size which could be resolved by that dose was defined as resolution. In the case where 0.20 μm (line:space=1:1) was not dissolved, the limiting resolution was used for the resolution and the dose at that time was used for the sensitivity.

(4) Evaluation of PCD

A resist film obtained by the method in (1) was left standing within an electron beam drawing apparatus in high vacuum for 60 minutes and then, a resist pattern was formed by the method in (2). Thereafter, a minimum line-and-space which could be resolved by the same dose as the sensitivity obtained in the method of (3) (where the formed resist film was immediately irradiated without standing in high vacuum for 60 minutes) was determined. As this size is closer to the resolution obtained in (3), the PCD stability is higher.

(5) Evaluation of PED

A resist pattern was formed in the same manner as in (2) except that a step of allowing the resist film after the irradiation to stand within an electron beam drawing apparatus in high vacuum for 60 minutes was added. Thereafter, a minimum contact hole size (diameter) or line-and-space which could be resolved by the same dose as the sensitivity obtained in the method of (3) (where the resist film after the irradiation was immediately heated without standing in high vacuum for 60 minutes) was determined. As this size is closer to the resolution obtained in (3), the PED stability is higher.

(6) Evaluation of Development Defect, Coatability and Solvent Solubility

1) Number of development defects

The thus obtained resist patterns each was measured on the number of development defects by KLA-2112 manufactured by KLA Tenchol K.K. and the obtained primary data value was defined as the number of development

defects.

2) Coatability (in-plane uniformity)

Each resist solution was coated on a 8-inch silicon wafer and the same treatment as in the above-described coating of resist layer was performed to obtained a resist coating film for the measurement of in-plane uniformity. On this resist film, the coating film thickness was measured at 36 points evenly along the cross in the wafer diameter direction. A standard deviation of measured values was determined. When the triple value thereof was less than 50, the coatability was rated ○ and when the triple value was 50 or more, the rating was ×.

3) Solvent solubility

The solvent solubility was evaluated by the particle initial value and the increment in the number of particles after storage aging determined according to the following method.
Number of particles and increment in the number of particles after storage aging:
Using the positive photoresist composition solution (coating solution) prepared as above, the number of particles in the solution immediately after the preparation (particle initial value) and the number of particles after the standing at 23°C for 1 week (number of particles after aging) were counted by means of a particle counter manufactured by Lion. Together with the particle initial value, the increment in the number of particles calculated by (number of particles after aging) - (particle initial value) was evaluated. The particles counted were particles of 0.25 μm or more in 1 ml of the resist composition.
Each composition was evaluated for Resist Film A and Resist Film B, and the results for Resist Film A are shown in Table 2 and the results for Resist Film B are shown in Table 3, respectively.

TABLE 1

| | Acid Generator (0.077 g) | Binder | Cationically Polymerizable Compound (0.136 g) | Dissolution-Inhibiting Agent (0.374g) | Organic Basic Compound (0.0031 g) | Surfactant (100 ppm) | Solvent |
|---|---|---|---|---|---|---|---|
| Example 1 | I-1 | (C-3) (1.11 g) | A-8 | (16) | 1 | S-1 | a2/b5=75/25 |
| 2 | I-2 | (C-4) (1.48 g) | A-10 | - | 1 | S-1 | a2/c1=95/5 |
| 3 | I-7 | (C-5) (1.11 g) | A-13 | (41) | - | S-1 | a1/b1=65/35 |
| 4 | II-1 | (C-8) (1.48 g) | A-15 | - | 1 | S-1 | a1/b2=80/20 |
| 5 | II-4 | (C-14) (1.11 g) | A-17 | (43) | 1 | S-1 | a1/c1=95/5 |
| 6 | III-1 | (C-21)' (1.48 g) | A-18 | - | - | S-1 | a1/c2=90/10 |
| 7 | III-2 | (C-27) (1.11 g) | A-21 | (41) | 1 | S-1 | a2/b4=85/15 |
| 8 | I-1 | PHS-1 (1.11 g) | A-22 | (43-2) | 1 | S-1 | a1/b4=80/20 |
| 9 | I-9 | PHS-2 (1.11 g) | A-23 | (44) | 1 | S-1 | a1/b5=70/30 |
| 10 | II-1 | PHS-1 (1.11 g) | A-27 | (43-2) | 1 | S-1 | a1/b4/c1=75/20/5 |
| 11 | II-4 | (C-28)' (1.48 g) | spirooctane | - | - | S-1 | a1/b4/c2=80/15/5 |
| 12 | III-1 | (C-30) (1.11 g) | *Epicote 825 | (16) | 1 | S-1 | a1/b4/c3=72/20/8 |
| 13 | III-4 | (C-31) (1.48 g) | ε-caprolactone | - | 1 | S-1 | a1/b1/c1=70/25/5 |
| 14 | I-1 | (C-32) (1.11 g) | terephthal-aldehyde | (41) | 1 | S-1 | a2/b4/c1=65/30/5 |
| 15 | I-2 | PHS/St (1.48 g) | A-23 | - | 1 | S-1 | a1/b1/c3=72/20/8 |
| 16 | I-1 | P-2 (1.48 g) | A-15 | (41) | 1 | S-1 | a2/b5=75/25 |
| 17 | III-1 | P-1 (1.48 g) | A-22 | (43-2) | 1 | S-1 | a1/b4=80/20 |
| 18 | II-1 | P-4 (1.48 g) | A-13 | (16) | 1 | S-1 | a1/b1=65/35 |
| Comparative Example 1 | PAG-1 | PHS-1 (1.11 g) | - | (16) | - | S-1 | a1 |
| 2 | II-3 | (C-5) (1.48 g) | - | - | - | S-1 | a1 |
| 3 | I-1 | (C-28)' (1.11 g) | - | (43) | - | S-1 | a1 |

*Epicote 825: produced by Yuka Shell Epoxy K.K.

Acid generator PAG-1 is shown below.

PAG-1

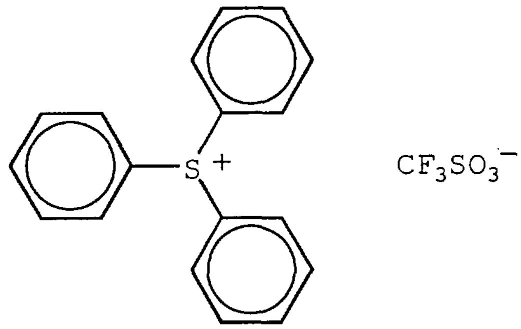

The binder resins used each has the following composition and physical properties.

(c-3) : p-hydroxystyrene/p-tert-butoxycarboxystyrene copolymer (molar ratio: 80/20), weight average molecular weight (Mw): 13,000, molecular weight distribution (Mw/Mn): 1.4

(c-4) : p-hydroxystyrene/p-(1-ethoxyethoxy)styrene copolymer (molar ratio: 70/30), Mw: 12,000, molecular weight distribution (Mw/Mn): 1.3

(c-4) ' : Mw: 7,000

(c-5) : p-hydroxystyrene/p-(tert-butoxycarbonylmethoxy)-styrene copolymer (molar ratio: 75/25), Mw: 8,000, molecular weight distribution (Mw/Mn): 1.5

(c-8) : m-hydroxystyrene/m-(tert-butoxycarbonylmethoxy)styrene copolymer (molar ratio: 80/20), Mw: 7,000, molecular weight distribution (Mw/Mn): 1.4

(c-14): p-hydroxystyrene/styrene/p-(tert-butoxycarbonylmethoxy)styrene copolymer (molar ratio: 70/10/20), Mw: 16,000, molecular weight distribution (Mw/Mn): 1.7

(c-21): p-hydroxystyrene/tert-butyl methacrylate copolymer (molar ratio: 70/30), Mw: 16,000, molecular weight distribution (Mw/Mn): 2.0

(c-21)': Mw: 9,500

(c-27) : p-hydroxystyrene/p-(tert-butyl)styrene/tert-butyl methacrylate copolymer (molar ratio: 70/5/25), Mw: 15,000, molecular weight distribution (Mw/Mn): 1.9

(c-28): p-hydroxystyrene/p-(1-phenethyloxyethoxy)styrene copolymer (molar ratio: 85/15), Mw: 12,000, molecular weight distribution (Mw/Mn): 1.2

(c-28) ' : Mw: 7,000

(c-30): p-hydroxystyrene/p-(1-cyclohexylethylethoxy)-styrene copolymer (molar ratio: 85/15), Mw: 13,000, molecular weight distribution (Mw/Mn): 1.2

(c-31): p-hydroxystyrene/p-acetoxystyrene/p-(1-phenethyl-ethoxy)styrene copolymer (molar ratio: 70/10/20), Mw: 9,000, molecular weight distribution (Mw/Mn): 1.2

(c-32): p-hydroxystyrene/p-(1-p-cyclohexylphenoxyethoxy-ethoxy)styrene copolymer (molar ratio: 85/15), Mw: 13,000, molecular weight distribution (Mw/Mn): 1.2

(PHS-1) : poly(p-hydroxystyrene) (VP-8000, trade name, produced by Nippon Soda Co., Ltd.)

(PHS-2): poly(p-hydroxystyrene) (VP-5000, trade name, produced by Nippon Soda Co., Ltd.)

(PHS/St: synthesized in Synthesis Example 1): p-hydroxystyrene/styrene (molar ratio: 80/20), Mw: 26,000, molecular weight distribution (Mw/Mn) : 1.9

The organic basic compounds used are as follows:

1: 2,4,5-triphenylimidazole
2: 1,5-diazabicyclo[4.3.0]non-5-ene
3: 4-dimethylaminopyridine
4: 1,8-diazabicyclo[5.4.0]undec-7-ene
5: N-cyclohexyl-N'-morpholinoethylthiourea

The surfactants used are as follows:

S-1: Troysol S-366 (produced by Troy Chemical K.K.)
S-2: Megafac F176 (Dainippon Ink & Chemicals, Inc.)
S-3: Megafac R08 (Dainippon Ink & Chemicals, Inc.)
S-4: Polysiloxane Polymer KP-341 (Shin-Etsu Chemical Co., Ltd.)
S-5: Surflon S-382 (produced by Asahi Glass Co., Ltd.)

The solvents used are as follows:

a1: propylene glycol monomethyl ether acetate
a2: propylene glycol monomethyl ether propionate
b1: ethyl lactate
b2: butyl acetate
b3: 2-heptanone
b4: propylene glycol monomethyl ether
b5: ethyl 3-ethoxypropionate.
c1: γ-butyrolactone
c2: ethylene carbonate
c3: propylene carbonate

In Table 1, the ratio for the solvent mixture is a ratio by weight.
Dissolution-Inhibiting Compound 44 is a compound where all R are $-H_2COOC_4H_9(t)$.

TABLE 2

| | | Sensitivity ($\mu C/cm^2$) | Resolution ($\mu m$) | Profile | Number of Development Defects | Coatability (in-plane uniformity) | Particle Initial Value | Increment in Number of Particles |
|---|---|---|---|---|---|---|---|---|
| Example | 1 | 3.8 | 0.10 | rectangular | 65 | ○ | 4 | 2 |
| | 2 | 3.5 | 0.11 | " | 70 | ○ | 3 | 1 |
| | 3 | 3.1 | 0.10 | " | 60 | ○ | 7 | 3 |
| | 4 | 5.0 | 0.12 | " | 80 | ○ | 5 | 2 |
| | 5 | 3.9 | 0.10 | " | 75 | ○ | 3 | 2 |
| | 6 | 4.4 | 0.11 | " | 70 | ○ | 6 | 0 |
| | 7 | 4.8 | 0.10 | " | 74 | ○ | 5 | 1 |
| | 8 | 3.0 | 0.08 | " | 55 | ○ | 3 | 0 |
| | 9 | 2.5 | 0.08 | " | 60 | ○ | 4 | 3 |
| | 10 | 2.7 | 0.08 | " | 65 | ○ | 3 | 1 |
| | 11 | 5.0 | 0.13 | " | 69 | ○ | 7 | 3 |
| | 12 | 6.0 | 0.12 | " | 81 | ○ | 8 | 4 |
| | 13 | 7.1 | 0.12 | " | 77 | ○ | 9 | 5 |
| | 14 | 6.5 | 0.12 | " | 83 | ○ | 7 | 4 |
| | 15 | 3.5 | 0.11 | " | 67 | ○ | 6 | 1 |
| | 16 | 3.9 | 0.09 | " | 66 | ○ | 7 | 0 |
| | 17 | 3.3 | 0.08 | " | 58 | ○ | 7 | 1 |
| | 18 | 4.7 | 0.10 | " | 70 | ○ | 8 | 2 |
| Comparative Example | 1 | 5.6 | 0.16 | reverse taper | 213 | × | 31 | 29 |
| | 2 | 7.3 | 0.15 | " | 418 | × | 25 | 33 |
| | 3 | 4.7 | 0.15 | " | 356 | × | 45 | 41 |

TABLE 3

| | Sensitivity (μC/$cm^2$) | Resolution (μm) | Profile Profile |
|---|---|---|---|
| Example 1 | 4.1 | 0.10 | rectanqular |
| 2 | 3.9 | 0.12 | " |
| 3 | 3.3 | 0.10 | " |
| 4 | 4.9 | 0.11 | " |
| 5 | 4.3 | 0.10 | " |
| 6 | 4.8 | 0.11 | " |
| 7 | 5.1 | 0.11 | " |
| 8 | 3.2 | 0.08 | " |
| 9 | 2.6 | 0.09 | " |
| 10 | 2.8 | 0.08 | " |
| 11 | 2.7 | 0.13 | " |
| 12 | 5.9 | 0.13 | " |
| 13 | 7.5 | 0.12 | " |
| 14 | 6.3 | 0.13 | " |
| 15 | 3.8 | 0.11 | " |
| 16 | 4.3 | 0.11 | " |
| 17 | 3.7 | 0.09 | " |
| 18 | 5.1 | 0.12 | " |
| Comparative Example 1 | 6.2 | 0.18 | tailing |
| 2 | 7.9 | 0.17 | " |
| 3 | 6.0 | 0.17 | " |

It is seen from the results in Tables 2 and 3 that the positive resist composition of the present invention is excellent in all properties as compared with Comparative Examples.

Experiments were performed in the same manner as in Examples except for changing the organic basic compound from 1 to 2, 3, 4 and 5, respectively, as a result, the same performance was obtained.

Also, experiments were performed in the same manner as in Examples except for changing the surfactant from S-1 to S-2, S-3, S-4 and S-5, respectively, as a result, the same performance was obtained.

Furthermore, PCD and PED were evaluated, as a result, the stability against PCD and PED was excellent as compared with Comparative Examples.

(7) Patterning by a proximity X-ray exposure

Using each resist composition in Example 1 and Comparative Examples 1, 2 and 3, Resist Film A having a thickness of 0.40 μm was obtained in the same manner as in (1) above. Subsequently, the resist performance (namely, sensitivity, resolution and pattern shape) was evaluated in the same manner as in (3) above using the same patterning as (2) except for using a proximity X-ray exposure apparatus (gap value: 20 nm). The evaluation results are shown in Table 4.

TABLE 4

| Resist Composition | Sensitivity (mJ/$cm^2$) | Resolution (μm) | Pattern Shape |
|---|---|---|---|
| Example 1 | 85 | 0.10 | rectanqular |
| Comparative Example 1 | 150 | 0.19 | tapered, layer loss |

TABLE 4 (continued)

| Resist Composition | Sensitivity (mJ/cm$^2$) | Resolution (μm) | Pattern Shape |
|---|---|---|---|
| Comparative Example 2 | 195 | 0.16 | tapered |
| Comparative Example 3 | 160 | 0.18 | tapered |

As apparent from Table 4, the resist composition of the present invention exhibits very excellent performance even in the X-ray exposure.
By the positive resist composition of the present invention, a positive chemical amplification-type resist composition ensuring high sensitivity, high resolution, a pattern file excellent in the rectangularity, high stability against PCD and PED and excellent properties with respect to the development defect, coatability (in-plane uniformity) and solvent solubility, can be provided.
While the invention has been described in detail and with reference to specific embodiments thereof, it will be apparent to one skilled in the art that various changes and modifications can be made therein without departing from the spirit and scope thereof.

## Claims

**1.** A positive resist composition to be irradiated with one of an electron beam and X ray comprising:

(a) a compound capable of generating an acid upon irradiation with a radiation;
(b) a compound having a cationically polymerizable function; and
(d) one of solvent mixtures (DI) and (DII):

(DI) a solvent mixture containing at least one solvent selected from Group (A) below and at least one solvent selected from Group (B) below; and
(DII) a solvent mixture containing at least one solvent selected from Group (A) below and at least one solvent selected from Group (C) below:

Group A: a propylene glycol monoalkyl ether carboxylate;
Group B: a propylene glycol monoalkyl ether, an alkyl lactate, an acetic ester, a chain ketone and an alkyl alkoxypropionate;
Group C: a γ-butyrolactone, an ethylene carbonate and a propylene carbonate.

**2.** A positive resist composition to be irradiated with one of an electron beam and X ray comprising:

(a) a compound capable of generating an acid upon irradiation with a radiation;
(b) a compound having a cationically polymerizable function; and
(c) a solvent mixture containing: at least one solvent selected from Group (A) below; at least one solvent selected from Group (B) below; and at least one solvent selected from Group (C) below:

Group A: a propylene glycol monoalkyl ether carboxylate;
Group B: a propylene glycol monoalkyl ether, an alkyl lactate, an acetic ester, a chain ketone and an alkyl alkoxypropionate;
Group C: a γ-butyrolactone, an ethylene carbonate and a propylene carbonate.

**3.** The positive resist composition as claimed in claim 1, which further comprises (d) an organic basic compound.

**4.** The positive resist composition as claimed in claim 1, which further comprises (e) a surfactant containing at least one of a fluorine atom and a silicon atom.

**5.** The positive resist composition as claimed in claim 1, wherein the compound (b) is at least one compound selected from the group consisting of vinyl compounds, cycloalkane compounds, cyclic ether compounds, lactone compounds and aldehyde compounds.

**6.** The positive resist composition as claimed in claim 1, wherein the compound (b) is a compound represented by

formula (A):

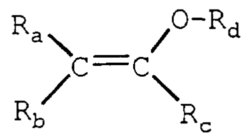

(A)

wherein $R_a$, $R_b$ and $R_c$, which are the same or different, each represents a hydrogen atom, an alkyl or aryl group which may have a substituent, two of $R_a$, $R_b$ and $R_c$ may combine to form a saturated or olefinic unsaturated ring, and $R_d$ represents an alkyl group or a substituted alkyl group.

**7.** The positive resist composition as claimed in claim 1, wherein the compound (a) contains at least one selected from the compounds represented by formulae (I) to (III):

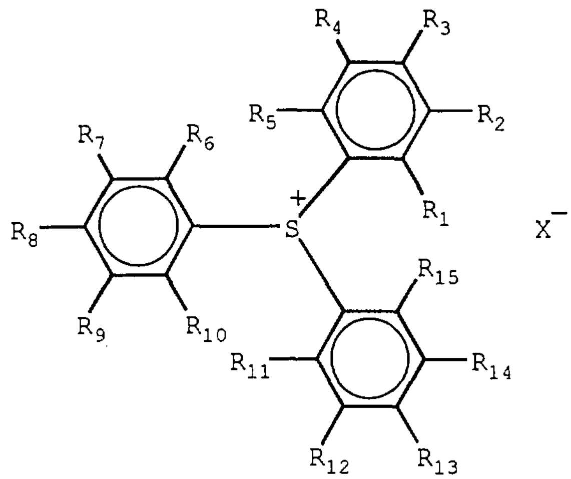

(I)

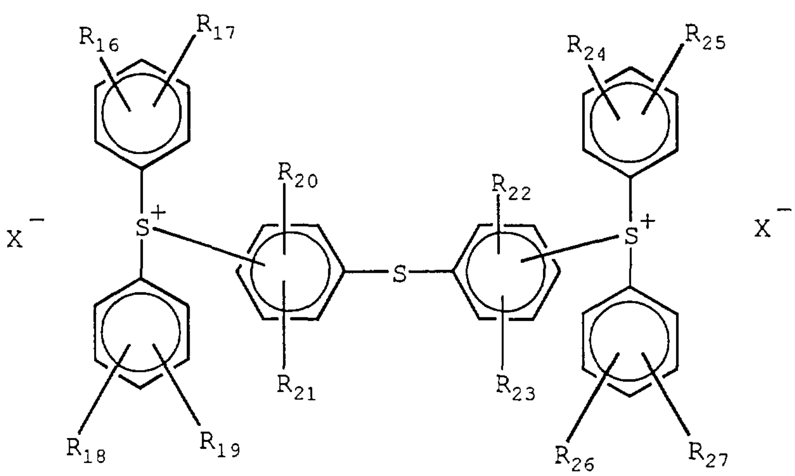

(II)

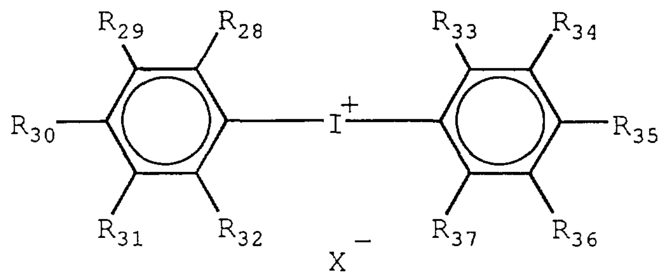

(III)

wherein $R_1$ to $R_{37}$, which are the same or different, each represents a hydrogen atom, a linear, branched or cyclic alkyl group, a linear, branched or cyclic alkoxy group, a hydroxyl group, a halogen atom or an $-S-R_{38}$ group; $R_{38}$ represents a linear, branched or cyclic alkyl or aryl group; two or more of respective groups $R_1$ to $R_{15}$, $R_{16}$ to $R_{27}$ and $R_{28}$ to $R_{37}$ may combine to form a ring containing one or more member selected from the group consisting of a single bond, a carbon, oxygen, sulfur and nitrogen atom; and

$X^-$ represents an anion of a benzenesulfonic acid, a naphthalenesulfonic acid or anthracenesulfonic acid that contains at least one member selected from the group consisting of:
at least one fluorine atom;
a linear, branched or cyclic alkyl group substituted by at least one fluorine atom;
a linear, branched or cyclic alkoxy group substituted by at least one fluorine atom;
an acyl group substituted by at least one fluorine atom;
an acyloxy group substituted by at least one fluorine atom;
a sulfonyl group substituted by at least one fluorine atom;
a sulfonyloxy group substituted by at least one fluorine atom;
a sulfonylamino group substituted by at least one fluorine atom;
an aryl group substituted by at least one fluorine atom;
an aralkyl group substituted by at least one fluorine atom; and
an alkoxycarbonyl group substituted by at least one fluorine atom.

**8.** The positive resist composition as claimed in claim 1, which comprises at least one of:

(f) a resin having a group capable of decomposing by an acid, which increases in the solubility in an alkali developer under the action of an acid; and
(g) a low molecular dissolution-inhibiting compound having a molecular weight of 3,000 or less, which has a group capable of decomposing by an acid and increases in the solubility in an alkali developer under the action of an acid.

**9.** The positive resist composition as claimed in claim 2, which further comprises (d) an organic basic compound.

**10.** The positive resist composition as claimed in claim 2, which further comprises (e) a surfactant containing at least one of a fluorine atom and a silicon atom.

**11.** The positive resist composition as claimed in claim 2, wherein the compound (b) is at least one compound selected from the group consisting of vinyl compounds, cycloalkane compounds, cyclic ether compounds, lactone compounds and aldehyde compounds.

**12.** The positive resist composition as claimed in claim 2, wherein the compound (b) is a compound represented by formula (A):

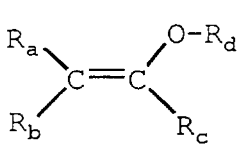

(A)

wherein $R_a$, $R_b$ and $R_c$, which are the same or different, each represents a hydrogen atom, an alkyl or aryl group

which may have a substituent, two of $R_a$, $R_b$ and $R_c$ may combine to form a saturated or olefinic unsaturated ring, and $R_d$ represents an alkyl group or a substituted alkyl group.

**13.** The positive resist composition as claimed in claim 2, wherein the compound (a) contains at least one selected from the compounds represented by formulae (I) to (III) :

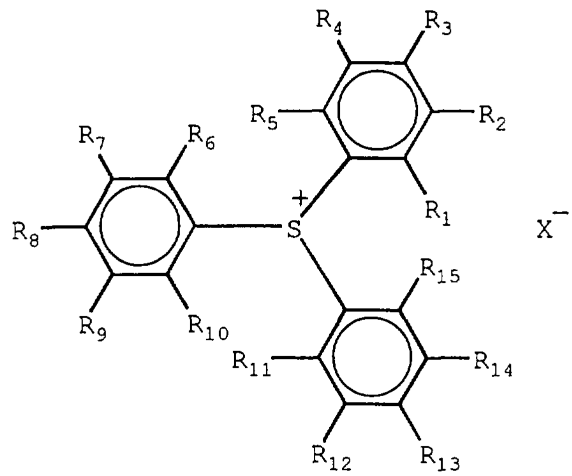

(I)

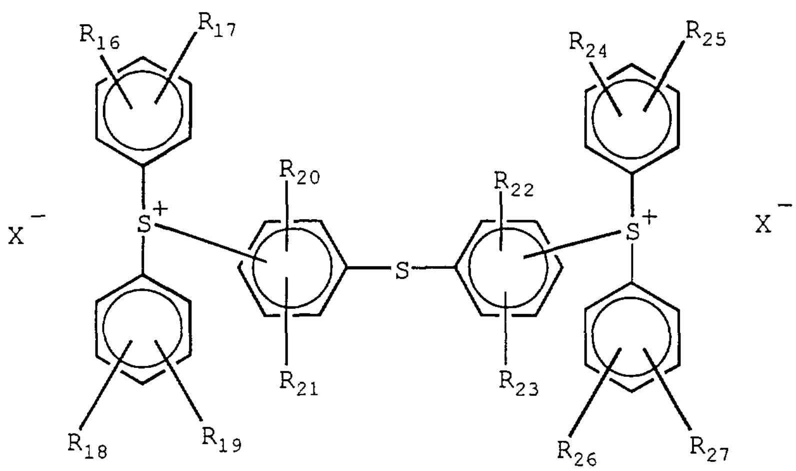

(II)

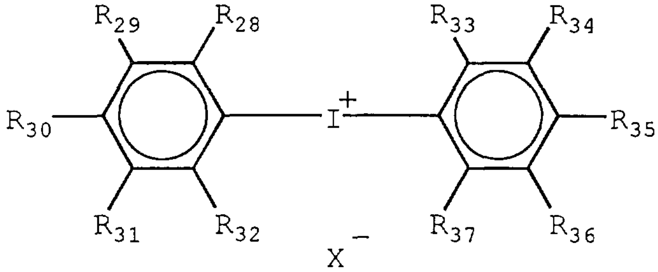

(III)

wherein $R_1$ to $R_{37}$, which are the same or different, each represents a hydrogen atom, a linear, branched or cyclic alkyl group, a linear, branched or cyclic alkoxy group, a hydroxyl group, a halogen atom or an -S-$R_{38}$ group; $R_{38}$ represents a linear, branched or cyclic alkyl or aryl group; two or more of respective groups $R_1$ to $R_{15}$, $R_{16}$ to $R_{27}$ and $R_{28}$ to $R_{37}$ may combine to form a ring containing one or more member selected from the group consisting of a single bond, a carbon, oxygen, sulfur and nitrogen atom; and

$X^-$ represents an anion of a benzenesulfonic acid, a naphthalenesulfonic acid or anthracenesulfonic acid that

contains at least one member selected from the group consisting of:
at least one fluorine atom;
a linear, branched or cyclic alkyl group substituted by at least one fluorine atom;
a linear, branched or cyclic alkoxy group substituted by at least one fluorine atom;
an acyl group substituted by at least one fluorine atom;
an acyloxy group substituted by at least one fluorine atom;
a sulfonyl group substituted by at least one fluorine atom;
a sulfonyloxy group substituted by at least one fluorine atom;
a sulfonylamino group substituted by at least one fluorine atom;
an aryl group substituted by at least one fluorine atom;
an aralkyl group substituted by at least one fluorine atom; and
an alkoxycarbonyl group substituted by at least one fluorine atom.

**14.** The positive resist composition as claimed in claim 2, which comprises at least one of:

(f) a resin having a group capable of decomposing by an acid, which increases in the solubility in an alkali developer under the action of an acid; and
(g) a low molecular dissolution-inhibiting compound having a molecular weight of 3,000 or less, which has a group capable of decomposing by an acid and increases in the solubility in an alkali developer under the action of an acid.

**15.** A method for forming a pattern comprises: applying the positive resist composition according to claim 1 on a substrate to form a resist film; irradiating the resist film with one of an electron beam and X ray; and developing the resist film.

**16.** A method for forming a pattern comprises: applying the positive resist composition according to claim 2 on a substrate to form a resist film; irradiating the resist film with one of an electron beam and X ray; and developing the resist film.

European Patent Office

# EUROPEAN SEARCH REPORT

Application Number
EP 01 12 0747

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
| --- | --- | --- | --- |
| Y | US 6 114 462 A (S. WATANABE ET AL.) 5 September 2000 (2000-09-05)<br>* column 101 - column 102; examples 23-27; table 3 * | 1-5, 7-11, 13-16 | G03F7/004<br>G03F7/039 |
| Y | DATABASE WPI<br>Section Ch, Week 200001<br>Derwent Publications Ltd., London, GB;<br>Class A21, AN 2000-007027<br>XP002187137<br>& JP 11 286535 A (TAIYO INK SEIZO KK), 19 October 1999 (1999-10-19)<br>* abstract * | 1-5, 7-11, 13-16 | |
| A | EP 0 634 696 A (JAPAN SYNTHETIC RUBBER CO.,LTD.) 18 January 1995 (1995-01-18)<br>* page 15; example 6; tables 1-1 * | 1-16 | |
| A | EP 0 869 393 A (FUJI PHOTO FILM CO., LTD.) 7 October 1998 (1998-10-07)<br>* page 77, line 54 * | 1-16 | TECHNICAL FIELDS SEARCHED (Int.Cl.7)<br>G03F |

The present search report has been drawn up for all claims

| Place of search | Date of completion of the search | Examiner |
| --- | --- | --- |
| THE HAGUE | 11 January 2002 | Dupart, J.-M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 01 12 0747

This annex lists the patent family membersrelating to the patent documents cited in the above-mentioned European search report.
The members are as contained in the European Patent Office EDP file on
The European Patent Office is in no way liable for these particulars which are merely given for the purpose of information.

11-01-2002

| Patent document cited in search report | Publication date | Patent family member(s) | Publication date |
|---|---|---|---|
| US 6114462 A | 05-09-2000 | JP 10207066 A | 07-08-1998 |
| | | JP 10204125 A | 04-08-1998 |
| | | US 6312869 B1 | 06-11-2001 |
| | | KR 228468 B1 | 01-11-1999 |
| | | KR 227986 B1 | 01-11-1999 |
| | | TW 385315 B | 21-03-2000 |
| | | US 5942367 A | 24-08-1999 |
| JP 11286535 A | 19-10-1999 | NONE | |
| EP 0634696 A | 18-01-1995 | JP 7036189 A | 07-02-1995 |
| | | JP 7084359 A | 31-03-1995 |
| | | JP 7084361 A | 31-03-1995 |
| | | DE 69407882 D1 | 19-02-1998 |
| | | DE 69407882 T2 | 16-07-1998 |
| | | EP 0634696 A1 | 18-01-1995 |
| | | US 6114086 A | 05-09-2000 |
| | | US 5629135 A | 13-05-1997 |
| | | US 5916729 A | 29-06-1999 |
| EP 0869393 A | 07-10-1998 | JP 10274844 A | 13-10-1998 |
| | | JP 10274845 A | 13-10-1998 |
| | | DE 69800164 D1 | 06-07-2000 |
| | | DE 69800164 T2 | 05-10-2000 |
| | | EP 0869393 A1 | 07-10-1998 |
| | | US 6037098 A | 14-03-2000 |

EPO FORM P0459

For more details about this annex : see Official Journal of the European Patent Office, No. 12/82